# EUROPEAN PATENT APPLICATION

(11) **EP 1 813 990 A1**
(43) Date of publication of application: **01.08.2007**
(21) Application number: 05806132.6
(22) Date of filing: 08.11.2005
(51) Int. Cl.: G03F 7/26, G03F 7/038, G03F 7/039, H01L 21/027

(54) **METHOD FOR FORMING RESIST PATTERN**

(30) Priority: 15.11.2004 JP 2004331136; 13.12.2004 JP 2004360297
(71) Applicant: TOKYO OHKA KOGYO CO., LTD., Kawasaki-shi, Kanagawa 211-0012 (JP)
(72) Inventor: IWAI, Takeshi, c/o TOKYO OHKA KOGYO CO., LTD.,, Kawasaki-shi, Kanagawa 2110012 (JP); IWASHITA, Jun, c/o TOKYO OHKA KOGYO CO., LTD.,, Kawasaki-shi, Kanagawa 2110012 (JP)
(74) Representative: Portal, Gérard
(86) International application number: PCT/JP2005/020420
(87) International publication number: WO 2006/051769

(57) **Abstract**

A method for forming a resist pattern that includes the following steps (i) and (ii): (i) a step of forming a first resist layer on a substrate using a positive resist composition, and then conducting selective exposure, thereby forming a latent image of a dense pattern on the first resist layer, and (ii) a step of forming a second resist layer on top of the first resist layer using a negative resist composition, conducting selective exposure, and then developing the first resist layer and the second resist layer simultaneously, thereby exposing a portion of the latent image of the dense pattern, wherein as the negative resist composition, a negative resist composition dissolved in an organic solvent that does not dissolve the first resist layer is used.

## Description

### TECHNICAL FIELD

The present invention relates to a method for forming a resist pattern.
Priority is claimed on Japanese Patent Application No. 2004-331136, filed November 15, 2004, and Japanese Patent Application No. 2004-360297, filed December 13, 2004 ,the contents of which are incorporated herein by reference.

### BACKGROUND ART

In recent years, in the production of semiconductor elements and liquid crystal display elements, advances in lithography techniques have lead to rapid progress in the field of pattern miniaturization. Typically, these miniaturization techniques involve shortening the wavelength of the exposure light source. Conventionally, ultraviolet radiation typified by g-line and i-line radiation has been used, but nowadays, mass production of semiconductor elements using KrF excimer lasers and ArF excimer lasers has commenced. Furthermore, investigations are also being conducted into the use of radiation with even shorter wavelengths than these excimer lasers, including F₂ excimer lasers, electron beams, extreme ultraviolet radiation, and X-rays.
One example of a known resist material that satisfies the high resolution properties necessary for reproducing patterns of minute dimensions is a resist composition, which includes a base resin that exhibits changed alkali solubility under the action of acid, and an acid generator that generates acid on exposure. These chemically amplified resist compositions include negative compositions that contain an alkali-soluble resin, an acid generator and a cross-linking agent, and positive compositions that contain a resin that exhibits increased alkali solubility under the action of acid, and an acid generator.

For example, resins (acrylic resins) containing structural units derived from (meth)acrylic acid are widely used as the base resin for resists used within ArF excimer laser lithography as they offer excellent transparency in the vicinity of 193 nm (see patent reference 1, etc.).

During formation of a resist pattern using this type of chemically amplified resist composition, steps are conducted for forming a resist layer on a substrate using the resist composition, selectively exposing the resist layer, conducting post exposure baking (PEB), and developing the resist layer to form the resist pattern.
Furthermore, in the formation of a resist pattern, when patterns such as line patterns and hole patterns are formed on a single substrate, both dense patterns in which the spacing between adjacent patterns is narrow, isolated patterns in which the spacing between adjacent patterns is large may be formed on the same substrate.

In recent years, as devices have become more complex and higher densities have increased, the ability to precisely form different patterns on a single substrate in this manner has become highly desirable.
However, a problem arises in that in conventional resist pattern formation, the depth of focus (DOF) during formation of an isolated pattern tends to be narrower than the DOF during formation of a dense pattern.

Accordingly, patent reference 2 discloses a technique in which, for example, a second resist layer (an upper layer) is laminated on top of a first resist layer (a lower layer) in which a dense pattern has been formed, thereby filling in the dense pattern, subsequently forming a different pattern from the dense pattern within the upper layer, thereby exposing a portion of the dense pattern of the lower layer while leaving the remainder of the dense pattern buried. In other words, the pattern of the upper layer is formed so that a portion of the pattern formed in the lower layer remains filled in.
For example, the pattern of the upper layer may be formed with a larger size than the pattern formed in the lower layer. For example, in those cases where a hole pattern is formed in both the upper and lower layers, a pattern may be formed in the upper layer in which the hole diameter is larger than the hole diameter of a dense pattern formed in the lower layer, with the hole patterns of the upper and lower layers formed so as to interconnect. By employing such a configuration, the dense pattern of the lower layer can be exposed within those areas in which the hole pattern of the upper layer is formed. Moreover, in those areas where the upper layer is not removed, the dense pattern of the lower layer remains in a buried state.
As a result, in one portion on the substrate, an isolated pattern is formed from the pattern formed in the lower layer, and the pattern formed in the upper layer that interconnects with this lower layer pattern. In other words, in this pattern, because the dense pattern formed in the lower layer is used, the pattern of the lower layer that contacts the substrate can be formed at a desired size, and an isolated pattern that satisfies the required DOF characteristics can be obtained.
In this manner, a resist pattern that contains a mixture of dense patterns and isolated patterns can be formed on a single substrate.
As a result, the problems caused by variation in the DOF characteristics between dense patterns and isolated patterns can be suppressed.
[Patent Reference 1]
Japanese Unexamined Patent Application, First Publication No. 2003-167347
[Patent Reference 2]
U.S. Patent Application, No. 2003-0104319A1

### DISCLOSURE OF INVENTION

### PROBLEMS TO BE SOLVED BY THE INVENTION

However, in the above method for forming a resist pattern, in which a dense pattern is formed in the lower layer, and a pattern that is different from the lower layer is formed in the upper layer, a problem arises in that mixing occurs at the interface between the upper and lower layers. Mixing refers to a phenomenon in which the two resist layers dissolve within each other.

The present invention takes the above circumstances into consideration, with an object of providing a method for forming a resist pattern in which a dense pattern is formed in a lower layer, and a pattern that is different from the lower layer is formed in an upper layer, wherein mixing can be suppressed.

### MEANS FOR SOLVING THE PROBLEMS

In order to achieve the above object, the present invention adopts the aspects described below.
A first aspect is a method for forming a resist pattern that includes the following steps (i) and (ii):
(i) a step of forming a first resist layer on a substrate using a positive resist composition, and then conducting selective exposure, thereby forming a latent image of a dense pattern on the first resist layer, and
(ii) a step of forming a second resist layer on top of the first resist layer using a negative resist composition, conducting selective exposure, and then developing the first resist layer and the second resist layer simultaneously, thereby exposing a portion of the latent image of the dense pattern, wherein
   as the negative resist composition, a negative resist composition dissolved in an organic solvent that does not dissolve the first resist layer is used.
A second aspect is a method for forming a resist pattern that includes the following steps (i') and (ii'):
(i') a step of forming a first resist layer on a substrate using a positive resist composition, conducting selective exposure, and then performing developing to form a dense pattern in the first resist layer, and
(ii') a step of forming a second resist layer on top of the dense pattern of the first resist layer using a negative resist composition, conducting selective exposure, and then performing developing, thereby filling in a portion of the dense pattern, wherein
   as the negative resist composition, a negative resist composition dissolved in an organic solvent that does not dissolve the first resist layer is used.

The term "exposure" is not limited to irradiation with light, but describes a general concept that includes irradiation with any form of radiation, such as an electron beam or the like.
A third aspect is a method for forming a resist pattern that includes the following steps (xi) and (xii):
(xi) a step of forming a first resist layer on a substrate using a first positive resist composition, and then conducting selective exposure, thereby forming a latent image of a dense pattern on the first resist layer, and
(xii) a step of forming a second resist layer on top of the first resist layer using a second positive resist composition, conducting selective exposure, and then developing the first resist layer and the second resist layer simultaneously, thereby exposing a portion of the latent image of the dense pattern, wherein
   as the second positive resist composition, a positive resist composition dissolved in an organic solvent that does not dissolve the first resist layer is used.
A fourth aspect is a method for forming a resist pattern that includes the following steps (xi') and (xii'):
(xi') a step of forming a first resist layer on a substrate using a first positive resist composition, conducting selective exposure, and then performing developing to form a dense pattern in the first resist layer, and
(xii') a step of forming a second resist layer on top of the dense pattern of the first resist layer using a second positive resist composition, conducting selective exposure, and then performing developing, thereby filling in a portion of the dense pattern, wherein
   as the second positive resist composition, a positive resist composition dissolved in an organic solvent that does not dissolve the first resist layer is used.

### EFFECTS OF THE INVENTION

The present invention is able to provide a method for forming a resist pattern in which a dense pattern is formed in a lower layer and a different pattern is formed in an upper layer, wherein the method uses a negative resist composition that is able to suppress mixing.
Furthermore, the present invention is also able to provide a method for forming a resist pattern in which a dense pattern is formed in a lower layer and a different pattern is formed in an upper layer, wherein mixing can be suppressed.

### BRIEF DESCRIPTION OF THE DRAWINGS

FIG. 1A is an explanatory diagram showing the flow of a sample sequence (process 1) according to a first aspect.
FIG. 1B is an explanatory diagram showing the flow of a sample sequence (process 2) according to a second aspect.
FIG. 2A is an explanatory diagram (cross-sectional view) of the process 1.
FIG. 2B is an explanatory diagram (cross-sectional view) of the process 1.
FIG. 2C is an explanatory diagram (cross-sectional view) of the process 1.
FIG. 3A is an explanatory diagram (cross-sectional view) of the process 2.
FIG. 3B is an explanatory diagram (cross-sectional view) of the process 2.
FIG. 3C is an explanatory diagram (cross-sectional view) of the process 2.
FIG. 3D is an explanatory diagram (cross-sectional view) of the process 2.
FIG. 4 is a plan view showing a state following formation of a dense pattern and an isolated pattern using the process 1 or process 2.
FIG. 5A is an explanatory diagram showing the flow of a sample sequence (process 1) according to a third aspect.
FIG. 5B is an explanatory diagram showing the flow of a sample sequence (process 102) according to a fourth aspect.
FIG. 6A is an explanatory diagram (cross-sectional view) of the process 1A.
FIG. 6B is an explanatory diagram (cross-sectional view) of the process 1A.
FIG. 6C is an explanatory diagram (cross-sectional view) of the process 1A.
FIG. 7A is an explanatory diagram (cross-sectional view) of the process 2A.
FIG. 7B is an explanatory diagram (cross-sectional view) of the process 2A.
FIG. 7C is an explanatory diagram (cross-sectional view) of the process 2A.
FIG. 7D is an explanatory diagram (cross-sectional view) of the process 2A.
FIG. 8 is a plan view showing a state following formation of a dense pattern and an isolated pattern using the process 1A or process 2A.

### DESCRIPTION OF THE REFERENCE SYMBOLS

- 1: Substrate
- 2: First resist layer (lower layer)
- 2a: Hole
- 2a': Latent image
- 12: Second resist layer (upper layer)
- 12a: Hole
- 12a': Latent image
- 3, 13: Mask
- 101: Substrate
- 102: First resist layer (lower layer)
- 102a: Hole
- 102a': Latent image (exposed portion)
- 112: Second resist layer (upper layer)
- 112a: Hole
- 112a': Latent image (exposed portion)
- 103, 113: Mask

### BEST MODE FOR CARRYING OUT THE INVENTION

### [First Aspect]

A first aspect is a method for forming a resist pattern that includes the following steps (i) and (ii): (i) a step of forming a first resist layer on a substrate using a positive resist composition, and then conducting selective exposure, thereby forming a latent image of a dense pattern on the first resist layer, and (ii) a step of forming a second resist layer (an upper layer) on top of the first resist layer (the lower layer) using a negative resist composition, conducting selective exposure, and then developing the first resist layer and the second resist layer simultaneously, thereby exposing a portion of the latent image of the dense pattern, wherein
as the negative resist composition, a negative resist composition dissolved in an organic solvent that does not dissolve the first resist layer is used.

Here, a dense pattern refers to a pattern in which the spacing between adjacent patterns is narrow when a line pattern or hole pattern is formed. Specifically, in a cross-section of the pattern, the ratio of the spacing between adjacent patterns relative to the pattern width is preferably no higher than 1, even more preferably no higher than 0.9, and is most preferably 0.8 or less. For practical reasons, the lower limit for this ratio is typically 0.5 or greater. In a hole pattern, the pattern width refers to the width of the removed portions of the resist layer, for example, the hole diameter of a hole pattern. The pattern width in a line pattern refers to the line width.
An isolated pattern describes a pattern in which the spacing between adjacent patterns is greater than that within a dense pattern. Specifically, in a cross-section of the pattern, the ratio of the spacing between adjacent patterns relative to the pattern width is preferably 2 or greater, even more preferably 3 or greater, and is most preferably 5 or greater. For practical reasons, the upper limit for this ratio is typically no greater than 10.
The pattern width and spacing values refer to values near the interface between the substrate and the resist layer.

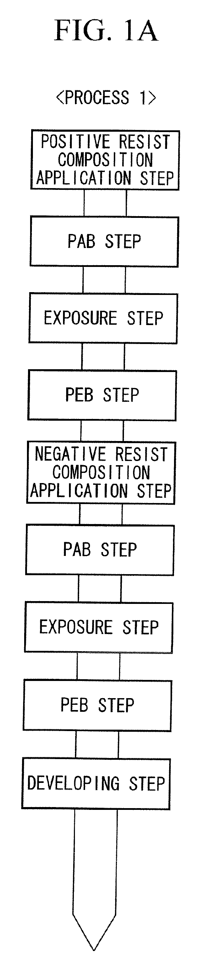

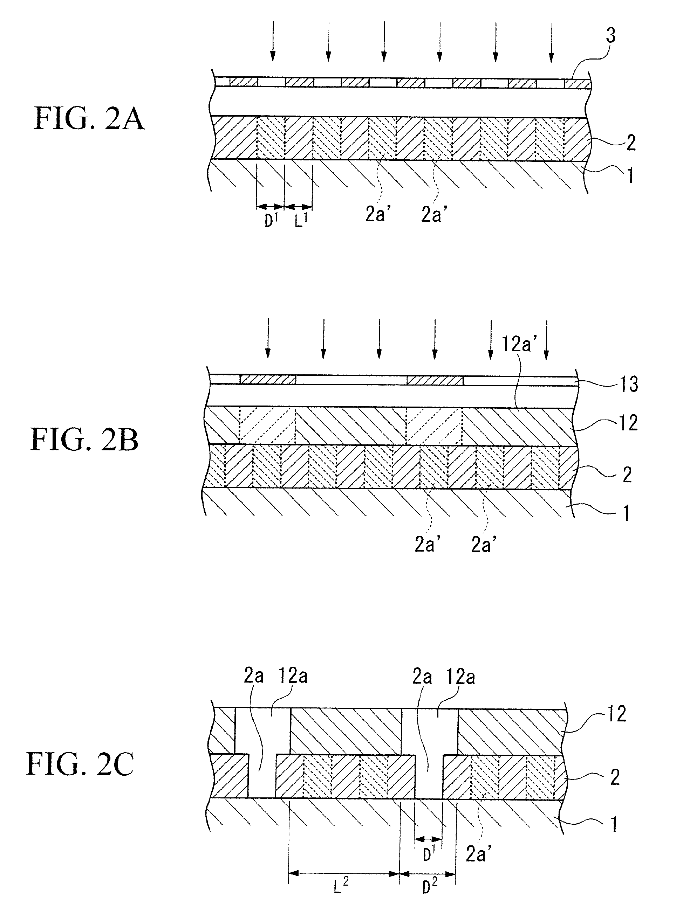

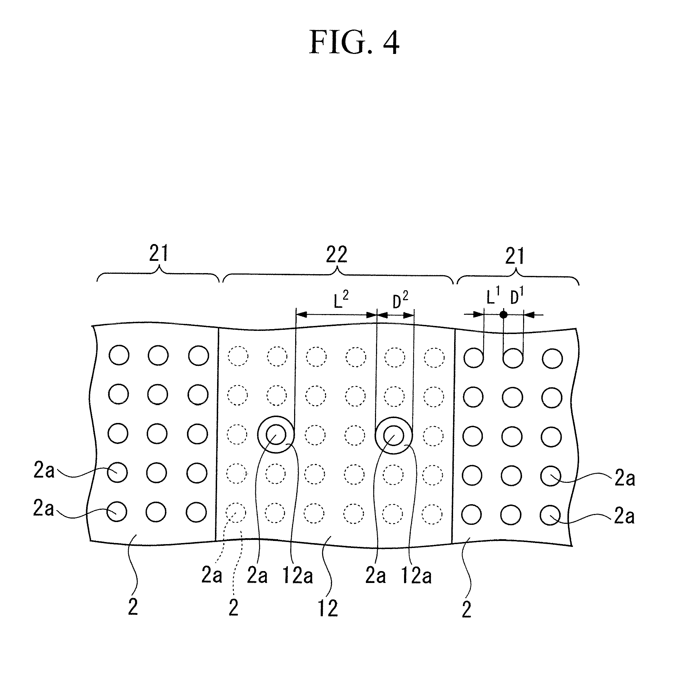

FIG. 1A is a diagram showing the flow of a sample sequence (hereafter referred to as the process 1) according to the first aspect. FIG. 2A through FIG. 2C are explanatory diagrams (cross-sectional views) of the process 1. FIG. 4 is a plan view showing a state following formation of a dense pattern and an isolated pattern using the process.

In the process 1, the following steps are conducted in sequence.

### (i-1) Positive Resist Composition Application Step

Using a coating apparatus, a chemically amplified positive resist composition containing an acid generator component (hereafter also referred to as an acid generator) that generates acid on exposure is applied to the surface of a substrate 1 (see FIG. 2A).

### (i-2) PAB (Prebake) Step

The applied resist film is heat treated, thereby forming a first resist layer 2 (see FIG. 2A).
The heating conditions typically involve heating at 80 to 150°C for a period of approximately 40 to 120 seconds (and preferably for 60 to 90 seconds).
The thickness of the first resist layer 2 is typically within a range from approximately 0.05 to 1.0 µm, and is preferably from 0.1 to 0.5 µm.

### (i-3) Exposure Step

By selectively exposing the first resist layer 2, a latent image 2a' of a dense pattern is formed on the first resist layer (see FIG. 2A). The term "latent image" refers to the region subjected to exposure. In those cases where a positive resist composition is used, this latent image refers to the exposed portions.
In other words, the first resist layer 2 is selectively exposed using a dense pattern mask (reticle) 3.
FIG. 2A represents an example in which exposure is conducted to form a dense hole pattern in which the pattern width D¹ and the spacing L¹ are formed in an approximately 1:1 size relationship.
In other words, as shown in FIG. 4, selective exposure is conducted so as to form a dense pattern in the first resist layer 2 in which a plurality of holes 2a of pattern width D¹ are arranged in a dense pattern with a spacing of L¹.
There are no particular restrictions on the wavelength used for the exposure, and an ArF excimer laser, KrF excimer laser, F₂ excimer laser, or other radiation such as EUV (extreme ultraviolet), VUV (vacuum ultraviolet), EB (electron beam), X-ray or soft X-ray radiation can be used, although an ArF excimer laser is particularly ideal (this also applies in the exposure steps described below).

### (i-4) PEB (Post Exposure Baking) Step

The selectively exposed first resist layer 2 is subjected to a heat treatment, thereby suitably dispersing the acid component generated from the acid generator within the first resist layer 2, and causing dissociation of the acid-dissociable, dissolution-inhibiting groups contained within the base component of the positive resist composition. Depending on the nature of the acid-dissociable, dissolution-inhibiting groups, dissociation of these acid-dissociable, dissolution-inhibiting groups may occur solely by exposure. Accordingly, the PEB step is not necessarily required.
The heating conditions typically involve heating at 80 to 150°C for a period of 40 to 120 seconds (and preferably 60 to 90 seconds).

### (ii-1) Negative Resist Composition Application Step

Using a coating apparatus, a chemically amplified negative resist composition containing an acid generator is applied to the surface of the first resist layer 2 (see FIG. 2B).

### (ii-2) PAB (Prebake) Step

The applied resist film is heat treated, thereby forming a second resist layer 12 (see FIG. 2B).
The heating conditions typically involve heating at 80 to 150°C for a period of approximately 40 to 120 seconds (and preferably for 60 to 90 seconds).
The thickness of the second resist layer 12 is typically within a range from approximately 0.05 to 1.0 µm, and is preferably from 0.1 to 0.5 µm.

### (ii-3) Exposure Step

The second resist layer 12 is then exposed.
In other words, the second resist layer 12 is selectively exposed using a desired mask (reticle) 13, thereby forming a latent image 12a' (see FIG. 2B).
FIG. 2B represents an example in which exposure is conducted to form an isolated hole pattern in which the pattern width D² and the spacing L² are formed in an approximately 1:2 size relationship.
In other words, as shown in FIG. 4, the regions 21 positioned at the left and right edges of the diagram are not exposed, whereas in the region 22 sandwiched between the regions 21, selective exposure is conducted using the mask 13 so as to form a pattern in the second resist layer 12 in which holes 12a of pattern width D² are arranged with a spacing of L².
As shown in FIG. 2B and FIG. 4, the diameter (pattern width) D² of the holes 12a within the isolated pattern are designed to be larger than the diameter (pattern width) D¹ of the holes 2a (the latent image 2a') formed in the first resist layer 2. Furthermore, the holes 12a are formed over an area that includes a hole 2a (latent image portion 2a') formed directly therebeneath.

### (ii-4) PEB (Post Exposure Baking) Step

The selectively exposed second resist layer 12 is subjected to a heat treatment, thereby suitably dispersing the acid component generated from the acid generator within the second resist layer 12, and effecting the negative conversion (see FIG. 2B).
The heating conditions typically involve heating at 80 to 150°C for a period of 40 to 120 seconds (and preferably 60 to 90 seconds).

### (ii-5) First Resist Layer and Second Resist Layer Developing Step

The laminate of the first resist layer 2 and the second resist layer 12 is subjected to a developing treatment. The developing treatment uses, for example, an aqueous solution of TMAH (an aqueous solution of tetramethylammonium hydroxide) with a concentration of 0.1 to 10% by weight (and preferably 2.38% by weight).
Upon conducting this developing treatment, within the region 22 shown in FIG. 4, the unexposed portions of the second resist layer 12 are first removed, forming the isolated pattern holes 12a, as shown in FIG. 2C. Subsequently, the developing solution that enters these holes 12a contacts the first resist layer 2 that constitutes the bottom surface within the holes 12a, thereby developing and removing the underlying latent image portions 2a' of the first resist layer 2, and exposing the substrate. In other words, the latent image 2a' of the first resist layer 2 undergoes patterning. As a result, holes 2a are formed directly beneath the holes 12a.
Furthermore, in the regions 21, because no light is irradiated onto the region during the selective exposure, the second resist layer 12 is developed and removed by the developing solution, and the underlying latent image 2a' of the dense pattern formed in the first resist layer 2 is developed, thus forming the holes 2a.
Accordingly, an isolated hole pattern is formed in which the holes 2a and the holes 12a are interconnected.
In other words, in the region 22, the holes 2a are formed in a dense pattern that enables broad DOF characteristics to be ensured, meaning the holes can be formed precisely at the desired size. The isolated holes 12a are formed over a portion of the holes 2a of the dense pattern formed in the first resist layer 2.
In other words, in this method, a portion of the dense pattern with a broad DOF formed in the lower first resist layer 2 is exposed and patterned by the developing treatment, and can then be used as an isolated pattern.
If an isolated pattern is formed from the outset in the lower first resist layer 2, then broad DOF characteristics cannot be achieved, but by employing the steps described above, an isolated pattern with broad DOF characteristics can be obtained.
The DOF characteristics of the second resist layer 12 of the upper layer need not be as favorable as those for the pattern formed in the lower layer (the first resist layer 2). This is because within the isolated hole pattern containing the interconnected holes 2a and 12a, the holes 2a within the lower layer 2 represent the more important portions. The reason for this importance is that when etching of the substrate is conducted, it is the pattern within the lower layer 2 that is transferred (namely, the pattern transferred to the substrate is dependent on the pattern of the lower layer 2).

In this manner, a so-called isolated-dense mixed pattern can be obtained, in which a dense pattern region 21 and an isolated pattern region 22 with the same DOF characteristics can be formed on a single substrate.

According to this method of the present invention, a specific negative resist composition is used. The materials for the negative resist composition are the same as those used for the second aspect, and are consequently described following the description of the steps of the second aspect.

### [Second Aspect]

The second aspect is a method for forming a resist pattern that includes the following steps (i') and (ii'): (i') a step of forming a first resist layer on a substrate using a positive resist composition, conducting selective exposure, and then performing developing to form a dense pattern in the first resist layer, and (ii') a step of forming a second resist layer on top of the dense pattern of the first resist layer using a negative resist composition, conducting selective exposure, and then performing developing, thereby filling in a portion of the dense pattern, wherein
as the negative resist composition, a negative resist composition dissolved in an organic solvent that does not dissolve the first resist layer is used.

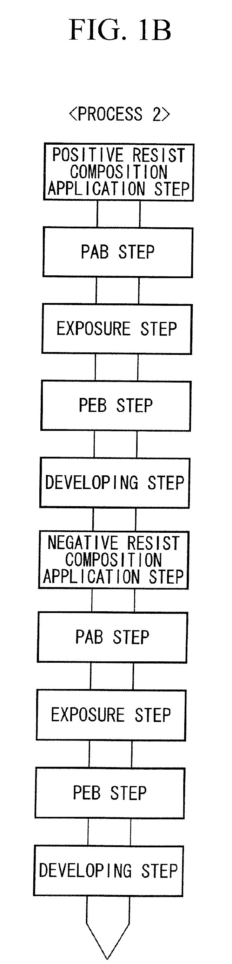

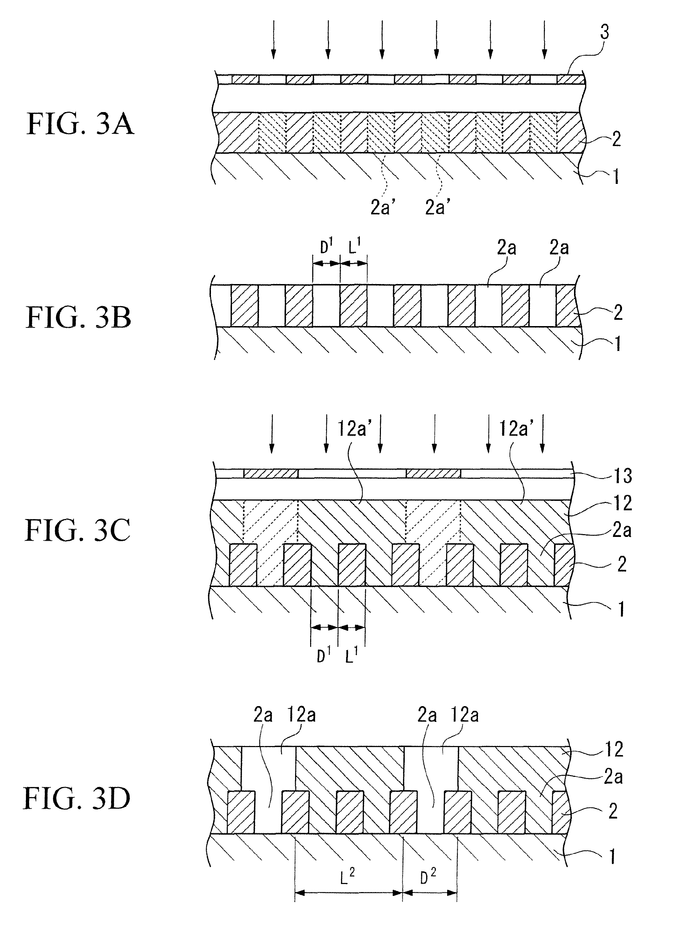

FIG. 1B is a diagram showing the flow of a sample sequence (hereafter referred to as a process 2) according to the second aspect. FIG. 3A through FIG. 3D are explanatory diagrams (cross-sectional views) of the process 2. FIG. 4 is a plan view showing a state following formation of a dense pattern and an isolated pattern using the process.

In the process 2, the following steps are conducted in sequence.

### (i'-1) Positive Resist Composition Application Step

The same as (i-1) of the first aspect (see FIG. 3A).

### (i'-2) PAB (Prebake) Step

The same as (i-2) of the first aspect (see FIG. 3A).

### (i'-3) Exposure Step

The same as (i-3) of the first aspect (see FIG. 3A).

### (i"-4) PEB (Post Exposure Baking) Step

The same as (i-4) of the first aspect (see FIG. 3A).

### (i'-5) First Resist Layer Developing Step

The first resist layer 2 is then subjected to a developing treatment. The developing treatment uses, for example, an aqueous solution of TMAH (an aqueous solution of tetramethylammonium hydroxide) with a concentration of 0.1 to 10% by weight (and preferably 2.38% by weight).
Upon conducting this developing treatment, the exposed portions are removed, as shown in FIG. 3B, and a dense pattern containing a plurality of holes 2a in which the pattern width D¹ and the spacing L¹ are formed in an approximately 1:1 size relationship is obtained in the first resist layer 2.
In other words, as shown in FIG. 4, a dense pattern in which holes 2a with a pattern width D¹ are positioned at a spacing of L¹ is formed across the entire surface of the first resist layer 2.

### (ii'-1) Negative Resist Composition Application Step

Using a coating apparatus, a chemically amplified negative resist composition containing an acid generator is applied to the surface of the first resist layer 2 that has a dense pattern formed therein, as shown in FIG. 3C. As a result, the negative resist composition fills the holes 2a, thereby burying the holes 2a, and a resist film is formed on top, so that the first resist layer 2 is covered with the resist film.

### (ii'-2) PAB (Prebake) Step

The applied resist film is heat treated, thereby forming a second resist layer 12 (see FIG. 3C).
The heating conditions typically involve heating at 80 to 150°C for a period of approximately 40 to 120 seconds (and preferably for 60 to 90 seconds).
The thickness of the second resist layer 12 (the distance from the surface of the first resist layer 2 to the surface of the second resist layer 12) is typically within a range from approximately 0.05 to 1.0 µm, and is preferably from 0.1 to 0.5 µm.

### (ii'-3) Exposure Step

The second resist layer 12 is then exposed.
In other words, the second resist layer 12 is selectively exposed using a desired mask (reticle) 13.
FIG. 3C represents an example in which exposure is conducted to form an isolated hole pattern in which the pattern width D² and the spacing L² are formed in an approximately 1:2 size relationship.
In other words, in this example, the same mask as that used in the first aspect is used to expose the same regions, and as shown in FIG. 4, the regions 21 are not exposed, whereas in the region 22, the second resist layer 12 is selectively exposed so as to form a pattern in which holes 12a of pattern width D² are arranged with a spacing of L², thereby forming a latent image 12a'.
As shown in FIG. 3C and FIG. 4, the diameter (pattern width) D² of the holes 12a within the isolated pattern are designed to be larger than the diameter (pattern width) D¹ of the holes 2a formed in the first resist layer 2. Furthermore, the holes 12a are formed over an area that includes a hole 2a formed directly therebeneath.

### (ii'-4) PEB (Post Exposure Baking) Step

The selectively exposed second resist layer 12 is then subjected to a heat treatment, thereby suitably dispersing the acid component generated from the acid generator within the second resist layer 12, and effecting the negative conversion (see FIG. 3C).
The heating conditions typically involve heating at 80 to 150°C for a period of 40 to 120 seconds (and preferably 60 to 90 seconds).

### (ii'-5) Second Resist Layer Developing Step

Upon conducting developing of the laminate of the first resist layer 2 and the second resist layer 12, within the region 22 shown in FIG. 4, the unexposed portions of the second resist layer 12 are removed, forming the isolated pattern holes 12a, as shown in FIG. 3D.
As a result, within the region 22, an isolated hole pattern is formed in which the holes 12a and the holes 2a directly therebeneath are interconnected. Furthermore, in the regions 21, because no light is irradiated onto the regions during the selective exposure, the second resist layer 12 is developed and removed by the developing solution, and the negative resist composition that had filled the dense pattern of the underlying first resist layer is removed at the same time, thereby forming the holes 2a.
In other words, in this method, a dense pattern with a broad DOF formed in the first resist layer 2 is filled and covered with the second resist layer 12, and the second resist layer is then selectively exposed and developed to remove a portion of the second resist layer 12 and expose a portion of the underlying dense pattern, thereby enabling the dense pattern to be used as an isolated pattern. Within the dense pattern, those portions corresponding with the areas in which the second resist layer 12 is not removed remain buried beneath the second resist layer 12.
If an isolated pattern is formed from the outset in the lower first resist layer 2, then broad DOF characteristics cannot be achieved, but by employing the steps described above, an isolated pattern with a broad DOF can be obtained.
The DOF characteristics of the second resist layer 12 of the upper layer need not be as favorable as those for the pattern formed in the first resist layer (the lower layer) 2. This is because within the isolated hole pattern containing the interconnected holes 2a and 12a, the holes 2a within the lower layer 2 represent the more important portions. The reason for this importance is that when etching of the substrate is conducted, it is the pattern within the lower layer 2 that is transferred (namely, the pattern transferred to the substrate is dependent on the pattern of the lower layer).
In this manner, a so-called isolated-dense mixed pattern can be obtained, in which a dense pattern region 21 and an isolated pattern region 22 can be formed on a single substrate, as shown in FIG. 4.

The process 2 offers the advantage that the occurrence of post-developing scum is less likely.
Furthermore, another advantage is that because the first resist layer is subjected to developing treatment prior to formation of the second resist layer, the second resist layer is unaffected by the acid generator within the first resist layer, enabling a more precise pattern to be formed.

According to this method of the present invention, a specific negative resist composition is used. The materials for the negative resist composition are the same as those used for the first aspect, and are described below.

### [Negative Resist Composition]

The negative resist composition is preferably a chemically amplified composition containing a resin component (A0-0), an acid generator component (B) that generates acid on exposure, and a cross-linking agent component (C).
Furthermore, in a negative resist composition used in the present invention, these components are dissolved within a specific solvent.

### Organic Solvent

In the present invention, an organic solvent that does not dissolve the first resist layer is used. As a result, mixing of the resist layers can be suppressed.
As this type of organic solvent, any solvent that lacks compatibility with the first resist layer can be used.
The expression "does not dissolve the first resist layer" preferably means that at 23°C, when a first resist layer with a film thickness 0.2 µm is formed and this resist layer is then immersed in the organic solvent, no change is observed in the film thickness even after 60 minutes.

Examples of this type of solvent include alcohol-based solvents and fluorine-based solvents. These solvents may be used either alone, or in mixtures of two or more different solvents.
Of these solvents, alcohol-based solvents are preferred in terms of the coating properties obtained, and the dissolution of materials such as the resin component. Accordingly, the organic solvent preferably includes an alcohol-based solvent.
Monohydric alcohols are particularly preferred, and of such alcohols, although dependent on the number of carbon atoms, primary or secondary monohydric alcohols are preferred, and primary monohydric alcohols are the most desirable.
The boiling point is preferably within a range from 80 to 160°C, and even more preferably from 90 to 150°C, and from the viewpoints of the resulting coating properties, the stability of the composition upon storage, and the heating temperature required in the PAB step and/or PEB step, boiling points within a range from 100 to 135°C are the most desirable.
In this description, the term "monohydric alcohol" refers to compounds in which the number of hydroxyl groups incorporated within the alcohol molecule is 1, and does not include dihydric alcohols, trihydric alcohols, or derivatives thereof.

Specific examples of the alcohol-based solvent include n-amyl alcohol (boiling point: 138.0°C), s-amyl alcohol (boiling point: 119.3°C), t-amyl alcohol (boiling point: 101.8°C), isoamyl alcohol (boiling point: 130.8°C), isobutanol (also called isobutyl alcohol or 2-methyl-1-propanol) (boiling point: 107.9°C), isopropyl alcohol (boiling point: 82.3°C), 2-ethylbutanol (boiling point: 147°C), neopentyl alcohol (boiling point: 114°C), n-butanol (boiling point: 117.7°C), s-butanol (boiling point: 99.5°C), t-butanol (boiling point: 82.5°C), 1-propanol (boiling point: 97.2°C), n-hexanol (boiling point: 157.1°C), 2-heptanol (boiling point: 160.4°C), 3-heptanol (boiling point: 156.2°C), 2-methyl-1-butanol (boiling point: 128.0°C), 2-methyl-2-butanol (boiling point: 112.0°C), and 4-methyl-2-pentanol (boiling point: 131.8°C). Of these, isobutanol (2-methyl-1-propanol), 4-methyl-2-pentanol, and n-butanol are preferred. Of these, isobutanol and n-butanol are particularly desirable.

An example of a suitable fluorine-based solvent is perfluoro-2-butyltetrahydrofuran.
These organic solvents may be used either alone, or in mixtures of two or more different solvents.

The organic solvent may also include other organic solvents besides the alcohol-based solvent and/or fluorine-based solvent, provided the solvent does not dissolve the first resist layer, although the alcohol-based solvent and/or fluorine-based solvent preferably accounts for at least 80% by weight, and preferably 100% by weight of the solvent.
Examples of possible other solvents include either one, or two or more solvents selected from known materials used as the solvents for conventional chemically amplified resists.
Suitable examples include lactones such as γ-butyrolactone; ketones such as acetone, methyl ethyl ketone, cyclohexanone, methyl isoamyl ketone and 2-heptanone; polyhydric alcohols and derivatives thereof such as ethylene glycol, ethylene glycol monoacetate, diethylene glycol, diethylene glycol monoacetate, propylene glycol, propylene glycol monoacetate, dipropylene glycol, or the monomethyl ether, monoethyl ether, monopropyl ether, monobutyl ether or monophenyl ether of dipropylene glycol monoacetate; cyclic ethers such as dioxane; and esters such as methyl lactate, ethyl lactate (EL), methyl acetate, ethyl acetate, butyl acetate, methyl pyruvate, ethyl pyruvate, methyl methoxypropionate, and ethyl ethoxypropionate.

There are no particular restrictions on the quantity used of the organic solvent, which is set in accordance with the desired film thickness so as to produce a concentration that enables favorable application to a substrate or the like, and is typically sufficient to produce a solid fraction concentration within the resist composition of 2 to 20% by weight, and preferably from 5 to 15% by weight.

There are no particular restrictions on the resin component (A0-0), the acid generator component (B) that generates acid on exposure, the cross-linking agent component (C), and any other optional components that may be added, and the types of materials proposed for use within conventional negative resist compositions may be used.
Considering the effects relating to the negative resist composition making contact with the first resist layer, the negative resist composition preferably exhibits a high level of sensitivity.
Preferred compositions are described below.

In the following description of the negative resist composition, the meanings of the terms used are as listed below.
A "structural unit" refers to a monomer unit that contributes to the formation of a polymer (resin).
A "structural unit derived from acrylic acid" refers to a structural unit formed by cleavage of the ethylenic double bond of acrylic acid.
A "structural unit derived from an acrylate ester" refers to a structural unit formed by cleavage of the ethylenic double bond of an acrylate ester.
The term "structural unit derived from an acrylate ester" is a general concept that is deemed to also include those units in which the hydrogen atom at the α-position is substituted with another substituent group such as an alkyl group. In a "structural unit derived from acrylic acid" or a "structural unit derived from an acrylate ester", unless stated otherwise, the term "α-position" or "α-position carbon atom" refers to the carbon atom to which the carboxyl group is bonded.
Furthermore, the term "structural unit derived from acrylic acid" is a general concept that is deemed to include structural units in which the hydrogen atom bonded to the α-position carbon atom is substituted with another substituent group such as an alkyl group, as well as structural units derived from an acrylate ester in which a hydrogen atom is bonded to the α-position carbon atom.
Furthermore, unless stated otherwise, an "alkyl group" refers to a straight-chain, cyclic, or branched-chain alkyl group.

### Resin Component (A0-0)

The resin component (A0-0) is preferably a resin component (A0) that contains at least a fluorinated hydroxyalkyl group and an alicyclic group.
Of such components, the resin component (A0) is preferably a resin component (A) containing a structural unit (a1) that includes an alicyclic group having a fluorinated hydroxyalkyl group, and a structural unit (a2), which is a structural unit derived from an acrylate ester and includes a hydroxyl group-containing alicyclic group.

### - Structural Unit (a1) that includes an alicyclic group having a fluorinated hydroxyalkyl group

By including the structural unit (a1), swelling of the negative resist composition, which is a potential problem, can be suppressed.

### -- Alicyclic group having a fluorinated hydroxyalkyl group

In the structural unit (a1), the alicyclic group includes a fluorinated hydroxyalkyl group.
A fluorinated hydroxyalkyl group refers to an alkyl group containing a hydroxyl group in which either a portion of, or all of, the hydrogen atoms of the alkyl group have been substituted with fluorine atoms. In this group, the fluorination increases the ease with which the hydrogen atom of the hydroxyl group is released.
In the fluorinated hydroxyalkyl group, the alkyl group is either a straight-chain or branched-chain group, and although there are no particular restrictions on the number of carbon atoms, a typical number of carbon atoms is from 1 to 20, and preferably from 4 to 16. There are no particular restrictions on the number of hydroxyl groups, although a single hydroxyl group is typical.
Of the various possibilities, groups in which a fluorinated alkyl group and/or a fluorine atom is bonded to the α-position carbon atom to which the hydroxyl group is bonded (which refers to the α-position carbon atom of the hydroxyalkyl group) are preferred. Furthermore, the fluorinated alkyl group bonded to the α-position is preferably a group in which all of the hydrogen atoms of the alkyl group have been substituted with fluorine atoms.

The alicyclic group may be either a monocyclic or polycyclic group, although a polycyclic group is preferred. Furthermore, an alicyclic hydrocarbon group is preferred. Furthermore, the group is preferably saturated. Moreover, the number of carbon atoms within the alicyclic group is preferably within a range from 5 to 15.

Specific examples of the alicyclic group include the groups described below.
Namely, examples of suitable monocyclic groups include groups in which one hydrogen atom has been removed from a cycloalkane. Examples of suitable polycyclic groups include groups in which one or two hydrogen atoms have been removed from a bicycloalkane, tricycloalkane or tetracycloalkane or the like.
Specific examples of monocyclic groups include groups in which one or two hydrogen atoms have been removed from cyclopentane or cyclohexane, and groups in which two hydrogen atoms have been removed from cyclohexane are particularly preferred.
Examples of suitable polycyclic groups include groups in which one or two hydrogen atoms have been removed from a polycycloalkane such as adamantane, norbornane, isobornane, tricyclodecane or tetracyclododecane.
These types of polycyclic groups can be selected appropriately from the multitude of groups proposed for forming acid-dissociable, dissolution-inhibiting groups for use within resins for positive photoresist compositions used within ArF excimer laser processes.
Of the various possibilities, groups in which two hydrogen atoms have been removed from cyclohexane, adamantane, norbornane or tetracyclododecane are readily available industrially, and are consequently preferred.
Of the monocyclic and polycyclic groups exemplified above, groups in which two hydrogen atoms have been removed from norbornane are particularly preferred.

The structural unit (a1) is preferably a structural unit derived from acrylic acid, and structures in which the above alicyclic group is bonded to the ester group [-C(O)O-] of the acrylate ester (namely, structures in which the hydrogen atom of the carboxyl group is substituted with the aforementioned alicyclic group) are preferred.

Specifically, as the structural unit (a1), units represented by a general formula (1) shown below are particularly preferred.

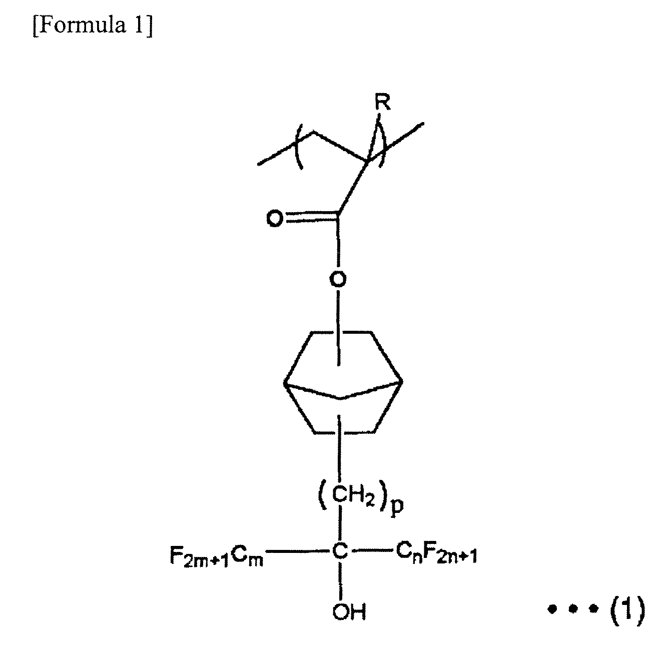

(wherein, R represents a hydrogen atom, an alkyl group, a fluorinated alkyl group, or a fluorine atom, and m, n and p each represent, independently, an integer from 1 to 5)

R represents a hydrogen atom, an alkyl group, a fluorinated alkyl group, or a fluorine atom.
As the alkyl group, lower alkyl groups of no more than 5 carbon atoms are preferred, and specific examples include a methyl group, ethyl group, propyl group, isopropyl group, n-butyl group, isobutyl group, tert-butyl group, pentyl group, isopentyl group, or neopentyl group, although a methyl group is preferred.
The fluorinated alkyl group is preferably a lower alkyl group of no more than 5 carbon atoms in which one or more of the hydrogen atoms have been substituted with fluorine atoms. Specific examples of suitable alkyl groups include the same groups as those listed above.
The hydrogen atoms substituted with fluorine atoms may represent either a portion of, or all of, the hydrogen atoms of the alkyl group.
A hydrogen atom or an alkyl group is preferred as the R group, a hydrogen atom or a methyl group is even more preferred, and a hydrogen atom is the most desirable.
Furthermore, n, m and p preferably each represent 1.

Of the structural units represented by the general formula (1), a structural unit derived from the monomer α,α'-bis-(trifluoromethyl)-bicyclo[2.2.1]hepta-5-ene-2-ethanol acrylate (which corresponds with the unit 1 in the formula 23 shown below) is preferred in terms of the effects achieved, the ease of synthesis, and the superior etching resistance obtained.

The structural unit (a1) may be either a single type of structural unit or a mixture of two or more different structural units.

### - Structural Unit (a2), which is a structural unit derived from an acrylate ester and includes a hydroxyl group-containing alicyclic group

In the component (A), by including the structural unit (a2), the swelling suppression effect is further enhanced. Furthermore, the etching resistance is also improved.
When the component (A) is blended into the negative resist composition, the hydroxyl group (alcoholic hydroxyl group) of the structural unit (a2) undergoes a reaction with the cross-linking agent (C) under the action of the acid generated from the acid generator (B), and this reaction causes the component (A) to change from a state of being soluble in the alkali developing solution to a state of being insoluble, thereby effecting the negative conversion.

In the structural unit (a2), the hydroxyl group-containing alicyclic group is preferably bonded to the ester group (-C(O)O-) of the acrylate ester.

Moreover, in the structural unit (a2), another substituent group may be bonded to the α-position (the α-position carbon atom) instead of a hydrogen atom. Examples of preferred substituent groups include an alkyl group, fluorinated alkyl group, or fluorine atom.
These groups are as described above in relation to the group R within the general formula (1) of the aforementioned structural unit (a1), and of the various groups that can be bonded to the α-position, a hydrogen atom or an alkyl group is preferred, a hydrogen atom or a methyl group is even more preferred, and a hydrogen atom is the most desirable.

Furthermore, the term "hydroxyl group-containing alicyclic group" refers to a group in which a hydroxyl group is bonded to an alicyclic group.
The number of hydroxyl groups is preferably within a range from 1 to 3, and is most preferably 1.
Furthermore, alkyl groups of 1 to 4 carbon atoms may also be bonded to the alicyclic group.

The alicyclic group may be either a monocyclic or polycyclic group, although a polycyclic group is preferred. Furthermore, an alicyclic hydrocarbon group is preferred. Furthermore, the group is preferably saturated. Moreover, the number of carbon atoms within the alicyclic group is preferably within a range from 5 to 15.

Specific examples of the alicyclic group include the groups described below.
Namely, examples of suitable monocyclic groups include groups in which one hydrogen atom has been removed from a cycloalkane. Examples of suitable polycyclic groups include groups in which one hydrogen atom has been removed from a bicycloalkane, tricycloalkane or tetracycloalkane or the like.
Specific examples of monocyclic groups include groups in which one hydrogen atom has been removed from cyclopentane or cyclohexane, and a cyclohexyl group is particularly preferred.
Examples of suitable polycyclic groups include groups in which one hydrogen atom has been removed from a polycycloalkane such as adamantane, norbornane, isobornane, tricyclodecane or tetracyclododecane.
These types of polycyclic groups can be selected appropriately from the multitude of groups proposed for forming acid-dissociable, dissolution-inhibiting groups for use within resins for positive photoresist compositions used within ArF excimer laser processes.
Of the various possibilities, a cyclohexyl group, adamantyl group, norbornyl group, and tetracyclododecanyl group are readily available industrially, and are consequently preferred.
Of the monocyclic and polycyclic groups exemplified above, groups a cyclohexyl group or adamantyl group is preferred, and an adamantyl group is particularly preferred.

Specific examples of preferred structural units (a2) include structural units represented by a general formula (2) shown below.

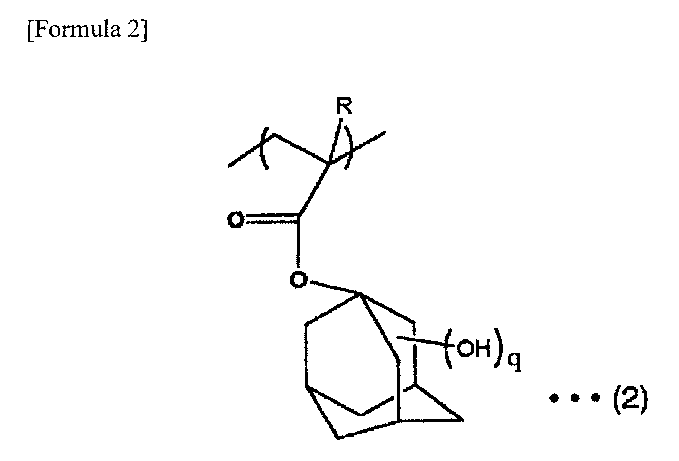

(wherein, R represents a hydrogen atom, an alkyl group, a fluorinated alkyl group, or a fluorine atom, and q represents an integer from 1 to 3)

R represents a hydrogen atom, an alkyl group, a fluorinated alkyl group or a fluorine atom that is bonded to the α-position, and is as described above in relation to the general formula (1). In the general formula (2), R is most preferably a hydrogen atom.
Furthermore, q represents an integer from 1 to 3, and is preferably 1.
Furthermore, although there are no particular restrictions on the bonding position of the hydroxyl group, units in which the hydroxyl group is bonded to position 3 of the adamantyl group are preferred.

The structural unit (a2) may be either a single type of structural unit or a mixture of two or more different structural units.

### - Structural Unit (a3), which is derived from acrylic acid, contains no cyclic structures, and includes an alcoholic hydroxyl group as a side chain

In addition to the structural unit (a1) and the structural unit (a2), the component (A) preferably also includes a structural unit (a3).
Including the structural unit (a3) enables an improvement in resolution to be achieved. Furthermore, thickness loss can also be suppressed. Furthermore, the controllability of the cross-linking reaction during pattern formation is favorable. Moreover, the film density also tends to increase. As a result, the heat resistance tends to improve. The etching resistance also improves.

The expression "contains no cyclic structures" means the structural unit contains no alicyclic groups or aromatic groups.
The structural unit (a3) is readily distinguishable from the structural unit (a2) as a result of containing no cyclic structures. When a component (A) that includes the structural unit (a3) is blended into a negative resist composition, the hydroxyl group of the hydroxyalkyl group of the structural unit (a3), together with the aforementioned hydroxyl group of the structural unit (a2), undergo reaction with the cross-linking agent (C) under the action of the acid generated from the acid generator (B), and this reaction causes the component (A) to change from a state of being soluble in the alkali developing solution to a state of being insoluble, thereby effecting the negative conversion.

The description "includes an alcoholic hydroxyl group as a side chain" refers to a structural unit which includes, for example, a bonded hydroxyalkyl group.
The hydroxyalkyl group may be bonded to the α-position carbon atom of the principal chain (the portion formed by cleavage of the ethylenic double bond of acrylic acid), or may form an ester group through substitution of the hydrogen atom of the carboxyl group of acrylic acid, and in the structural unit (a3), the hydroxyalkyl group preferably exists at either one, or both of these locations.

In those cases where the hydroxyalkyl group is not bonded to the α-position, the hydrogen atom at the α-position carbon atom may be replaced with an alkyl group, a fluorinated alkyl group, or a fluorine atom. These groups are as described above in relation to the group R within the general formula (1).

Furthermore, the structural unit (a3) is preferably a unit represented by a general formula (3) shown below.

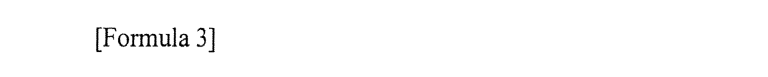

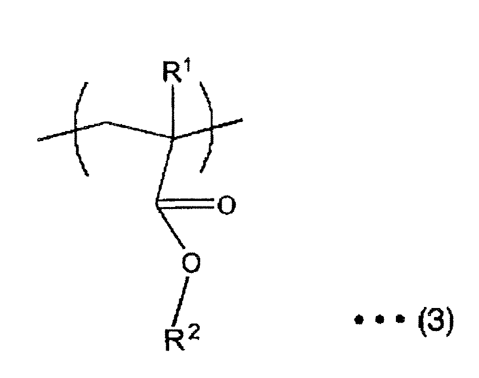

(wherein, R¹ represents a hydrogen atom, an alkyl group, a fluorinated alkyl group, a fluorine atom or a hydroxyalkyl group, and R² represents a hydrogen atom, an alkyl group, or a hydroxyalkyl group, provided that at least one of R¹ and R² represents a hydroxyalkyl group)

For the group R¹, a hydroxyalkyl group is preferably a lower hydroxyalkyl group of no more than 10 carbon atoms, even more preferably a lower hydroxyalkyl group of 2 to 8 carbon atoms, and is most preferably a hydroxymethyl group or hydroxyethyl group. There are no particular restrictions on the number of hydroxyl groups or the bonding positions of those groups, although one hydroxyl group is typical, and the hydroxyl group is preferably bonded to the terminal of the alkyl group.
For the group R¹, an alkyl group is preferably a lower alkyl group of no more than 10 carbon atoms, even more preferably a lower alkyl group of 2 to 8 carbon atoms, and is most preferably an ethyl group or methyl group.
For the group R¹, a fluorinated alkyl group is preferably a lower alkyl group of no more than 5 carbon atoms (most preferably an ethyl group or methyl group) in which a portion of, or all of, the hydrogen atoms have been substituted with fluorine atoms.
For the group R², suitable alkyl groups and hydroxyalkyl groups are the same as those described for R¹.

Specific examples of suitable units include structural units derived from (α-hydroxyalkyl) acrylic acid, structural units derived from alkyl (α-hydroxyalkyl) acrylate esters, and structural units derived from hydroxyalkyl (α-alkyl) acrylate esters.
Of these, from the viewpoints of improving the effects and increasing the film density, the structural unit (a3) is preferably a structural unit derived from an alkyl (α-hydroxyalkyl) acrylate ester.
Of these, structural units derived from either ethyl (α-hydroxymethyl) acrylate or methyl (α-hydroxymethyl) acrylate are particularly desirable.
Furthermore, the structural unit (a3) preferably includes a structural unit derived from a hydroxyalkyl (α-alkyl) acrylate ester. Of these, a structural unit derived from hydroxyethyl α-methyl-acrylate ester or hydroxymethyl α-methyl-acrylate ester is preferred.

The structural unit (a3) may be either a single type of structural unit or a mixture of two or more different structural units.

### - Structural Unit (a4) derived from an acrylate ester that includes a lactone-containing monocyclic or polycyclic group

In addition to the structural unit (a1) and the structural unit (a2), the component (A) preferably also includes a structural unit (a4) derived from an acrylate ester that includes a lactone-containing monocyclic or polycyclic group.
Furthermore, a combination of the structural unit (a1), the structural unit (a2), the structural unit (a4), and the structural unit (a3) may also be used.

When used in forming a resist film, the lactone-containing monocyclic or polycyclic group of the structural unit (a4) is effective in improving the adhesion between the resist film and the substrate, and enhancing the hydrophilicity of the component (A) relative to the developing solution. Furthermore, the structural unit (a4) also improves the swelling suppression effect.

In this description, the term "lactone" refers to a single ring containing a -O-C(O)- structure, and this lactone ring is counted as the first ring. Accordingly, groups that contain only the lactone ring are referred to as monocyclic groups, whereas groups that also contain other ring structures are described as polycyclic groups regardless of the structure of the other rings.

As the structural unit (a4), any group can be used without any particular restrictions, provided it includes a lactone ring that contains both the above type of ester structure (-O-C(O)-) and a cyclic structure.

Specifically, examples of lactone-containing monocyclic groups include groups in which one hydrogen atom has been removed from γ-butyrolactone. Examples of lactone-containing polycyclic groups include groups in which one hydrogen atom has been removed from a lactone ring-containing bicycloalkane, tricycloalkane, or tetracycloalkane.
Groups obtained by removing one hydrogen atom from a lactone-containing tricycloalkane with a structural formula such as that shown below are particularly preferred in terms of industrial availability.

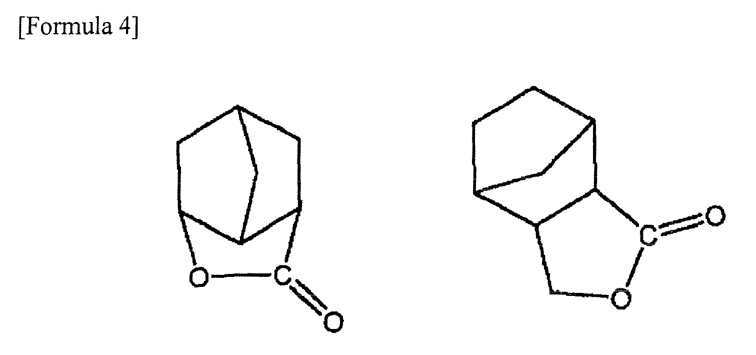

Furthermore, in the structural unit (a4), a lactone-containing polycyclic group is preferred, and structural units containing a norbornane lactone are particularly preferred.

In the structural unit (a4), another substituent group may be bonded to the α-position (the α-position carbon atom) instead of a hydrogen atom. Examples of preferred substituent groups include an alkyl group, fluorinated alkyl group, or fluorine atom.
These groups are as described above in relation to the group R within the general formula (1) of the aforementioned structural unit (a1), and of the various groups that can be bonded to the α-position, a hydrogen atom or an alkyl group is preferred, a hydrogen atom or a methyl group is even more preferred, and a hydrogen atom is the most desirable.

More specific examples of the structural unit (a4) include the structural units represented by general formulas (a4-1) to (a4-5) shown below.

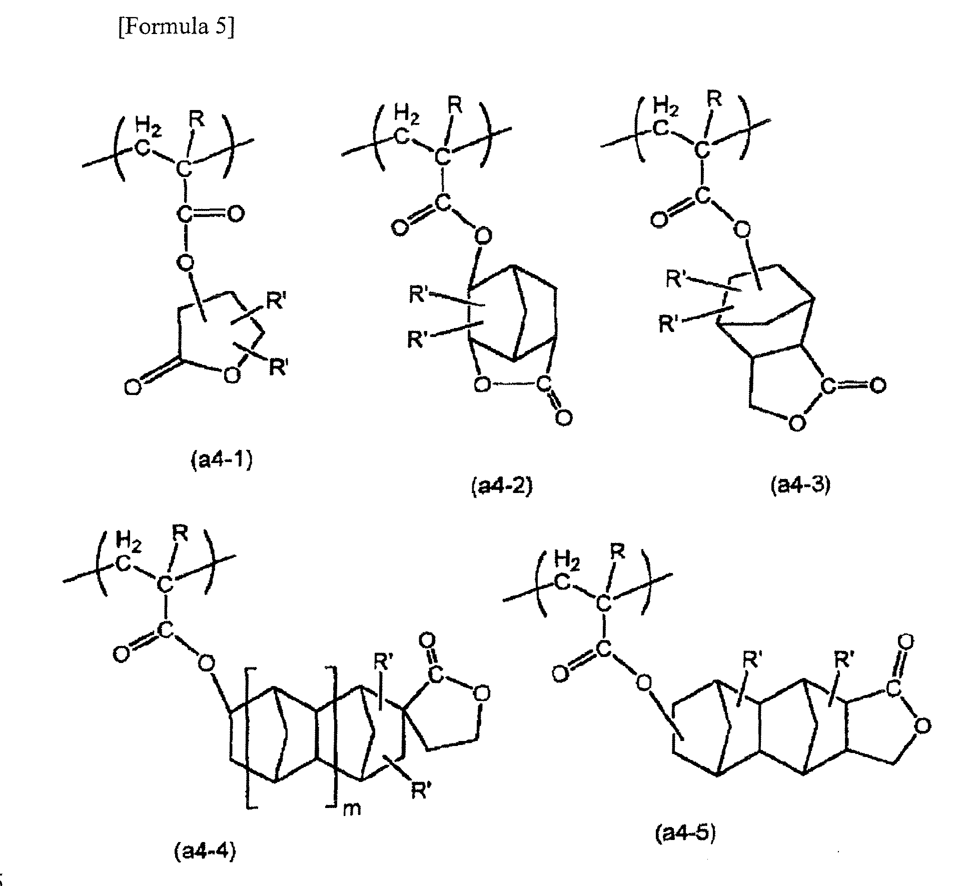

(wherein, R is as defined above, each R' represents, independently, a hydrogen atom, an alkyl group, or an alkoxy group of 1 to 5 carbon atoms, and m represents an integer of either 0 or 1)

Examples of the alkyl group of R' within the general formulas (a4-1) to (a4-5) include the same groups as those described in relation to the group R in the structural unit (a1). In the general formulas (a4-1) to (a4-5), from the viewpoint of factors such as industrial availability, R' is most preferably a hydrogen atom.

Moreover, as the structural unit (a4), units represented by the general formulas (a4-2) and (a4-3) are particularly preferred.

The structural unit (a4) may be either a single type of structural unit or a mixture of two or more different structural units.

### - Combination of Structural Unit (a1) through Structural Unit (a4)

In the component (A), the structural unit (a1) through structural unit (a4) are preferably selected and used in one of the four combinations described below.

### (i) Structural units selected so as to include a combination of the structural unit (a1) and the structural unit (a2)

In this case, the structural unit (a1) is preferably a structural unit represented by the general formula (1), and the group R within the general formula (1) is preferably a hydrogen atom. In addition, a hydrogen atom is preferably bonded to the α-position (the carbon atom to which the carboxyl group is bonded) of the structural unit (a2).
The reason for these preferences is that the above configuration yields an improved solubility contrast.

### (ii) Structural units selected so as to include a combination of the structural unit (a1), the structural unit (a2), and the structural unit (a3)

In this case, the structural unit (a1) is preferably a structural unit represented by the general formula (1), and the group R within the general formula (1) is preferably a hydrogen atom. In addition, a hydrogen atom is preferably bonded to the α-position of the structural unit (a2). The reason for these preferences is that this configuration yields an improved solubility contrast.

### (iii) Structural units selected so as to include a combination of the structural unit (a1), the structural unit (a2), and the structural unit (a4)

In this case, the structural unit (a1) is preferably a structural unit represented by the general formula (1), and the group R within the general formula (1) is preferably a hydrogen atom. In addition, a hydrogen atom is preferably bonded to the α-position of the structural unit (a2), and a hydrogen atom is preferably bonded to the α-position of the structural unit (a4).
The reason for these preferences is that this configuration yields an improved solubility contrast.

### (iv) Structural units selected so as to include a combination of the structural unit (a1), the structural unit (a2), the structural unit (a3), and the structural unit (a4)

In this case, the structural unit (a1) is preferably a structural unit represented by the general formula (1), and the group R within the general formula (1) is preferably a hydrogen atom. In addition, a hydrogen atom is preferably bonded to the α-position of the structural unit (a2), and a hydrogen atom is preferably bonded to the α-position of the structural unit (a4).
The reason for these preferences is that this configuration yields an improved solubility contrast.

### - Proportions of Structural Units (a1) to (a4)

In the component (A), when combining the structural units (a1) through (a4), one of the four combinations (i), (ii), (iii) or (iv) described above is preferably selected. For each of these combinations, the preferred proportions for each of the structural units are as described below.

### (i) Combination of the structural unit (a1) and the structural unit (a2)

In the case of a resin that contains at least the structural unit (a1) and the structural unit (a2) as essential units, and which is preferably formed solely from these two structural units, the proportions of each of the structural units within the resin preferably satisfy the numerical ranges described below.
Namely, the proportion of the structural unit (a1) is preferably within a range from 20 to 80 mol%, even more preferably from 30 to 70 mol%, and is most preferably from 35 to 55 mol%.
The proportion of the structural unit (a2) is preferably within a range from 20 to 80 mol%, even more preferably from 30 to 70 mol%, and is most preferably from 45 to 65 mol%.
Proportions that satisfy the above ranges yield an improvement in the swelling suppression effect.

### (ii) Combination of the structural unit (a1), the structural unit (a2), and the structural unit (a3)

In the case of a resin that contains the structural unit (a1), the structural unit (a2) and the structural unit (a3), and which is preferably formed solely from these structural units, the proportions of each of the structural units within the resin preferably satisfy the numerical ranges described below.
Namely, the proportion of the structural unit (a1) is preferably within a range from 20 to 80 mol%, even more preferably from 30 to 70 mol%, and is most preferably from 35 to 55 mol%.
The proportion of the structural unit (a2) is preferably within a range from 10 to 70 mol%, even more preferably from 10 to 50 mol%, and is most preferably from 20 to 40 mol%.
The proportion of the structural unit (a3) is preferably within a range from 10 to 70 mol%, even more preferably from 10 to 40 mol%, and is most preferably from 15 to 35 mol%.
Proportions that satisfy the above ranges yield an improvement in the swelling suppression effect. Furthermore, by ensuring a favorable balance between the structural unit (a2) and the structural unit (a3), a suitable level of contrast is obtained, enabling an improvement in the resolution. Furthermore, the etching resistance also improves. Moreover, a favorable exposure margin is also obtained.

### (iii) Combination of the structural unit (a1), the structural unit (a2), and the structural unit (a4)

In the case of a resin that contains the structural units (a1), (a2) and (a4), and which is preferably formed solely from these structural units, the proportions of each of the structural units within the resin preferably satisfy the numerical ranges described below.
Namely, the proportion of the structural unit (a1) is preferably within a range from 20 to 85 mol%, even more preferably from 30 to 70 mol%, and is most preferably from 35 to 50 mol%.
The proportion of the structural unit (a2) is preferably within a range from 14 to 70 mol%, even more preferably from 15 to 50 mol%, and is most preferably from 30 to 50 mol%.
The proportion of the structural unit (a4) is preferably within a range from 1 to 70 mol%, even more preferably from 3 to 50 mol%, and is most preferably from 5 to 20 mol%.
Proportions that satisfy the above ranges yield an improvement in the swelling suppression effect. Furthermore, the resist pattern shape is also more favorable.
By ensuring a favorable balance between the structural units (a1), (a2) and (a4), a suitable level of contrast is obtained, enabling an improvement in the resolution. Furthermore, the etching resistance also improves. Moreover, a favorable exposure margin is also obtained.

### (iv) Combination of the structural unit (a1), the structural unit (a2), the structural unit (a3), and the structural unit (a4)

In the case of a resin that contains all of the structural units (a1) through (a4), and which is preferably formed solely from these structural units, the proportions of each of the structural units within the resin preferably satisfy the numerical ranges described below.
Namely, the proportion of the structural unit (a1) is preferably within a range from 10 to 85 mol%, even more preferably from 20 to 70 mol%, and is most preferably from 25 to 50 mol%.
The proportion of the structural unit (a2) is preferably within a range from 10 to 80 mol%, even more preferably from 20 to 70 mol%, and is most preferably from 30 to 50 mol%.
The proportion of the structural unit (a3) is preferably within a range from 4 to 70 mol%, even more preferably from 7 to 50 mol%, and is most preferably from 10 to 30 mol%.
The proportion of the structural unit (a4) is preferably within a range from 1 to 70 mol%, even more preferably from 3 to 50 mol%, and is most preferably from 5 to 20 mol%.
Proportions that satisfy the above ranges yield an improvement in the swelling suppression effect. Furthermore, the resist pattern shape is also more favorable.
By ensuring a favorable balance between the structural units (a1) through (a4), a suitable level of contrast is obtained, enabling an improvement in the resolution. Furthermore, the etching resistance also improves. Moreover, a favorable exposure margin is also obtained.

In addition to the structural units selected from amongst the units (a1) through (a4), the component (A) may also include other copolymerizable structural units, but resins in which the primary components are selected from amongst the structural units (a1) through (a4) are preferred.
Here, the term "primary components" means that the combined total of these selected structural units preferably accounts for at least 70 mol%, even more preferably 80 mol% or greater, and most preferably 100 mol%, of the resin.

Particularly preferred configurations for the component (A) include resins formed from the structural unit (a1) and the structural unit (a2), resins formed from the structural unit (a1), the structural unit (a2) and the structural unit (a3), resins formed from the structural unit (a1), the structural unit (a2) and the structural unit (a4), and resins formed from the structural units (a1) through (a4), and the most preferred configurations are resins formed from the structural unit (a1), the structural unit (a2) and the structural unit (a3).

### - Weight Average Molecular Weight

The weight average molecular weight (Mw: the polystyrene equivalent weight average molecular weight determined using gel permeation chromatography) of the component (A) is preferably within a range from 2,000 to 30,000, even more preferably from 2,000 to 10,000, and is most preferably from 3,000 to 8,000. Ensuring a molecular weight within this range is preferred in terms of suppressing swelling, and suppressing the occurrence of the resulting microbridges. Furthermore, a molecular weight within the above range is also preferred in terms of achieving a high level of resolution. Lower molecular weights tend to result in more favorable properties.

The component (A) can be obtained, for example, by a conventional radical polymerization of the monomers that yield each of the structural units.
The component (A) may use either a single resin, or a combination of two or more different resins.

Furthermore, preferred weight average molecular weight values for the component (A0-0) and the component (A0) are the same as those described for the component (A).
The component (A0-0) and the component (A0) may use either a single resin, or a combination of two or more different resins.
Furthermore, the component (A0-0) and the component (A0) can use a resin besides the component (A).
The quantity of the component (A0-0) is preferably adjusted in accordance with the film thickness of the resist that is to be formed.

### Acid Generator Component (B) that Generates Acid on Exposure

There are no particular restrictions on the component (B), and any of the known acid generators used within conventional chemically amplified resist compositions can be used.

Examples of these acid generators are numerous, and include onium salt-based acid generators such as iodonium salts and sulfonium salts, oxime sulfonate-based acid generators, diazomethane-based acid generators such as bisalkyl or bisaryl sulfonyl diazomethanes and poly(bis-sulfonyl)diazomethanes, iminosulfonate-based acid generators, and disulfone-based acid generators.

Specific examples of suitable onium salt-based acid generators include diphenyliodonium trifluoromethanesulfonate or nonafluorobutanesulfonate, bis(4-tert-butylphenyl)iodonium trifluoromethanesulfonate or nonafluorobutanesulfonate, triphenylsulfonium trifluoromethanesulfonate, heptafluoropropanesulfonate or nonafluorobutanesulfonate, tri(4-methylphenyl)sulfonium trifluoromethanesulfonate, heptafluoropropanesulfonate or nonafluorobutanesulfonate, dimethyl(4-hydroxynaphthyl)sulfonium trifluoromethanesulfonate, heptafluoropropanesulfonate or nonafluorobutanesulfonate, monophenyldimethylsulfonium trifluoromethanesulfonate, heptafluoropropanesulfonate or nonafluorobutanesulfonate, diphenylmonomethylsulfonium trifluoromethanesulfonate, heptafluoropropanesulfonate or nonafluorobutanesulfonate, (4-methylphenyl)diphenylsulfonium trifluoromethanesulfonate, heptafluoropropanesulfonate or nonafluorobutanesulfonate, (4-methoxyphenyl)diphenylsulfonium trifluoromethanesulfonate, heptafluoropropanesulfonate or nonafluorobutanesulfonate, and tri(4-tert-butyl)phenylsulfonium trifluoromethanesulfonate, heptafluoropropanesulfonate or nonafluorobutanesulfonate.

Specific examples of suitable oxime sulfonate-based acid generators include α-(methylsulfonyloxyimino)-phenyl acetonitrile, α-(methylsulfonyloxyimino)-p-methoxyphenyl acetonitrile, α-(trifluoromethylsulfonyloxyimino)-phenyl acetonitrile, α-(trifluoromethylsulfonyloxyimino)-p-methoxyphenyl acetonitrile, α-(ethylsulfonyloxyimino)-p-methoxyphenyl acetonitrile, α-(propylsulfonyloxyimino)-p-methylphenyl acetonitrile, and α-(methylsulfonyloxyimino)-p-bromophenyl acetonitrile. Of these, α-(methylsulfonyloxyimino)-p-methoxyphenyl acetonitrile is preferred.

Of the aforementioned diazomethane-based acid generators, specific examples of suitable bisalkyl or bisaryl sulfonyl diazomethanes include bis(isopropylsulfonyl)diazomethane, bis(p-toluenesulfonyl)diazomethane, bis(1,1-dimethylethylsulfonyl)diazomethane, bis(cyclohexylsulfonyl)diazomethane, and bis(2,4-dimethylphenylsulfonyl)diazomethane.
Furthermore, specific examples of poly(bis-sulfonyl)diazomethanes include the structures shown below, such as 1,3-bis(phenylsulfonyldiazomethylsulfonyl)propane (compound A), 1,4-bis(phenylsulfonyldiazomethylsulfonyl)butane (compound B), 1,6-bis(phenylsulfonyldiazomethylsulfonyl)hexane (compound C), 1,10-bis(phenylsulfonyldiazomethylsulfonyl)decane (compound D), 1,2-bis(cyclohexylsulfonyldiazomethylsulfonyl)ethane (compound E), 1,3-bis(cyclohexylsulfonyldiazomethylsulfonyl)propane (compound F), 1,6-bis(cyclohexylsulfonyldiazomethylsulfonyl)hexane (compound G), and 1,10-bis(cyclohexylsulfonyldiazomethylsulfonyl)decane (compound H).

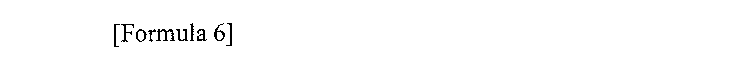

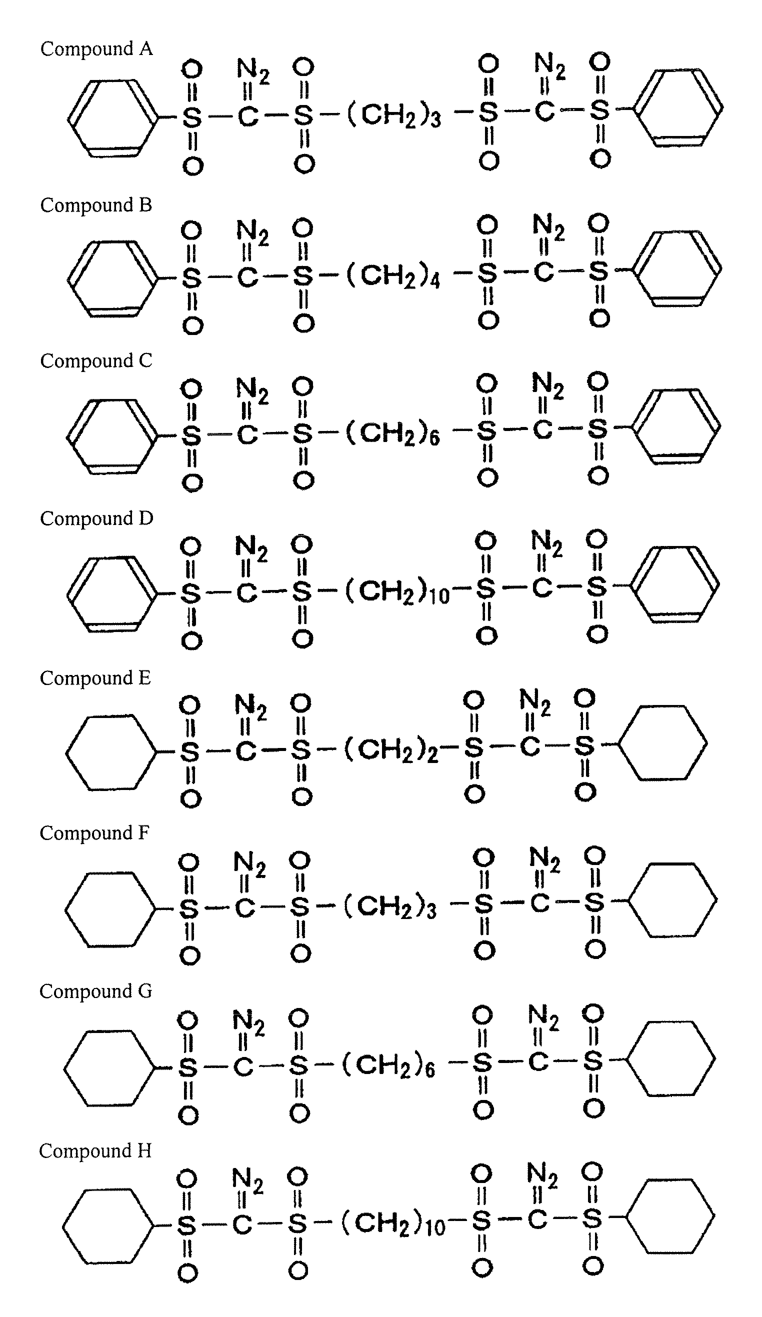

Furthermore, as the component (B), the use of at least one sulfonium compound selected from the group consisting of structural units represented by general formulas (b-1) and (b-2) shown below is also preferred.

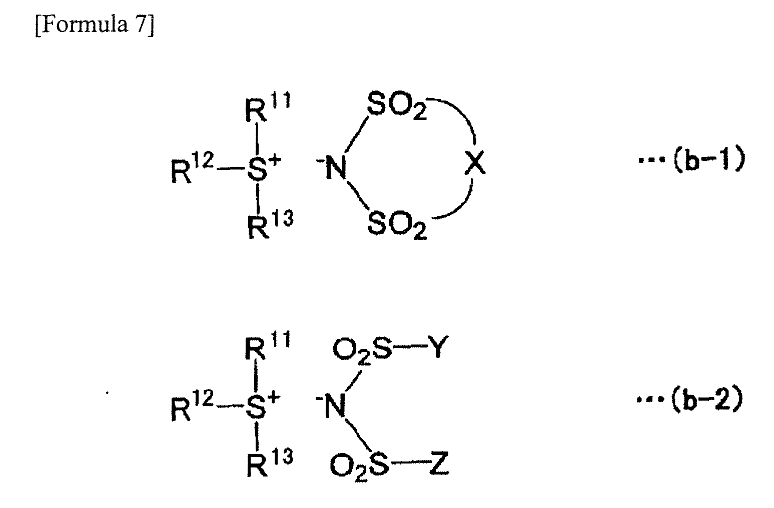

[In these formulas, X represents an alkylene group of 2 to 6 carbon atoms in which at least one hydrogen atom has been substituted with a fluorine atom; Y and Z each represent, independently, an alkyl group of 1 to 10 carbon atoms in which at least one hydrogen atom has been substituted with a fluorine atom; and R¹¹ to R¹³ each represent, independently, an aryl group or an alkyl group, although at least one of the groups R¹¹ to R¹³ is an aryl group.]

In the formulas (b-1) and (b-2), the group X is a straight-chain or branched alkylene group in which at least one hydrogen atom has been substituted with a fluorine atom, and the number of carbon atoms within the alkylene group is typically within a range from 2 to 6, preferably from 3 to 5, and is most preferably 3.
Y and Z each represent, independently, a straight-chain or branched alkyl group in which at least one hydrogen atom has been substituted with a fluorine atom, and the number of carbon atoms within the alkyl group is typically within a range from 1 to 10, preferably from 1 to 7, and is most preferably from 1 to 3.
Lower numbers of carbon atoms within the alkylene group X or the alkyl groups Y and Z result in better solubility within the resist solvent, and are consequently preferred.
Furthermore, in the alkylene group X or the alkyl groups Y and Z, the larger the number of hydrogen atoms that have been substituted with fluorine atoms, the stronger the acid becomes, and the transparency relative to high energy light beams of 200 nm or less or electron beams also improves favorably. The fluorine atom proportion within the alkylene group or alkyl groups, namely the fluorination ratio, is preferably within a range from 70 to 100%, and even more preferably from 90 to 100%, and perfluoroalkylene or perfluoroalkyl groups in which all of the hydrogen atoms have been substituted with fluorine atoms are the most desirable.

R¹¹ to R¹³ each represent, independently, an aryl group or an alkyl group.
Of the groups R¹¹ to R¹³, at least one group represents an aryl group. Compounds in which at least two of R¹¹ to R¹³ represent aryl groups are preferred, and compounds in which all of R¹¹ to R¹³ are aryl groups are the most preferred.
There are no particular restrictions on the aryl groups of R¹¹ to R¹³, and suitable examples include aryl groups of 6 to 20 carbon atoms, such as phenyl groups and naphthyl groups, which may, or may not, be substituted with alkyl groups, alkoxy groups, or halogen atoms or the like. In terms of enabling low cost synthesis, aryl groups of 6 to 10 carbon atoms are preferred.
There are no particular restrictions on the alkyl groups of R¹¹ to R¹³, and suitable examples include straight-chain, branched, or cyclic alkyl groups of 1 to 10 carbon atoms. From the viewpoint of achieving excellent resolution, alkyl groups of 1 to 5 carbon atoms are preferred. Specific examples include a methyl group, ethyl group, n-propyl group, isopropyl group, n-butyl group, isobutyl group, n-pentyl group, cyclopentyl group, hexyl group, cyclohexyl group, nonyl group, and decanyl group, although in terms of achieving superior resolution and enabling low cost synthesis, a methyl group is the most desirable.
Of the above possibilities, compounds in which R¹¹ to R¹³ are all phenyl groups are the most preferred.

These sulfonium compounds may be used either alone, or in combinations of two or more different compounds.

Of the above, from the viewpoint of the reactivity between the component (A0-0) and the component (C), the component (B) is preferably an onium salt having a fluorinated alkylsulfonate ion as the anion.
Similarly, in the positive resist composition described below, the use of an onium salt having a fluorinated alkylsulfonate ion as the anion is preferred.
As the component (B), either a single acid generator may be used alone, or a combination of two or more different acid generators may be used.

The quantity of the component (B), is typically within a range from 0.5 to 30 parts by weight, and preferably from 1 to 10 parts by weight, per 100 parts by weight of the component (A0-0). Ensuring the quantity satisfies this range enables satisfactory pattern formation to be conducted. Furthermore, a uniform solution is obtained, and the storage stability is also favorable, both of which are desirable.

### Cross-linking Agent Component (C)

There are no particular restrictions on the component (C), which may be selected appropriately from the various cross-linking agents used in conventional chemically amplified negative resist compositions.

Specific examples include aliphatic cyclic hydrocarbons containing a hydroxyl group and/or a hydroxyalkyl group, or oxygen-containing derivatives thereof, such as 2,3-dihydroxy-5-hydroxymethylnorbomane, 2-hydroxy-5,6-bis(hydroxymethyl)norbomane, cyclohexanedimethanol, 3,4,8(or 9)-trihydroxytricyclodecane, 2-methyl-2-adamantanol, 1,4-dioxane-2,3-diol, and 1,3,5-trihydroxycyclohexane.
Furthermore, other suitable examples include compounds produced by reacting an amino group-containing compound such as melamine, acetoguanamine, benzoguanamine, urea, ethylene urea, or glycoluril with either formaldehyde or a combination of formaldehyde and a lower alcohol, thereby substituting the hydrogen atoms of the amino group with hydroxymethyl groups or lower alkoxymethyl groups.
Of these, compounds that use melamine are referred to as melamine-based cross-linking agents, compounds that use urea are referred to as urea-based cross-linking agents, compounds that use ethylene urea are referred to as ethylene urea-based cross-linking agents, and compounds that use glycoluril are referred to as glycoluril-based cross-linking agents.
Specific examples include hexamethoxymethylmelamine, bismethoxymethylurea, bismethoxymethylbismethoxyethylene urea, tetramethoxymethylglycoluril, and tetrabutoxymethylglycoluril.

The component (C) is preferably at least one compound selected from amongst melamine-based cross-linking agents, urea-based cross-linking agents, ethylene urea-based cross-linking agents, propylene urea-based cross-linking agents, and glycoluril-based cross-linking agents. Glycoluril-based cross-linking agents are particularly desirable.

As the glycoluril-based cross-linking agent, glycoluril compounds in which the N-position is substituted with hydroxyalkyl groups and/or lower alkoxyalkyl groups that function as cross-link-forming groups are preferred.
Specific examples of glycoluril-based cross-linking agents include mono-, di-, tri-, or tetra-hydroxymethylated glycoluril, mono-, di-, tri-, and/or tetra-methoxymethylated glycoluril, mono-, di-, tri-, and/or tetra-ethoxymethylated glycoluril, mono-, di-, tri-, and/or tetra-propoxymethylated glycoluril, and mono-, di-, tri-, and/or tetra-butoxymethylated glycoluril. The expression "mono-, di-, tri-, and/or tetra-" means the compound may include one or more of the mono-substituted form, di-substituted form, tri-substituted form or tetra-substituted form, and the tri- and tetra-substituted forms are preferred.
Furthermore, mono-, di-, tri-, and/or tetra-methoxymethylated glycoluril, and mono-, di-, tri-, and/or tetra-butoxymethylated glycoluril are also particularly preferred.
From the viewpoints of achieving superior contrast and resolution, mono-, di-, tri-, and/or tetra-methoxymethylated glycoluril is the most preferred. This cross-linking agent is available commercially under the product name "Mx270" (manufactured by Sanwa Chemical Co., Ltd.). This product contains almost entirely tri- and tetra-substituted compounds, and is a mixture of monomers, dimers and trimers.

The blend quantity of the component (C) is typically within a range from 3 to 15 parts by weight, and preferably from 5 to 10 parts by weight, per 100 parts by weight of the component (A0-0). By ensuring this quantity is at least as large as the lower limit of the above range, the component (A0-0) can be readily converted to an alkali-insoluble state. Ensuring the quantity is no larger than the upper limit enables any deterioration in the resolution to be prevented. Lower quantities of the cross-linking agent tend to yield improved resolution.

### Nitrogen-containing Organic Compound (D)

In the negative resist composition, in order to improve the resist pattern shape and the post exposure stability of the latent image formed by the pattern-wise exposure of the resist layer, a nitrogen-containing organic compound (D) (hereafter referred to as the component (D)) may also be added as an optional component.
A multitude of these components (D) have already been proposed, and any of these known compounds can be used, although an aliphatic amine, and particularly a secondary aliphatic amine or tertiary aliphatic amine is preferred.
Examples of these aliphatic amines include amines in which at least one hydrogen atom of ammonia NH₃ has been substituted with an alkyl group or hydroxyalkyl group of no more than 12 carbon atoms (that is, alkylamines or alkyl alcohol amines). Specific examples of these aliphatic amines include monoalkylamines such as n-hexylamine, n-heptylamine, n-octylamine, n-nonylamine, and n-decylamine; dialkylamines such as diethylamine, di-n-propylamine, di-n-heptylamine, di-n-octylamine, and dicyclohexylamine; trialkylamines such as trimethylamine, triethylamine, tri-n-propylamine, tri-n-butylamine, tri-n-hexylamine, tri-n-pentylamine, tri-n-heptylamine, tri-n-octylamine, tri-n-nonylamine, tri-n-decanylamine, and tri-n-dodecylamine; and alkyl alcohol amines such as diethanolamine, triethanolamine, diisopropanolamine, triisopropanolamine, di-n-octanolamine, and tri-n-octanolamine.
These compounds may be used either alone, or in combinations of two or more different compounds.
The component (D) is typically used in a quantity within a range from 0.01 to 5.0 parts by weight per 100 parts by weight of the component (A0-0). Of the above amines, alkyl alcohol amines and trialkylamines are preferred, and alkyl alcohol amines are the most desirable. Amongst the various alkyl alcohol amines, triethanolamine and triisopropanolamine are the most preferred.

### Component (E)

In order to prevent any deterioration in sensitivity caused by the addition of the above component (D), and improve the resist pattern shape and the post exposure stability of the latent image formed by the pattern-wise exposure of the resist layer, an organic carboxylic acid, or a phosphorus oxo acid or derivative thereof (E) (hereafter referred to as the component (E)) may also be added as another optional component. The component (D) and the component (E) can be used in combination, or either one can also be used alone.
Examples of suitable organic carboxylic acids include malonic acid, citric acid, malic acid, succinic acid, benzoic acid, and salicylic acid.
Examples of suitable phosphorus oxo acids or derivatives thereof include phosphoric acid or derivatives thereof such as esters, including phosphoric acid, di-n-butyl phosphate and diphenyl phosphate; phosphonic acid or derivatives thereof such as esters, including phosphonic acid, dimethyl phosphonate, di-n-butyl phosphonate, phenylphosphonic acid, diphenyl phosphonate, and dibenzyl phosphonate; and phosphinic acid or derivatives thereof such as esters, including phosphinic acid and phenylphosphinic acid, and of these, phosphonic acid is particularly preferred.
The component (E) is typically used in a quantity within a range from 0.01 to 5.0 parts by weight per 100 parts by weight of the component (A0-0).

### Other Optional Components

Other miscible additives can also be added to the negative resist composition according to need, and examples include additive resins for improving the performance of the resist film, surfactants for improving the ease of application, dissolution inhibitors, plasticizers, stabilizers, colorants, halation prevention agents, and dyes.

### [Positive Resist Composition]

In the following description of the positive resist composition, the meanings of the terms used are as listed below.
The term "(α-lower alkyl) acrylate ester" is a generic term that includes α-lower alkyl acrylate esters such as methacrylate, and/or acrylate ester.
Here, an "α-lower alkyl acrylate ester" refers to a structure in which the hydrogen atom bonded to the α-carbon atom of an acrylate ester has been substituted with a lower alkyl group.
A "structural unit" refers to a monomer unit that contributes to the formation of a polymer.
The expression "structural unit derived from an acrylate ester" refers to a structural unit that is formed by cleavage of the ethylenic double bond of an acrylate ester.
The expression "structural unit derived from an α-lower alkyl acrylate ester" refers to a structural unit that is formed by cleavage of the ethylenic double bond of an α-lower alkyl acrylate ester.
The expression "structural unit derived from an (α-lower alkyl) acrylate ester" refers to a structural unit that is formed by cleavage of the ethylenic double bond of an (α-lower alkyl) acrylate ester.

The positive resist composition is a resist composition containing a resin component (A0') that exhibits increased alkali solubility under the action of acid, and an acid generator component (B) that generates acid on exposure, wherein
the above component (A0') is preferably a resin component (A'), which contains structural units derived from (α-lower alkyl) acrylate esters, and exhibits increased alkali solubility under the action of acid.
Moreover, the component (A') preferably includes a structural unit (a1') derived from an (α-lower alkyl) acrylate ester that contains an acid dissociable, dissolution inhibiting group, and a structural unit (a2') derived from an (α-lower alkyl) acrylate ester that contains a lactone ring.
Furthermore, the component (A') preferably also includes a structural unit (a3') derived from an (α-lower alkyl) acrylate ester that contains a polar group-containing polycyclic group.

### - Structural Unit (a 1')

In the structural unit (a1'), a hydrogen atom or a lower alkyl group is bonded to the α-carbon atom.
The lower alkyl group is preferably a straight-chain or branched alkyl group of 1 to 5 carbon atoms, and specific examples include a methyl group, ethyl group, propyl group, isopropyl group, n-butyl group, isobutyl group, tert-butyl group, pentyl group, isopentyl group, and neopentyl group. Of these, a methyl group is preferred industrially.
Of the above possibilities, a hydrogen atom or a methyl group is preferred.

The acid dissociable, dissolution inhibiting group of the structural unit (a1') is a group that exhibits an alkali dissolution inhibiting effect that renders the entire component (A') alkali-insoluble prior to exposure, but then dissociates under the action of acid generated from the acid generator (B) following exposure, causing the entire component (A') to change to an alkali-soluble state.
The acid dissociable, dissolution inhibiting group can be selected appropriately from the multitude of such groups proposed for use within resins for resist compositions used with an ArF excimer laser. Typically, groups that form either a cyclic or chain-like tertiary alkyl ester, or a cyclic or chain-like alkoxyalkyl ester with the carboxyl group of acrylic acid are the most widely known.

A cyclic or chain-like alkoxyalkyl ester refers to a structure in which the hydrogen atom of a carboxyl group has been substituted with an alkoxyalkyl group to form an ester, so that the alkoxyalkyl group is bonded to the terminal oxygen atom of the carbonyloxy group (-C(O)-O-), and when an acid acts on this alkoxyalkyl ester, the bond between the oxygen atom and the alkoxyalkyl group is broken. Examples of these types of cyclic or chain-like alkoxyalkyl groups include a 1-methoxymethyl group, 1-ethoxyethyl group, 1-isopropoxyethyl group, 1-cyclohexyloxyethyl group, 2-adamantoxymethyl group, 1-methyladamantoxymethyl group, and 4-oxo-2-adamantoxymethyl group.
Examples of acid dissociable, dissolution inhibiting groups that form a chain-like tertiary alkyl ester include a t-butyl group or tert-amyl group.
As the structural unit (a1'), structural units that include an acid dissociable, dissolution inhibiting group that contains a cyclic group, and particularly an alicyclic group, are preferred. The alicyclic group may be either a monocyclic or a polycyclic group, and can be selected appropriately from the multitude of such groups proposed for use within ArF resists, although from the viewpoint of etching resistance, a polycyclic alicyclic group is preferred. Furthermore, the alicyclic group is preferably a hydrocarbon group, and is preferably saturated.
Examples of suitable monocyclic alicyclic groups include groups in which one hydrogen atom has been removed from a cycloalkane. Examples of suitable polycyclic alicyclic groups include groups in which one hydrogen atom has been removed from a bicycloalkane, tricycloalkane or tetracycloalkane or the like.
Specifically, examples of suitable monocyclic groups include a cyclopentyl group or cyclohexyl group. Examples of suitable polycyclic groups include groups in which one hydrogen atom has been removed from a polycycloalkane such as adamantane, norbornane, isobornane, tricyclodecane or tetracyclododecane.
Of these groups, an adamantyl group in which one hydrogen atom has been removed from adamantane, a norbornyl group in which one hydrogen atom has been removed from norbornane, a tricyclodecanyl group in which one hydrogen atom has been removed from tricyclodecane, and a tetracyclododecanyl group in which one hydrogen atom has been removed from tetracyclododecane are preferred industrially.

More specifically, the structural unit (a1') is preferably at least one unit selected from the general formulas (I') to (III') shown below.

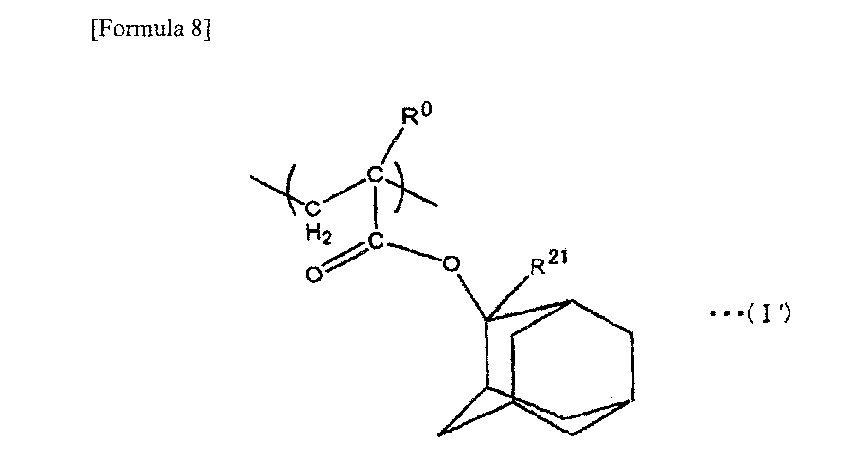

[wherein, R⁰ represents a hydrogen atom or a lower alkyl group, and R²¹ represents a lower alkyl group]

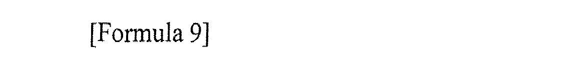

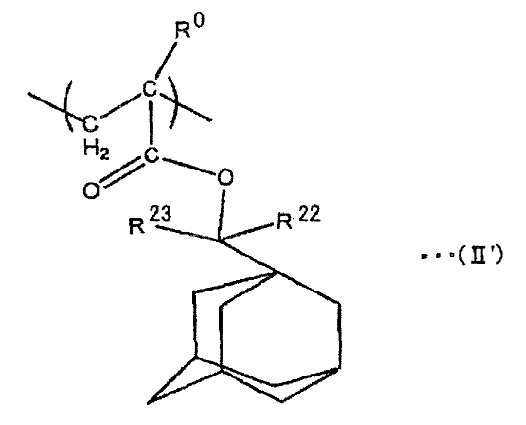

[wherein, R⁰ represents a hydrogen atom or a lower alkyl group, and R²² and R²³ each represent, independently, a lower alkyl group]

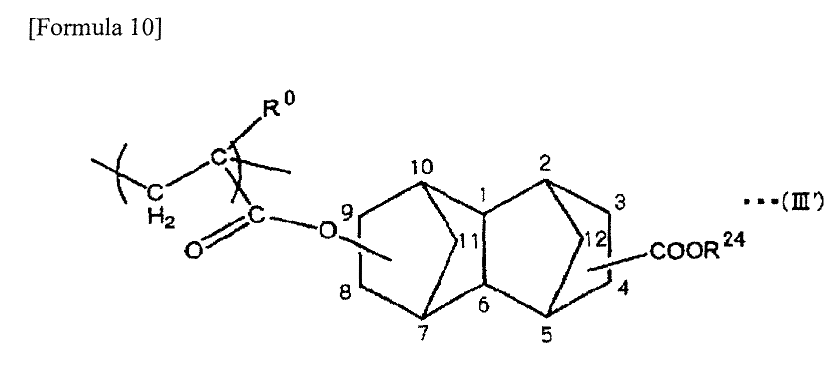

[wherein, R¹⁴ represents a tertiary alkyl group]

The group R⁰ is a hydrogen atom or a lower alkyl group. The lower alkyl group is preferably a straight-chain or branched alkyl group of 1 to 5 carbon atoms, and specific examples include a methyl group, ethyl group, propyl group, isopropyl group, n-butyl group, isobutyl group, tert-butyl group, pentyl group, isopentyl group, or neopentyl group. Of these, a methyl group is preferred industrially. Furthermore, of the various possibilities, a hydrogen atom or a methyl group is preferred.
The group R²¹ is preferably a straight-chain or branched lower alkyl group of 1 to 5 carbon atoms, and specific examples include a methyl group, ethyl group, propyl group, isopropyl group, n-butyl group, isobutyl group, pentyl group, isopentyl group, or neopentyl group. Of these, a methyl group or ethyl group is preferred from the viewpoint of industrial availability.

The groups R²² and R²³ each preferably represent, independently, a straight-chain or branched lower alkyl group of 1 to 5 carbon atoms. Of these groups, those cases in which R²² and R²³ are both methyl groups are preferred industrially, and a structural unit derived from 2-(1-adamantyl)-2-propyl acrylate is a specific example.

Furthermore, the group R²⁴ is preferably a chain-like tertiary alkyl group or a cyclic tertiary alkyl group. Examples of chain-like tertiary alkyl groups include a tert-butyl group or tert-amyl group, although those cases in which R⁴ is a tert-butyl group are preferred industrially. A tertiary alkyl group refers to an alkyl group that includes a tertiary carbon atom.
Examples of cyclic tertiary alkyl groups include the same groups as those exemplified above in relation to the "acid dissociable, dissolution inhibiting group that contains an alicyclic group", and specific examples include a 2-methyl-2-adamantyl group, 2-ethyl-2-adamantyl group, 2-(1-adamantyl)-2-propyl group, 1-ethylcyclohexyl group, 1-ethylcyclopentyl group, 1-methylcyclohexyl group or 1-methylcyclopentyl group.
Furthermore, the group -COOR²⁴ may be bonded to either position 3 or 4 of the tetracyclododecanyl group shown in the formula, although the bonding position cannot be further specified. Furthermore, the carboxyl group residue of the acrylate structural unit may be bonded to either position 8 or 9 within the formula, although similarly, the bonding position cannot be further specified.

The structural unit (a1') may use either a single structural unit, or a combination of two or more different structural units.
The proportion of the structural unit (a1'), relative to the combined total of all the structural units within the component (A'), is typically within a range from 20 to 60 mol%, and is preferably from 30 to 50 mol%, and most preferably from 35 to 45 mol%. By ensuring that this proportion is at least as large as the lower limit of the above range, a favorable pattern can be obtained, whereas ensuring that the proportion is no greater than the upper limit enables a favorable balance to be achieved with the other structural units.

### - Structural Unit (a2')

In the structural unit (a2'), a hydrogen atom or a lower alkyl group is bonded to the α-carbon atom, as was the case for the structural unit (a1').
Examples of the structural unit (a2') include structural units in which a monocyclic group formed from a lactone ring or a polycyclic group that includes a lactone ring is bonded to the ester side-chain portion of an (α-lower alkyl) acrylate ester. The term lactone ring refers to a single ring containing a -O-C(O)- structure, and this ring is counted as the first ring. Accordingly, in this description, the case in which the only ring structure is the lactone ring is referred to as a monocyclic group, and groups containing other ring structures are described as polycyclic groups regardless of the structure of the other rings.
Specific examples of the structural unit (a2') include units that contain a monocyclic group in which one hydrogen atom has been removed from γ-butyrolactone, and units that contain a polycyclic group in which one hydrogen atom has been removed from a lactone ring-containing bicycloalkane.

Specifically, the structural unit (a2') is preferably at least one unit selected from general formulas (IV') through (VII') shown below.

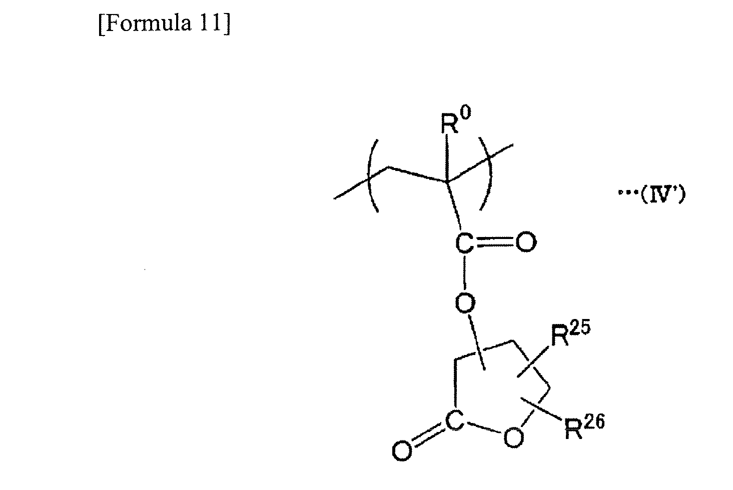

[wherein, R⁰ represents a hydrogen atom or a lower alkyl group, and R²⁵ and R²⁶ each represent, independently, a hydrogen atom or a lower alkyl group]

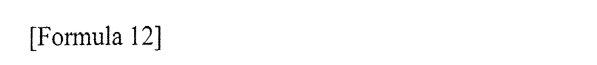

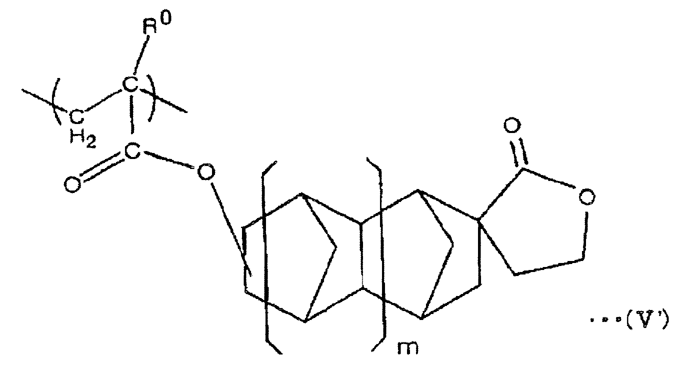

[wherein, R⁰ represents a hydrogen atom or a lower alkyl group, and m represents either 0 or 1]

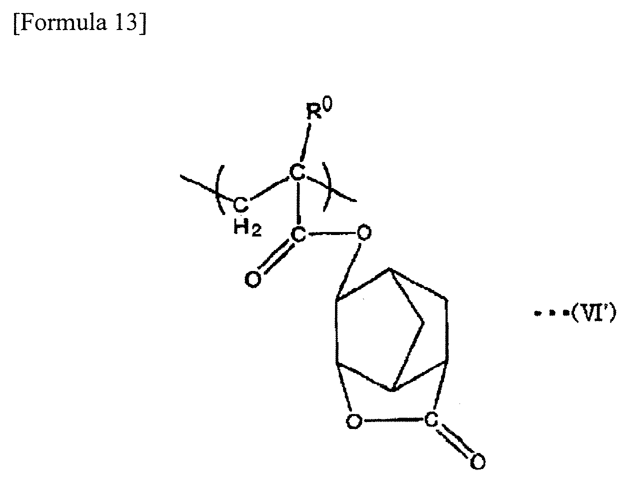

[wherein, R⁰ represents a hydrogen atom or a lower alkyl group]

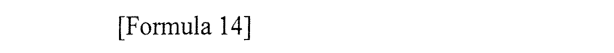

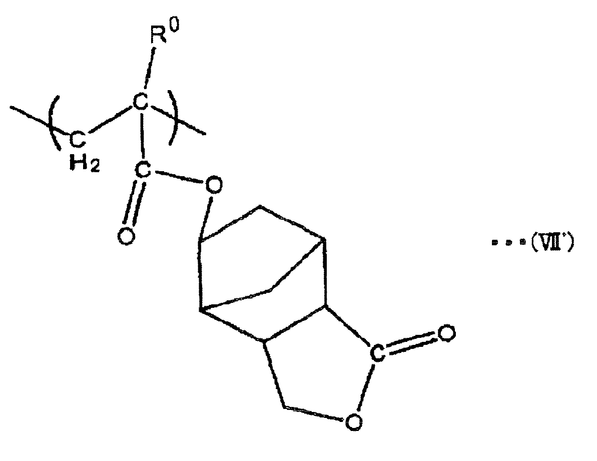

[wherein, R⁰ represents a hydrogen atom or a lower alkyl group.]

R⁰ is as described above.
In the formula (IV'), R²⁵ and R²⁶ each represent, independently, a hydrogen atom or a lower alkyl group, and preferably a hydrogen atom.
Suitable lower alkyl groups for the groups R²⁵ and R²⁶ are preferably straight-chain or branched alkyl groups of 1 to 5 carbon atoms, and specific examples include a methyl group, ethyl group, propyl group, isopropyl group, n-butyl group, isobutyl group, tert-butyl group, pentyl group, isopentyl group, or neopentyl group. A methyl group is preferred industrially.
Furthermore, amongst the structural units represented by the general formulas (IV') through (VII'), structural units represented by the general formula (IV') are preferred, and of the possible structural units represented by the formula (IV'), α-methacryloyloxy-y-butyrolactone, in which R⁰ is a methyl group, R²⁵ and R²⁶ are both hydrogen atoms, and the position of the ester linkage between the methacrylate ester and the γ-butyrolactone is at the α-position of the lactone ring, is the most desirable.

The structural unit (a2') may use either a single structural unit, or a combination of two or more different structural units.
The proportion of the structural unit (a2'), relative to the combined total of all the structural units within the component (A'), is typically within a range from 20 to 60 mol%, and is preferably from 20 to 50 mol%, and most preferably from 30 to 45 mol%. Ensuring that this proportion is at least as large as the lower limit of the above range improves the lithography characteristics, whereas ensuring that the proportion is no greater than the upper limit enables a favorable balance to be achieved with the other structural units.

### - Structural Unit (a3')

Including the structural unit (a3') increases the hydrophilicity of the entire component (A'), thereby improving the affinity with the developing solution, improving the alkali solubility within the exposed portions of the resist, and contributing to an improvement in the resolution.
In the structural unit (a3'), either a lower alkyl group or a hydrogen atom may be bonded to the α-carbon atom. Details of suitable lower alkyl groups are as described above.
Examples of the polar group include a hydroxyl group, cyano group, carboxyl group, or amino group or the like, although a hydroxyl group is particularly preferred.
Examples of the polycyclic group include polycyclic alicyclic hydrocarbon groups (polycyclic groups). This polycyclic group can be selected appropriately from the same multitude of polycyclic groups exemplified above in relation to the structural unit (a1').

Specifically, the structural unit (a3) is preferably at least one unit selected from the general formulas (VIII') through (IX') shown below.

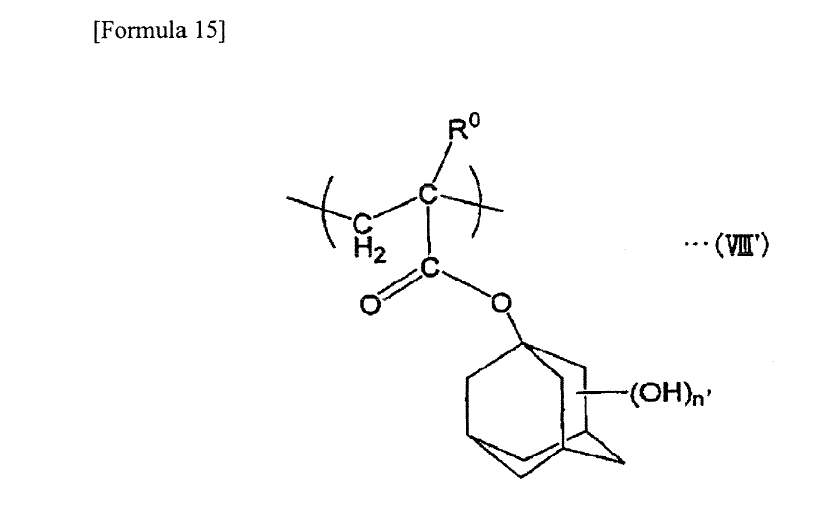

[wherein, R⁰ represents a hydrogen atom or a lower alkyl group, and n' represents an integer from 1 to 3]

R⁰ is as described above.
Of these units, structural units in which n' is 1, and the hydroxyl group is bonded to position 3 of the adamantyl group are preferred.

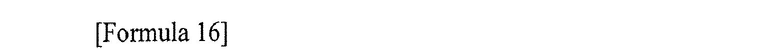

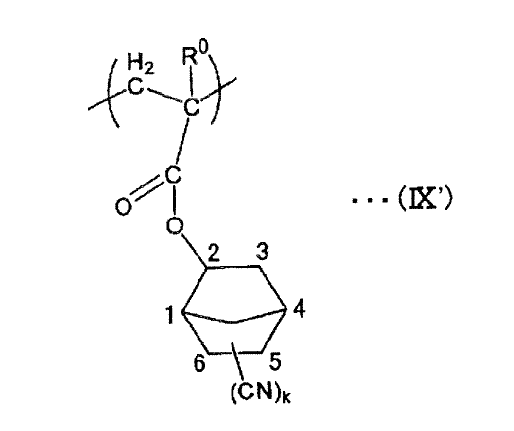

[wherein, R⁰ represents a hydrogen atom or a lower alkyl group, and k represents an integer from 1 to 3.]

R⁰ is as described above.
Of these units, structural units in which k is 1 are preferred. Furthermore, the cyano group is preferably bonded to position 5 or position 6 of the norbornyl group.

The structural unit (a3') may use either a single structural unit, or a combination of two or more different structural units.
The proportion of the structural unit (a3'), relative to the combined total of all the structural units that constitute the component (A'), is typically within a range from 10 to 50 mol%, preferably from 15 to 40 mol%, and is most preferably from 20 to 30 mol%.
Ensuring that this proportion is at least as large as the lower limit of the above range improves the lithography characteristics, whereas ensuring that the proportion is no greater than the upper limit enables a favorable balance to be achieved with the other structural units.

### - Other Structural Units

The component (A') may include structural units other than the aforementioned structural units (a1') through (a3'), but the combined total of these structural units (a1') through (a3'), relative to the combined total of all the structural units, is typically at least 70 mol%, preferably 80 mol% or greater, and is most preferably 100 mol%.
A structural unit (a4') other than the structural units (a1') through (a3') may be any other structural unit that cannot be classified as one of the above structural units (a1') through (a3'), and there are no particular restrictions.

Structural units that, for example, contain a polycyclic alicyclic hydrocarbon group and are derived from an (α-lower alkyl) acrylate ester are preferred. Examples of the polycyclic alicyclic hydrocarbon group include, for example, the same multitude of groups listed above in relation to the structural unit (a1'), and of these, in terms of industrial availability and the like, one or more groups selected from amongst a tricyclodecanyl group, adamantyl group, tetracyclododecanyl group, norbornyl group, and isobornyl group is preferred.
Specific examples of the structural unit (a4') include units of the structures (X) to (XII) shown below.

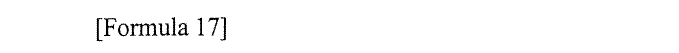

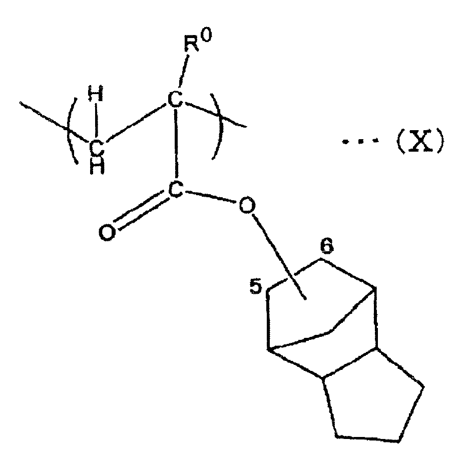

(wherein, R⁰ represents a hydrogen atom or a lower alkyl group)
This structural unit is typically obtained as a mixture of isomers in which the bonding position is either position 5 or position 6.

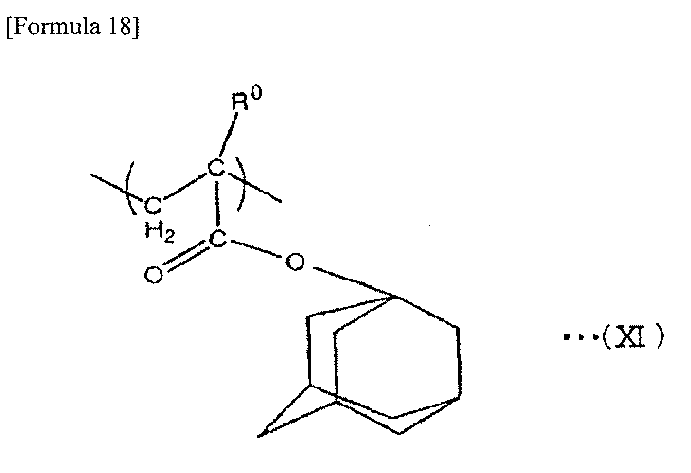

(wherein, R⁰ represents a hydrogen atom or a lower alkyl group)

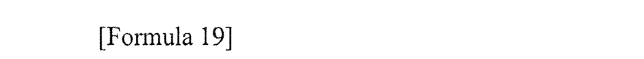

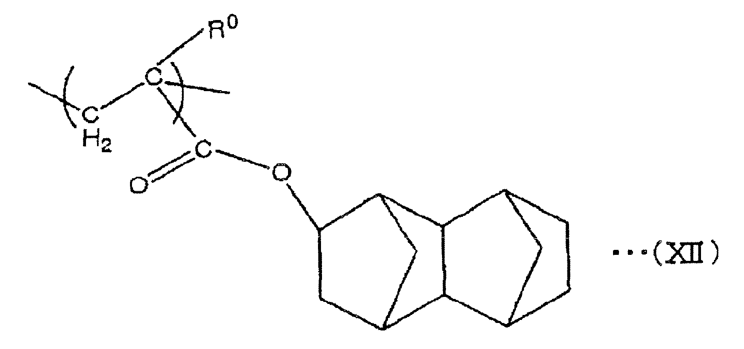

(wherein, R⁰ represents a hydrogen atom or a lower alkyl group)

R⁰ is as described above.
In those cases where a structural unit (a4') is included, the proportion of the structural unit (a4') within the component (A'), relative to the combined total of all the structural units, is typically within a range from 1 to 25 mol%, and is preferably from 5 to 20 mol%.

Furthermore, the component (A') preferably includes either a copolymer represented by the chemical formula (A'-1) shown below, or a copolymer represented by the chemical formula (A'-2) shown below, and is even more preferably a mixture of these copolymers.

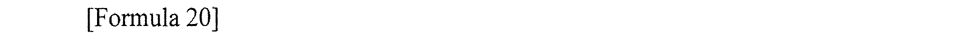

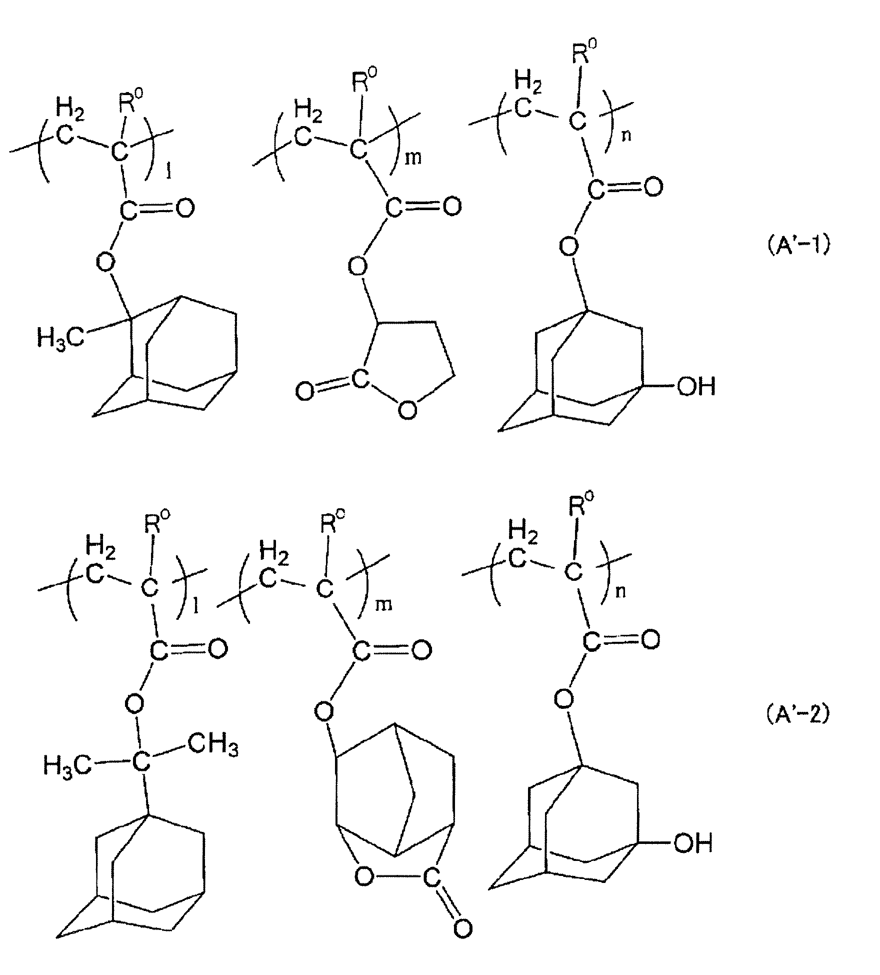

(wherein, R⁰ is as defined above)

The component (A') may include either a single resin, or a mixture of two or more different resins.
Furthermore, the component (A') can be obtained, for example, by a conventional radical polymerization or the like of the monomers corresponding with each of the structural units, using a radical polymerization initiator such as azobisisobutyronitrile (AIBN).

Although there are no particular restrictions on the weight average molecular weight (the polystyrene equivalent weight average molecular weight determined by gel permeation chromatography, this also applies below) of the component (A'), the value is typically no more than 30,000, and is preferably no more than 20,000, even more preferably 12,000 or lower, and is most preferably 10,000 or lower.
There are no particular restrictions on the lower limit of the weight average molecular weight, although from the viewpoints of inhibiting pattern collapse and achieving a favorable improvement in resolution and the like, the weight average molecular weight is preferably at least 4,000 or greater, and even more preferably 5,000 or greater.

Furthermore, preferred weight average molecular weight values for the component (A0') are the same as those described for the component (A').
The component (A0') may use either a single resin, or a mixture of two or more different resins. Furthermore, the component (A0') may use a resin besides the component (A').
The quantity of the component (A0') is preferably adjusted in accordance with the film thickness of the resist that is to be formed.

### Component (B)

As described for the negative resist composition.

### Component (D)

As described for the negative resist composition.

### Component (E)

As described for the negative resist composition.

### Organic Solvent

The positive resist composition can be produced by dissolving the materials in an organic solvent.
The organic solvent may be any solvent capable of dissolving the various components to generate a uniform solution, and one or more solvents selected from known materials used as the solvents for conventional chemically amplified resists can be used.
Specific examples of the solvent include ketones such as γ-butyrolactone, acetone, methyl ethyl ketone, cyclohexanone, methyl isoamyl ketone and 2-heptanone; polyhydric alcohols and derivatives thereof such as ethylene glycol, ethylene glycol monoacetate, diethylene glycol, diethylene glycol monoacetate, propylene glycol, propylene glycol monoacetate, dipropylene glycol, or the monomethyl ether, monoethyl ether, monopropyl ether, monobutyl ether or monophenyl ether of dipropylene glycol monoacetate; cyclic ethers such as dioxane; and esters such as methyl lactate, ethyl lactate (EL), methyl acetate, ethyl acetate, butyl acetate, methyl pyruvate, ethyl pyruvate, methyl methoxypropionate, and ethyl ethoxypropionate.

These organic solvents may be used either alone, or as a mixed solvent of two or more different solvents.
Furthermore, mixed solvents of propylene glycol monomethyl ether acetate (PGMEA) and a polar solvent are preferred. Although the blend ratio (weight ratio) in such mixed solvents can be set in accordance with factors such as the co-solubility of the PGMEA and the polar solvent, the ratio is preferably within a range from 1:9 to 9:1, and even more preferably from 2:8 to 8:2.
More specifically, in those cases where EL is added as the polar solvent, the weight ratio PGMEA:EL is preferably within a range from 2:8 to 8:2, and even more preferably from 3:7 to 7:3.
Furthermore, as the organic solvent, mixed solvents containing at least one of PGMEA and EL, together with γ-butyrolactone, are also preferred. In such cases, the weight ratio of the former and latter components in the mixed solvent is preferably within a range from 70:30 to 95:5.
There are no particular restrictions on the quantity used of the organic solvent, although the quantity should provide a concentration that enables favorable application of the solution to a substrate or the like, should be set in accordance with the required coating film thickness, and is typically set so that the solid fraction concentration within the resist composition falls within a range from 2 to 20% by weight, and even more preferably from 5 to 15% by weight.

### Other Optional Components

As described for the negative resist composition.

In a method for forming a resist pattern according to the present invention, by using a specific negative resist composition described above, a method for forming a resist pattern in which a dense pattern is formed in the lower layer and an isolated pattern is formed in the upper layer can be provided, wherein mixing can be suppressed, and a resist pattern of favorable shape can be obtained.

### EXAMPLES

### [Reference Example 1] (Preparation of Positive Resist Composition used in First Resist Layer)

100 parts by weight of a mixture (weight ratio 1: 1) of a resin 1 and a resin 2 represented by the chemical formulas shown below as a resin component, 3.0 parts by weight of triphenylsulfonium nonafluorobutanesulfonate as an acid generator, 0.15 parts by weight of triethanolamine as a nitrogen-containing organic compound, and 0.1 parts by weight of a surfactant (product name: R-08, manufactured by Dainippon Ink and Chemicals, Incorporated) as another component were dissolved in a mixed solvent as organic solvent (weight ratio 6:4) of propylene glycol monomethyl ether acetate and ethyl lactate, yielding a positive resist composition with a solid fraction concentration of 10% by weight.

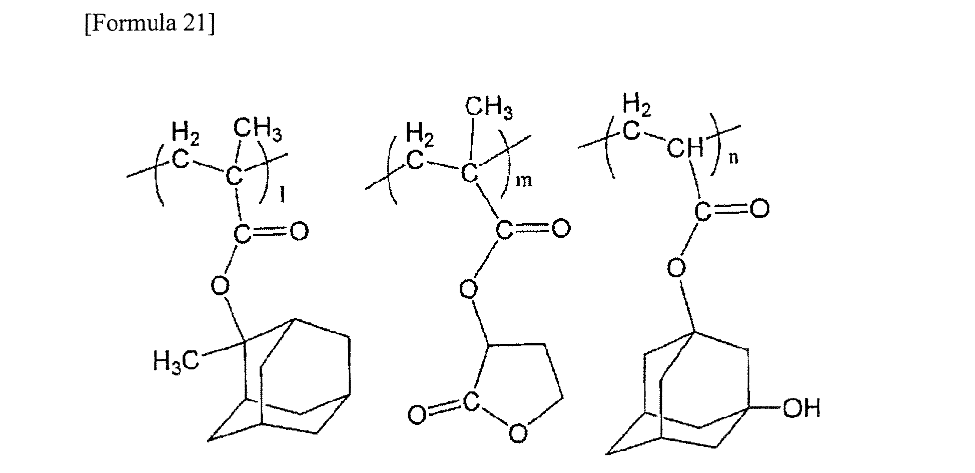

Resin 1 (weight average molecular weight: 10,000, dispersity (weight average molecular weight / number average molecular weight): 2.0, 1/m/n = 4/4/2 (molar ratio)) 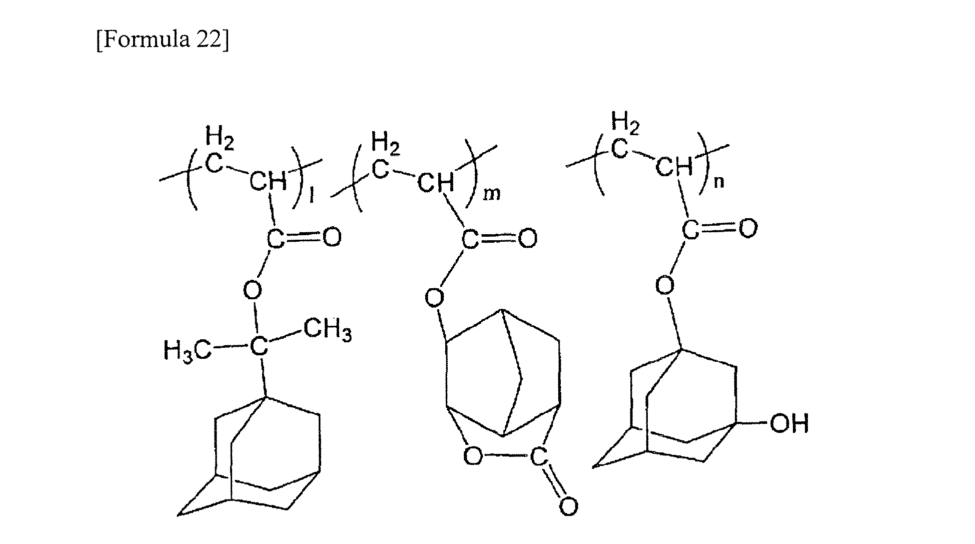 Resin 2 (weight average molecular weight: 10,000, dispersity (weight average molecular weight / number average molecular weight): 2.0,1/m/n = 3/5/2 (molar ratio))

### (Preparation of Negative Resist Composition used in Second Resist Layer)

100 parts by weight of a resin 3 represented by a chemical formula shown below as a resin component, 2.0 parts by weight of triphenylsulfonium trifluoromethanesulfonate as an acid generator, and 0.1 parts by weight of triethanolamine as a nitrogen-containing organic compound were dissolved in isobutanol as the organic solvent, yielding a negative resist composition with a solid fraction concentration of 6% by weight.

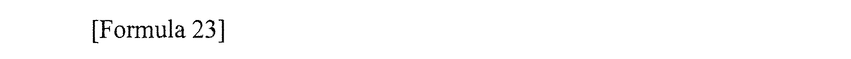

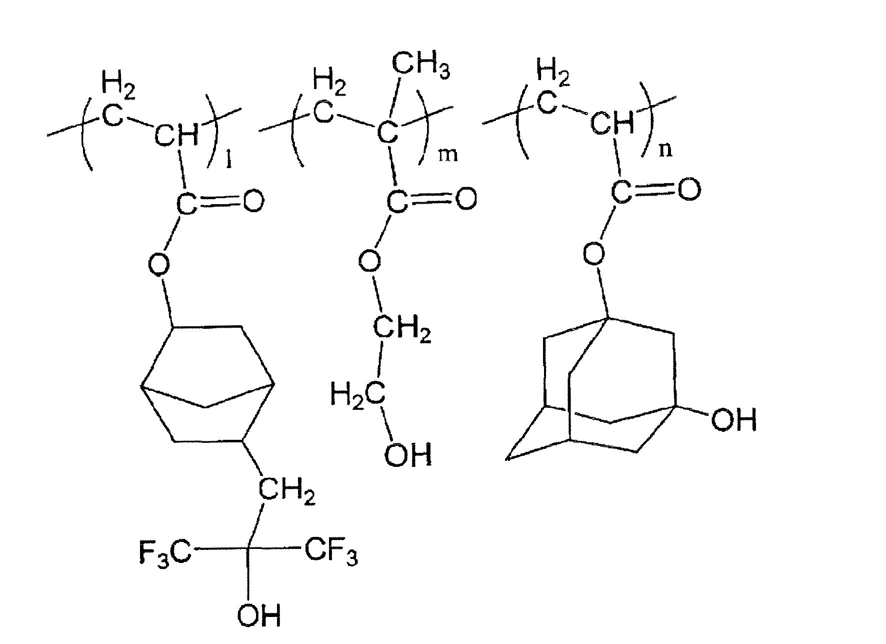

(weight average molecular weight: 5,400, dispersity (weight average molecular weight /number average molecular weight): 2.0, 1/m/n = 50/17/33 (molar ratio))

### [Example 1]

An organic anti-reflective film composition "ARC-29" (a product name, manufactured by Brewer Science Ltd.) was applied to the surface of an 8-inch silicon wafer using a spinner, and the composition was then baked and dried on a hotplate at 215°C for 60 seconds, thereby forming an organic anti-reflective film with a film thickness of 77 mn.
The positive resist composition prepared in the aforementioned reference example was then applied to the surface of this anti-reflective film using a spinner, and was then prebaked (PAB) and dried on a hotplate at 115°C for 60 seconds, thereby forming a resist layer with a film thickness of 300 nm.
Subsequently, this layer was selectively irradiated with an ArF excimer laser (193 nm) through a mask pattern, using an ArF exposure apparatus NSR-S302 (manufactured by Nikon Corporation; NA (numerical aperture) = 0.60, σ = 0.75).
The resist was then subjected to PEB treatment at 100°C for 60 seconds, subsequently subjected to puddle development for 60 seconds at 23°C in a 2.38% by weight aqueous solution of tetramethylammonium hydroxide, and was then washed for 20 seconds with water, and dried, thus forming a 140 nm 1:1 dense hole pattern.
Next, the negative resist composition prepared in the reference example was applied to the surface of the thus formed dense hole pattern using a spinner, and was then prebaked (PAB) and dried on a hotplate at 80°C for 60 seconds, thereby forming a resist layer with a film thickness of 200 nm. During this layer formation, no mixing occurred with the lower resist layer. Subsequently, this layer was selectively irradiated with an ArF excimer laser (193 nm) through a mask pattern, using an ArF exposure apparatus NSR-S302 (manufactured by Nikon Corporation; NA (numerical aperture) = 0.60, 2/3 annular illumination). The resist layer was then subjected to PEB treatment at 100°C for 60 seconds, subsequently subjected to puddle development for 60 seconds at 23°C in a 2.38% by weight aqueous solution of tetramethylammonium hydroxide, and was then washed for 20 seconds with water, and dried, thus forming an isolated-dense mixed pattern including both a 140 nm 1:1 dense contact hole pattern and a 140 nm isolated pattern.

In this manner, in an example according to the present invention, mixing was able to be prevented, and a practical resist pattern was able to be formed.

### [Third Aspect]

A third aspect is a method for forming a resist pattern that includes the following steps (xi) and (xii): (xi) a step of forming a first resist layer on a substrate using a first positive resist composition, and then conducting selective exposure, thereby forming a latent image of a dense pattern in the first resist layer, and (xii) a step of forming a second resist layer on top of the first resist layer using a second positive resist composition, conducting selective exposure, and then developing the first resist layer and the second resist layer simultaneously, thereby exposing a portion of the latent image of the dense pattern, wherein
as the second positive resist composition, a positive resist composition dissolved in an organic solvent that does not dissolve the first resist layer is used.

Here, a dense pattern refers to a pattern in which the spacing between adjacent patterns is narrow when a line pattern or hole pattern is formed. Specifically, in a cross-section of the pattern, the ratio of the spacing between adjacent patterns relative to the pattern width is preferably 1 or less, even more preferably 0.9 or less, and is most preferably 0.8 or less. For practical reasons, the lower limit for this ratio is typically 0.5 or greater. In a hole pattern, the pattern width refers to the width of the removed portions of the resist layer, for example, the hole diameter of a hole pattern. The pattern width in a line pattern refers to the line width.
An isolated pattern describes a pattern in which the spacing between adjacent patterns is greater than that within a dense pattern. Specifically, in a cross-section of the pattern, the ratio of the spacing between adjacent patterns relative to the pattern width is preferably 2 or greater, even more preferably 3 or greater, and is most preferably 5 or greater. For practical reasons, the upper limit for this ratio is typically no greater than 10.
The pattern width and spacing values refer to values near the interface between the substrate and the resist layer.

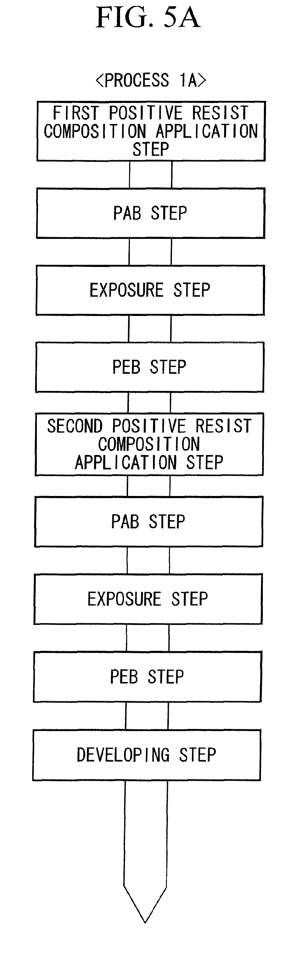

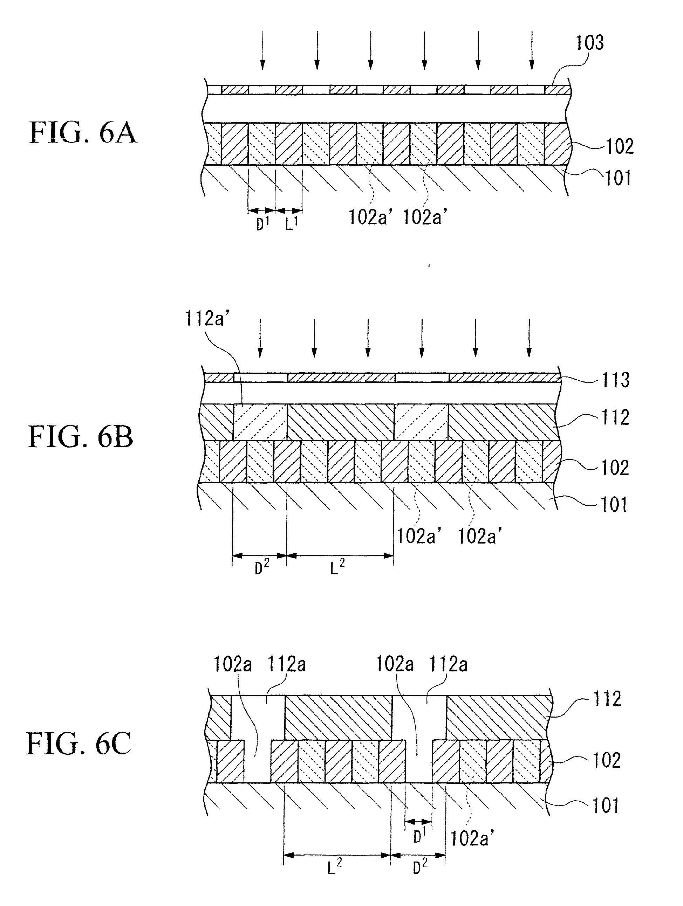

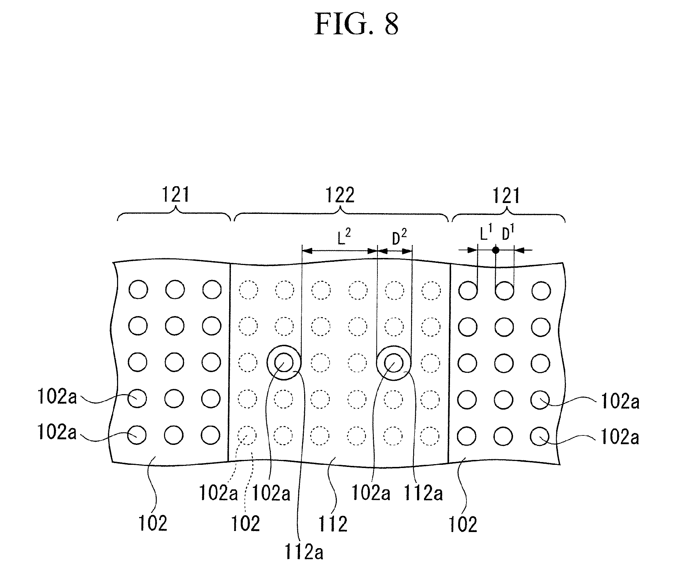

FIG. 5A is a diagram showing the flow of a sample sequence (hereafter referred to as a process 1A) according to the third aspect. FIG. 6A through FIG. 6C are explanatory diagrams (cross-sectional views) of the process 1A. FIG. 8 is a plan view showing a state following formation of a dense pattern and an isolated pattern using the process.

In the process 1A, the following steps are conducted in sequence.

### (xi-1) First Positive Resist Composition Application Step

Using a coating apparatus, a chemically amplified positive resist composition (the first positive resist composition) containing an acid generator component (hereafter also referred to as an acid generator) that generates acid on exposure is applied to the surface of a substrate 101 (see FIG. 6A).

### (xi-2) PAB (Prebake) Step

The applied resist film is heat treated, thereby forming a first resist layer 102 (see FIG. 6A).
The heating conditions typically involve heating at 80 to 150°C for a period of approximately 40 to 120 seconds (and preferably for 60 to 90 seconds).
The thickness of the first resist layer 102 is typically within a range from approximately 0.05 to 1.0 µm, and is preferably from 0.1 to 0.5 µm.

### (xi-3) Exposure Step

By selectively exposing the first resist layer 102, a latent image (exposed portions) 102a' of a dense pattern is formed on the first resist layer (see FIG. 6A). The term "latent image" refers to the region subjected to exposure.
In other words, the first resist layer 102 is selectively exposed using a dense pattern mask (reticle) 103.
FIG. 6A represents an example in which exposure is conducted to form a dense hole pattern in which the pattern width D¹ and the spacing L¹ are formed in an approximately 1:1 size relationship.
In other words, as shown in FIG. 8, selective exposure is conducted so as to form a dense pattern in the first resist layer 102 in which a plurality of holes 102a of pattern width D¹ are arranged in a dense pattern with a spacing of L¹.
There are no particular restrictions on the wavelength used for the exposure, and an ArF excimer laser, KrF excimer laser, F₂ excimer laser, or other radiation such as EUV (extreme ultraviolet), VUV (vacuum ultraviolet), EB (electron beam), X-ray or soft X-ray radiation can be used, although an ArF excimer laser is particularly ideal (this also applies in the exposure steps described below).

### (xi-4) PEB (Post Exposure Baking) Step

The selectively exposed first resist layer 102 is subjected to a heat treatment, thereby suitably dispersing the acid component generated from the acid generator within the first resist layer 102, and causing dissociation of the acid-dissociable, dissolution-inhibiting groups contained within the base component of the positive resist composition. Depending on the nature of the acid-dissociable, dissolution-inhibiting groups, dissociation of these acid-dissociable, dissolution-inhibiting groups may occur solely by exposure. Accordingly, the PEB step is not necessarily required.
The heating conditions typically involve heating at 80 to 150°C for a period of 40 to 120 seconds (and preferably 60 to 90 seconds).

### (xii-1) Second Positive Resist Composition Application Step

Using a coating apparatus, a chemically amplified positive resist composition (the second positive resist composition) containing an acid generator is applied to the surface of the first resist layer 102 (see FIG. 6B).
The terms "first positive resist composition" and "second positive resist composition" are used for the sake of convenience to facilitate differentiation between the positive resist composition that forms the first resist layer 102 and the positive resist composition that forms the second resist layer 112.

### (xii-2) PAB (Prebake) Step

The applied resist film is heat treated, thereby forming a second resist layer 112 (see FIG. 6B).
The heating conditions typically involve heating at 80 to 150°C for a period of approximately 40 to 120 seconds (and preferably for 60 to 90 seconds).
The thickness of the second resist layer 112 is typically within a range from approximately 0.05 to 1.0 µm, and is preferably from 0.1 to 0.5 µm.

### (xii-3) Exposure Step

The second resist layer 112 is then exposed.
In other words, the second resist layer 112 is selectively exposed using a desired mask (reticle) 113, thereby forming a latent image (exposed portions) 112a' (see FIG. 6B).
FIG. 6B represents an example in which exposure is conducted to form an isolated hole pattern in which the pattern width D² and the spacing L² are formed in an approximately 1:2 size relationship.
In other words, as shown in FIG. 8, the regions 121 positioned at the left and right edges of the diagram are completely exposed, whereas in the region 122 sandwiched between the regions 121, selective exposure is conducted using the mask 113 so as to form a pattern in the second resist layer 112 in which holes 112a of pattern width D² are arranged with a spacing of L².
As shown in FIG. 6B, FIG. 6C, and FIG. 8, the diameter (pattern width) D² of the holes 112a within the isolated pattern are designed to be larger than the diameter (pattern width) D¹ of the holes 102a (the latent image 102a') formed in the first resist layer 102. Furthermore, the holes 112a (latent image 112a') are formed over an area that includes a hole 102a (latent image portion 102a') formed directly therebeneath.

### (xii-4) PEB (Post Exposure Baking) Step

The selectively exposed second resist layer 112 is subjected to a heat treatment, thereby suitably dispersing the acid component generated from the acid generator within the second resist layer 112 (see FIG. 6B). This causes dissociation of the acid-dissociable, dissolution-inhibiting groups contained within the base component of the positive resist composition. Depending on the nature of the acid-dissociable, dissolution-inhibiting groups, dissociation of these acid-dissociable, dissolution-inhibiting groups may occur solely by exposure. Accordingly, the PEB step is not necessarily required.
The heating conditions typically involve heating at 80 to 150°C for a period of 40 to 120 seconds (and preferably 60 to 90 seconds).

### (xii-5) First Resist Layer and Second Resist Layer Developing Step

The laminate of the first resist layer 102 and the second resist layer 112 is subjected to a developing treatment. The developing treatment uses, for example, an aqueous solution of TMAH (an aqueous solution of tetramethylammonium hydroxide) with a concentration of 0.1 to 10% by weight (and preferably 2.38% by weight). Upon conducting this developing treatment, within the region 122 shown in FIG. 8, the exposed portions of the second resist layer 112 (the latent image 112a') are first removed, forming the isolated pattern holes 112a, as shown in FIG. 6C. Subsequently, the developing solution that enters these holes 112a contacts the first resist layer 102 that constitutes the bottom surface within the holes 112a, thereby developing and removing the underlying exposed portions (latent image portions 102a') of the first resist layer 102, and exposing the substrate. In other words, the latent image 102a' of the first resist layer 102 undergoes patterning. As a result, holes 102a are formed directly beneath the holes 112a. As a result, an isolated hole pattern is formed in which the holes 102a and the holes 112a are interconnected.
On the other hand, in the regions 121, because light is irradiated onto the entire region during the selective exposure, the entire second resist layer 112 within the regions 121 is developed and removed by the developing solution. The underlying exposed portions (latent image portions 102a') of the dense pattern formed in the first resist layer 102 are then developed, thus forming the holes 102a.

In other words, in the region 122, the holes 102a are formed in a dense pattern that enables broad DOF characteristics to be ensured, meaning the holes can be formed precisely at the desired size. The isolated holes 112a are formed over a portion of the holes 102a of the dense pattern formed in the first resist layer 102.
In other words, in this method, a portion of the dense pattern with a broad DOF formed in the lower first resist layer 102 is exposed and patterned by the developing treatment, and can then be used as an isolated pattern.
If an isolated pattern is formed from the outset in the lower first resist layer 102, then broad DOF characteristics cannot be achieved, but by employing the steps described above, an isolated pattern with broad DOF characteristics can be obtained.
The DOF characteristics of the second resist layer 112 of the upper layer need not be as favorable as those for the pattern formed in the lower layer (the first resist layer 102). This is because within the isolated hole pattern containing the interconnected holes 102a and 112a, the holes 102a within the lower layer 102 represent the more important portions. The reason for this importance is that when etching of the substrate is conducted, it is the pattern within the lower layer 102 that is transferred (namely, the pattern transferred to the substrate is dependent on the pattern of the lower layer 102).

In this manner, a so-called isolated-dense mixed pattern can be obtained, in which a dense pattern region 121 and an isolated pattern region 122 with the same DOF characteristics can be formed on a single substrate.

According to this method of the present invention, a specific positive resist composition is used as the second positive resist composition. The materials for this resist composition are the same as those used for the fourth aspect, and are consequently described following the description of the steps of the fourth aspect.

### [Fourth Aspect]

The fourth aspect is a method for forming a resist pattern that includes the following steps (xi') and (xii'): (xi') a step of forming a first resist layer on a substrate using a first positive resist composition, conducting selective exposure, and then performing developing to form a dense pattern in the first resist layer, and (xii') a step of forming a second resist layer on top of the dense pattern of the first resist layer using a second positive resist composition, conducting selective exposure, and then performing developing, thereby filling in a portion of the dense pattern, wherein
as the second positive resist composition, a positive resist composition dissolved in an organic solvent that does not dissolve the first resist layer is used.

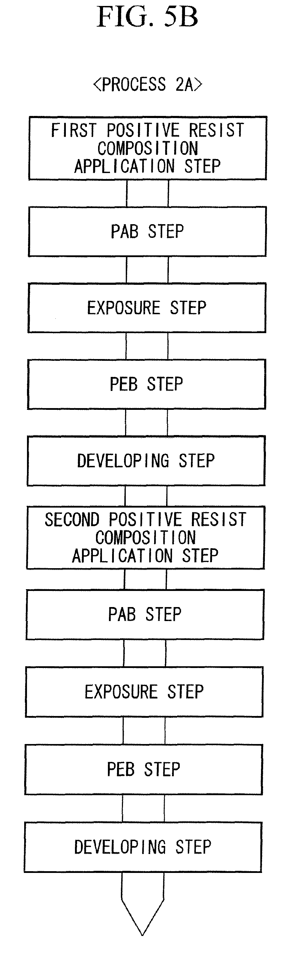

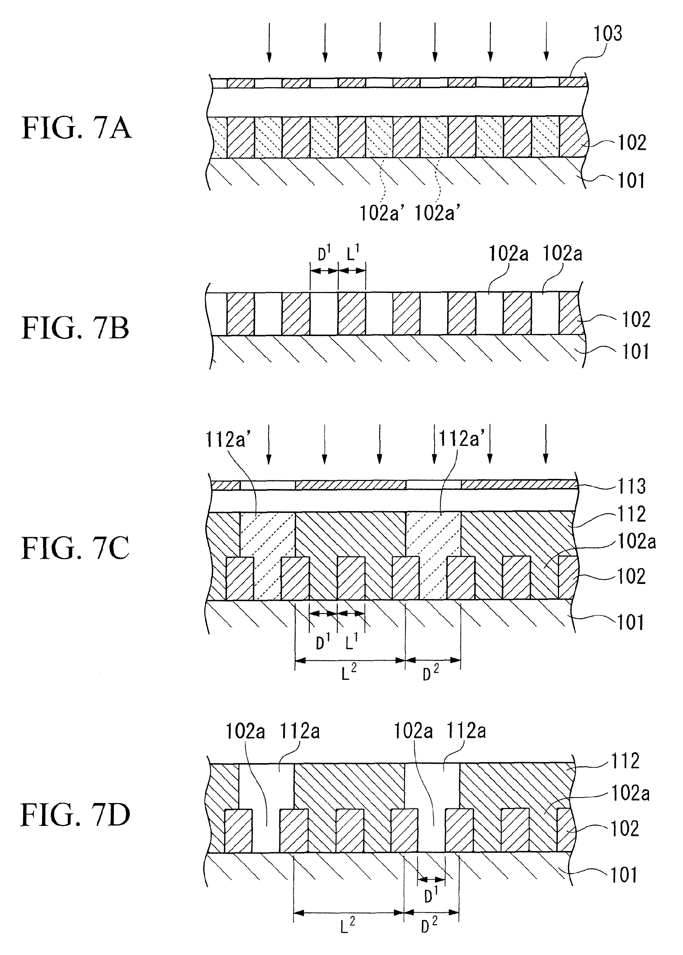

FIG. 5B is a diagram showing the flow of a sample sequence (hereafter referred to as a process 102 according to the fourth aspect. FIG. 7A through FIG. 7D are explanatory diagrams (cross-sectional views) of the process 102. FIG. 8 is a plan view showing a state following formation of a dense pattern and an isolated pattern using the process.

In the process 102, the following steps are conducted in sequence.

### (xi'-1) First Positive Resist Composition Application Step

The same as (xi-1) of the third aspect (see FIG. 7A).

### (xi'-2) PAB (Prebake) Step

The same as (xi-2) of the third aspect (see FIG. 7A).

### (xi'-3) Exposure Step

The same as (xi-3) of the third aspect (see FIG. 7A).

### (xi'-4) PEB (Post Exposure Baking) Step

The same as (xi-4) of the third aspect (see FIG. 7A).

### (xi'-5) First Resist Layer Developing Step

The first resist layer 102 is then subjected to a developing treatment. The developing treatment uses, for example, an aqueous solution of TMAH (an aqueous solution of tetramethylammonium hydroxide) with a concentration of 0.1 to 10% by weight (and preferably 2.38% by weight).
Upon conducting this developing treatment, the exposed portions are removed, as shown in FIG. 7B, and a dense pattern containing a plurality of holes 102a in which the pattern width D¹ and the spacing L¹ are formed in an approximately 1:1 size relationship is obtained in the first resist layer 102.
In other words, as shown in FIG. 8, a dense pattern in which holes 102a with a pattern width D¹ are positioned at a spacing of L¹ is formed across the entire surface of the first resist layer 102.

### (xii'-1) Second Positive Resist Composition Application Step

Using a coating apparatus, a chemically amplified second positive resist composition containing an acid generator is applied to the surface of the first resist layer 102 that has a dense pattern formed therein, as shown in FIG. 7C.
The terms "first positive resist composition" and "second positive resist composition" are used for the sake of convenience to facilitate differentiation between the positive resist composition that forms the first resist layer 102 and the positive resist composition that forms the second resist layer 112. The second positive resist composition fills the holes 102a, thereby burying the holes 102a, and a resist film is formed on top, so that the first resist layer 102 in which the dense pattern has been formed is covered with the resist film.

### (xii'-2) PAB (Prebake) Step

The applied resist film is heat treated, thereby forming a second resist layer 112 (see FIG. 7C).
The heating conditions typically involve heating at 80 to 150°C for a period of approximately 40 to 120 seconds (and preferably for 60 to 90 seconds).
The thickness of the second resist layer 112 (the distance from the surface of the first resist layer 102 to the surface of the second resist layer 112) is typically within a range from approximately 0.05 to 1.0 µm, and is preferably from 0.1 to 0.5 µm.

### (xii'-3) Exposure Step

The second resist layer 112 is then selectively exposed.
In other words, the second resist layer 112 is selectively exposed using a desired mask (reticle) 113.
FIG. 7C represents an example in which exposure is conducted to form an isolated hole pattern in which the pattern width D² and the spacing L² are formed in an approximately 1:2 size relationship.
In other words, in this example, the same mask as that used in the third aspect is used to expose the same regions, and as shown in FIG. 8, the regions 121 are totally exposed, whereas in the region 122, the second resist layer 112 is selectively exposed so as to form a pattern in which holes 112a of pattern width D² are arranged with a spacing of L², thereby forming a latent image (the exposed portions) 112a'.
As shown in FIG. 7D and FIG. 8, the diameter (pattern width) D² of the holes 112a within the isolated pattern are designed to be larger than the diameter (pattern width) D¹ of the holes 102a formed in the first resist layer 102. Furthermore, the holes 112a are formed over an area that includes a hole 102a formed directly therebeneath.

### (xii'-4) PEB (Post Exposure Baking) Step

The selectively exposed second resist layer 112 is then subjected to a heat treatment, thereby suitably dispersing the acid component generated from the acid generator within the second resist layer 112, and causing dissociation of the acid-dissociable, dissolution-inhibiting groups contained within the base component of the positive resist composition (see FIG. 7C).
Depending on the nature of the acid-dissociable, dissolution-inhibiting groups, dissociation of these acid-dissociable, dissolution-inhibiting groups may occur solely by exposure. Accordingly, the PEB step is not necessarily required.
The heating conditions typically involve heating at 80 to 150°C for a period of 40 to 120 seconds (and preferably 60 to 90 seconds).

### (xii'-5) Second Resist Layer Developing Step

Upon conducting developing of the laminate of the first resist layer 102 and the second resist layer 112, within the region 122 shown in FIG. 8, the exposed portions (latent image portions 112a') of the second resist layer 112 are removed, forming the isolated pattern holes 112a, as shown in FIG. 7D.
As a result, within the region 122, an isolated hole pattern is formed in which the holes 112a and the holes 102a directly therebeneath are interconnected. Furthermore, in the regions 121, because light is irradiated onto the entire region during the selective exposure, the entire second resist layer 112 within the regions 121 is developed and removed by the developing solution, and the second positive resist composition that had filled the dense pattern of the underlying first resist layer is removed at the same time, thereby forming the holes 102a.

In other words, in this method, a dense pattern with a broad DOF formed in the first resist layer 102 is filled and covered with the second resist layer 112, and the second resist layer is then selectively exposed and developed to remove a portion of the second resist layer 112 and expose a portion of the underlying dense pattern formed in the first resist layer 102, thereby enabling the dense pattern to be used as an isolated pattern. Within the dense pattern, those portions corresponding with the areas in which the second resist layer 112 is not removed remain buried beneath the second resist layer 112.
If an isolated pattern is formed from the outset in the lower first resist layer 102, then broad DOF characteristics cannot be achieved, but by employing the steps described above, an isolated pattern with a broad DOF can be obtained.

The DOF characteristics of the second resist layer 112 of the upper layer need not be as favorable as those for the pattern formed in the first resist layer (the lower layer) 102. This is because within the isolated hole pattern containing the interconnected holes 102a and 112a, the holes 102a within the lower layer 102 represent the more important portions. The reason for this importance is that when etching of the substrate is conducted, it is the pattern within the lower layer 102 that is transferred (namely, the pattern transferred to the substrate is dependent on the pattern of the lower layer).
In this manner, a so-called isolated-dense mixed pattern can be obtained, in which a dense pattern region 121 and an isolated pattern region 122 can be formed on a single substrate, as shown in FIG. 8.

The process 102 offers the advantage that the occurrence of post-developing scum is less likely.
Furthermore, another advantage is that because the first resist layer is subjected to developing treatment prior to formation of the second resist layer, the second resist layer is unaffected by the acid generator within the first resist layer, enabling a more precise pattern to be formed.

According to this method of the present invention, a specific positive resist composition is used as the second positive resist composition that is used for forming the second resist layer 112. The materials for this resist composition are the same as those used for the third aspect, and are described below.

### [Second Positive Resist Composition]

The positive resist composition preferably includes a resin component (A'), which contains structural units derived from acrylate esters, and exhibits increased alkali solubility under the action of acid, and an acid generator component (B) that generates acid on exposure, dissolved in an organic solvent.
Furthermore, in the second positive resist composition used in the present invention, these components are dissolved within a specific organic solvent.

### Organic Solvent

In the second positive resist composition, an organic solvent that does not dissolve the first resist layer is used. As a result, mixing of the resist layers can be suppressed.
As this type of organic solvent, any solvent that lacks compatibility with the first resist layer can be used.
The expression "does not dissolve the first resist layer" preferably means that at 23°C, when a first resist layer with a film thickness 0.2 µm is formed and this resist layer is then immersed in the organic solvent, no change is observed in the film thickness even after 60 minutes.

Examples of this type of solvent include alcohol-based solvents and fluorine-based solvents. These solvents may be used either alone, or in mixtures of two or more different solvents.
Of these solvents, alcohol-based solvents are preferred in terms of the coating properties obtained, and the dissolution of materials such as the resin component. Accordingly, the organic solvent preferably includes an alcohol-based solvent.
Monohydric alcohols are particularly preferred, and of such alcohols, although dependent on the number of carbon atoms, primary or secondary monohydric alcohols are preferred, and primary monohydric alcohols are the most desirable.
The boiling point is preferably within a range from 80 to 160°C, and even more preferably from 90 to 150°C, and from the viewpoints of the resulting coating properties, the stability of the composition upon storage, and the heating temperature required in the PAB step and/or PEB step, boiling points within a range from 100 to 135°C are the most desirable.
In this description, the term "monohydric alcohol" refers to compounds in which the number of hydroxyl groups incorporated within the alcohol molecule is 1, and does not include dihydric alcohols, trihydric alcohols, or derivatives thereof.

Specific examples of the alcohol-based solvent include n-amyl alcohol (boiling point: 138.0°C), s-amyl alcohol (boiling point: 119.3°C), t-amyl alcohol (boiling point: 101.8°C), isoamyl alcohol (boiling point: 130.8°C), isobutanol (also called isobutyl alcohol or 2-methyl-1-propanol) (boiling point: 107.9°C), isopropyl alcohol (boiling point: 82.3°C), 2-ethylbutanol (boiling point: 147°C), neopentyl alcohol (boiling point: 114°C), n-butanol (boiling point: 117.7°C), s-butanol (boiling point: 99.5°C), t-butanol (boiling point: 82.5°C), 1-propanol (boiling point: 97.2°C), n-hexanol (boiling point: 157.1 °C), 2-heptanol (boiling point: 160.4°C), 3-heptanol (boiling point: 156.2°C), 2-methyl-1-butanol (boiling point: 128.0°C), 2-methyl-2-butanol (boiling point: 112.0°C), and 4-methyl-2-pentanol (boiling point: 131.8°C). Of these, isobutanol (2-methyl-1-propanol), 4-methyl-2-pentanol, and n-butanol are preferred. Of these, isobutanol and n-butanol are particularly desirable.

An example of a suitable fluorine-based solvent is perfluoro-2-butyltetrahydrofuran.
These organic solvents may be used either alone, or in mixtures of two or more different solvents.

The organic solvent may also include other organic solvents besides the alcohol-based solvent and/or fluorine-based solvent, provided the solvent does not dissolve the first resist layer, although the alcohol-based solvent and/or fluorine-based solvent preferably accounts for at least 80% by weight, and preferably 100% by weight of the solvent.
Examples of possible other solvents include either one, or two or more solvents selected from known materials used as the solvents for conventional chemically amplified resists.
Suitable examples include lactones such as γ-butyrolactone; ketones such as acetone, methyl ethyl ketone, cyclohexanone, methyl isoamyl ketone and 2-heptanone; polyhydric alcohols and derivatives thereof such as ethylene glycol, ethylene glycol monoacetate, diethylene glycol, diethylene glycol monoacetate, propylene glycol, propylene glycol monoacetate, dipropylene glycol, or the monomethyl ether, monoethyl ether, monopropyl ether, monobutyl ether or monophenyl ether of dipropylene glycol monoacetate; cyclic ethers such as dioxane; and esters such as methyl lactate, ethyl lactate (EL), methyl acetate, ethyl acetate, butyl acetate, methyl pyruvate, ethyl pyruvate, methyl methoxypropionate, and ethyl ethoxypropionate.

There are no particular restrictions on the quantity used of the organic solvent, which is set in accordance with the desired film thickness so as to produce a concentration that enables favorable application to a substrate or the like, and is typically sufficient to produce a solid fraction concentration within the resist composition of 2 to 20% by weight, and preferably from 5 to 15% by weight.

There are no particular restrictions on the resin component (A'), the acid generator component (B) that generates acid on exposure, and any other optional components that may be added, and the types of materials proposed for use within conventional positive resist compositions may be used.
Considering the effects relating to the second positive resist composition making contact with the first resist layer 102, the second positive resist composition preferably exhibits a high level of sensitivity.
Preferred compositions are described below.

In the following description of the positive resist composition, the meanings of the terms used are as listed below. A "structural unit" refers to a monomer unit that contributes to the formation of a polymer (resin).
A "structural unit derived from acrylic acid" refers to a structural unit formed by cleavage of the ethylenic double bond of acrylic acid.
A "structural unit derived from an acrylate ester" refers to a structural unit formed by cleavage of the ethylenic double bond of an acrylate ester.
The term "structural unit derived from an acrylate ester" is a general concept that is deemed to also include those units in which the hydrogen atom at the α-position is substituted with another substituent group such as a halogen atom, an alkyl group, or a halogenated alkyl group.
In a "structural unit derived from acrylic acid" or a "structural unit derived from an acrylate ester", unless stated otherwise, the term "α-position" or "α-position carbon atom" refers to the carbon atom to which the carboxyl group is bonded.
Furthermore, the term "structural unit derived from acrylic acid" is a general concept that is deemed to include structural units in which the hydrogen atom bonded to the α-position carbon atom is substituted with another substituent group such as a halogen atom, an alkyl group, or a halogenated alkyl group, as well as structural units derived from an acrylate ester in which a hydrogen atom is bonded to the α-position carbon atom.
Furthermore, unless stated otherwise, an "alkyl group" refers to a straight-chain, cyclic, or branched-chain alkyl group.

### Resin Component (A')

The component (A') of the second positive resist composition is preferably a resin component (A') that contains structural units derived from acrylate esters and exhibits increased alkali solubility under the action of acid.
Furthermore, the resin component (A') preferably includes a structural unit (a1') derived from an acrylate ester containing an acid-dissociable, dissolution-inhibiting group, and a structural unit (a2') containing an alicyclic group having a fluorinated hydroxyalkyl group.
In the second positive resist composition, by using a resin component that includes the structural unit (a2') containing an alicyclic group having a fluorinated hydroxyalkyl group, favorable solubility of the composition in alcohol-based organic solvents can be achieved.

### - Structural Unit (a1') derived from an acrylate ester containing an acid-dissociable, dissolution-inhibiting group

In the structural unit (a1'), a hydrogen atom, a halogen atom, a halogenated lower alkyl group, or a lower alkyl group is bonded to the α-carbon atom.
The lower alkyl group is preferably a straight-chain or branched alkyl group of 1 to 5 carbon atoms, and specific examples include a methyl group, ethyl group, propyl group, isopropyl group, n-butyl group, isobutyl group, tert-butyl group, pentyl group, isopentyl group, and neopentyl group. Of these, a methyl group is preferred industrially.
The halogenated lower alkyl group is preferably a straight-chain or branched halogenated alkyl group of 1 to 5 carbon atoms, is even more preferably a straight-chain or branched fluorinated lower alkyl group of 1 to 5 carbon atoms, and is most preferably a trifluoromethyl group.
Suitable halogen atoms include a fluorine atom, chlorine atom, bromine atom, or iodine atom, although a fluorine atom is preferred.
Of the above possibilities, a hydrogen atom or a methyl group is preferred.

The acid dissociable, dissolution inhibiting group of the structural unit (a1') is a group that exhibits an alkali dissolution inhibiting effect that renders the entire component (A') alkali-insoluble prior to exposure, but then dissociates under the action of acid generated from the acid generator (B) following exposure, causing the entire component (A') to change to an alkali-soluble state.
The acid dissociable, dissolution inhibiting group can be selected appropriately from the multitude of such groups proposed for use within resins for resist compositions used with an ArF excimer laser. Typically, groups that form either a cyclic or chain-like tertiary alkyl ester, or a cyclic or chain-like alkoxyalkyl ester with the carboxyl group of acrylic acid are the most widely known.

A cyclic or chain-like alkoxyalkyl ester refers to a structure in which the hydrogen atom of a carboxyl group has been substituted with an alkoxyalkyl group to form an ester, so that the alkoxyalkyl group is bonded to the terminal oxygen atom of the carbonyloxy group (-C(O)-O-), and when an acid acts on this alkoxyalkyl ester, the bond between the oxygen atom and the alkoxyalkyl group is broken. Examples of these types of cyclic or chain-like alkoxyalkyl groups include a 1-methoxymethyl group, 1-ethoxyethyl group, 1-isopropoxyethyl group, 1-cyclohexyloxyethyl group, 2-adamantoxymethyl group, 1-methyladamantoxymethyl group, and 4-oxo-2-adamantoxymethyl group.
Examples of acid dissociable, dissolution inhibiting groups that form a chain-like tertiary alkyl ester include a t-butyl group or tert-amyl group.
As the structural unit (a1'), structural units that include an acid dissociable, dissolution inhibiting group that contains a cyclic group, and particularly an alicyclic group, are preferred. The alicyclic group may be either a monocyclic or a polycyclic group, and can be selected appropriately from the multitude of such groups proposed for use within ArF resists, although from the viewpoint of etching resistance, a polycyclic alicyclic group is preferred. Furthermore, the alicyclic group is preferably a hydrocarbon group, and is preferably saturated.
Examples of suitable monocyclic alicyclic groups include groups in which one hydrogen atom has been removed from a cycloalkane. Examples of suitable polycyclic alicyclic groups include groups in which one hydrogen atom has been removed from a bicycloalkane, tricycloalkane or tetracycloalkane or the like.
Specifically, examples of suitable monocyclic groups include a cyclopentyl group or cyclohexyl group. Examples of suitable polycyclic groups include groups in which one hydrogen atom has been removed from a polycycloalkane such as adamantane, norbornane, isobornane, tricyclodecane or tetracyclododecane.
Of these groups, an adamantyl group in which one hydrogen atom has been removed from adamantane, a norbornyl group in which one hydrogen atom has been removed from norbornane, a tricyclodecanyl group in which one hydrogen atom has been removed from tricyclodecane, and a tetracyclododecanyl group in which one hydrogen atom has been removed from tetracyclododecane are preferred industrially.

More specifically, the structural unit (a1') is preferably at least one unit selected from the general formulas (21') to (2III') shown below.

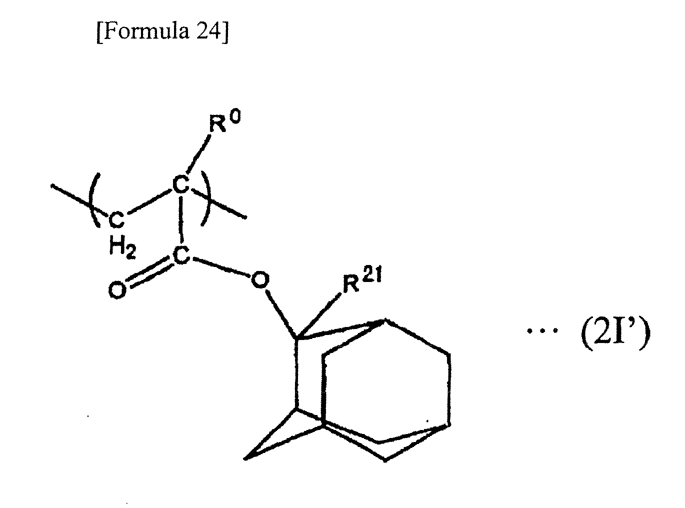

[wherein, R⁰ represents a hydrogen atom, a halogen atom, a halogenated lower alkyl group, or a lower alkyl group, and R²¹ represents a lower alkyl group]

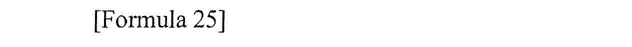

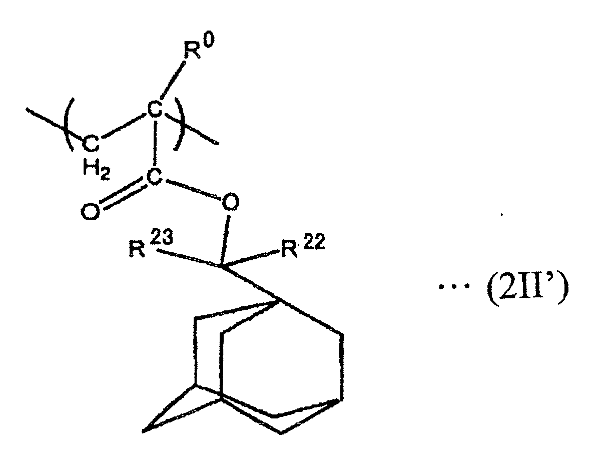

[wherein, R⁰ represents a hydrogen atom, a halogen atom, a halogenated lower alkyl group, or a lower alkyl group, and R²² and R²³ each represent, independently, a lower alkyl group]

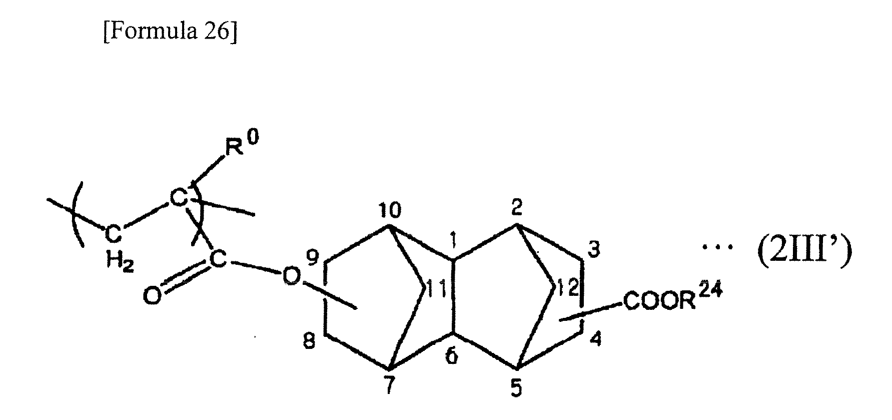

[wherein, R²⁴ represents a tertiary alkyl group]

The group R⁰ is a hydrogen atom, a halogen atom, a halogenated lower alkyl group, or a lower alkyl group. The lower alkyl group is preferably a straight-chain or branched alkyl group of 1 to 5 carbon atoms, and specific examples include a methyl group, ethyl group, propyl group, isopropyl group, n-butyl group, isobutyl group, tert-butyl group, pentyl group, isopentyl group, or neopentyl group. Of these, a methyl group is preferred industrially.
The halogenated lower alkyl group refers to a group in which a portion of, or all of, the hydrogen atoms within an aforementioned lower alkyl group have been substituted with halogen atoms. In such a halogenated lower alkyl group, examples of the halogen atoms used to substitute the hydrogen atoms include a fluorine atom, chlorine atom, bromine atom, or iodine atom, although a fluorine atom is preferred.
Suitable halogen atoms include a fluorine atom, chlorine atom, bromine atom, or iodine atom, although a fluorine atom is particularly preferred.
Of the above possibilities, R⁰ is preferably a hydrogen atom or a methyl group.
The group R²¹ is preferably a straight-chain or branched lower alkyl group of 1 to 5 carbon atoms, and specific examples include a methyl group, ethyl group, propyl group, isopropyl group, n-butyl group, isobutyl group, pentyl group, isopentyl group, or neopentyl group. Of these, a methyl group or ethyl group is preferred from the viewpoint of industrial availability.

The groups R²² and R²³ each preferably represent, independently, a straight-chain or branched lower alkyl group of 1 to 5 carbon atoms. Of these groups, those cases in which R²² and R²³ are both methyl groups are preferred industrially, and a structural unit derived from 2-(1-adamantyl)-2-propyl acrylate is a specific example.

Furthermore, the aforementioned group R²⁴ is preferably a chain-like tertiary alkyl group or a cyclic tertiary alkyl group. Examples of chain-like tertiary alkyl groups include a tert-butyl group or tert-amyl group, although those cases in which R²⁴ is a tert-butyl group are preferred industrially. A tertiary alkyl group refers to an alkyl group that includes a tertiary carbon atom.
Examples of cyclic tertiary alkyl groups include the same groups as those exemplified above in relation to the "acid dissociable, dissolution inhibiting group that contains an alicyclic group", and specific examples include a 2-methyl-2-adamantyl group, 2-ethyl-2-adamantyl group, 2-(1-adamantyl)-2-propyl group, 1-ethylcyclohexyl group, 1-ethylcyclopentyl group, 1-methylcyclohexyl group or 1-methylcyclopentyl group.
Furthermore, the group -COOR²⁴ may be bonded to either position 3 or 4 of the tetracyclododecanyl group shown in the formula, although the bonding position cannot be further specified. Furthermore, the carboxyl group residue of the acrylate structural unit may be bonded to either position 8 or 9 within the formula, although similarly, the bonding position cannot be further specified.

The structural unit (a1') may use either a single structural unit, or a combination of two or more different structural units.
The proportion of the structural unit (a1'), relative to the combined total of all the structural units within the component (A'), is typically within a range from 20 to 60 mol%, and is preferably from 30 to 50 mol%, and most preferably from 35 to 45 mol%.
By ensuring that this proportion is at least as large as the lower limit of the above range, a favorable pattern can be obtained, whereas ensuring that the proportion is no greater than the upper limit enables a favorable balance to be achieved with the other structural units.

### - Structural Unit (a2') containing an alicyclic group having a fluorinated hydroxyalkyl group.

By including the structural unit (a2'), the solubility of the composition in alcohol-based solvents can be improved.

### -- Alicyclic group having a fluorinated hydroxyalkyl group

In the structural unit (a2'), the alicyclic group includes a fluorinated hydroxyalkyl group.
A fluorinated hydroxyalkyl group refers to an alkyl group containing a hydroxyl group in which either a portion of, or all of, the hydrogen atoms of the alkyl group have been substituted with fluorine atoms. In this group, the fluorination increases the ease with which the hydrogen atom of the hydroxyl group is released.
In the fluorinated hydroxyalkyl group, the alkyl group is either a straight-chain or branched-chain group, and although there are no particular restrictions on the number of carbon atoms, a typical number of carbon atoms is from 1 to 20, and preferably from 4 to 16. There are no particular restrictions on the number of hydroxyl groups, although a single hydroxyl group is typical.
Of the various possibilities, groups in which a fluorinated alkyl group and/or a fluorine atom is bonded to the α-position carbon atom to which the hydroxyl group is bonded (which refers to the α-position carbon atom of the hydroxyalkyl group) are preferred. Furthermore, the fluorinated alkyl group bonded to the α-position is preferably a group in which all of the hydrogen atoms of the alkyl group have been substituted with fluorine atoms.

The alicyclic group may be either a monocyclic or polycyclic group, although a polycyclic group is preferred. Furthermore, an alicyclic hydrocarbon group is preferred. Furthermore, the group is preferably saturated. Moreover, the number of carbon atoms within the alicyclic group is preferably within a range from 5 to 15.

Specific examples of the alicyclic group include the groups described below.
Namely, examples of suitable monocyclic groups include groups in which one hydrogen atom has been removed from a cycloalkane. Examples of suitable polycyclic groups include groups in which one or two hydrogen atoms have been removed from a bicycloalkane, tricycloalkane or tetracycloalkane or the like.
Specific examples of monocyclic groups include groups in which one or two hydrogen atoms have been removed from cyclopentane or cyclohexane, and groups in which two hydrogen atoms have been removed from cyclohexane are particularly preferred.
Examples of suitable polycyclic groups include groups in which one or two hydrogen atoms have been removed from a polycycloalkane such as adamantane, norbornane, isobornane, tricyclodecane or tetracyclododecane.
These types of polycyclic groups can be selected appropriately from the multitude of groups proposed for forming acid-dissociable, dissolution-inhibiting groups for use within resins for positive photoresist compositions used within ArF excimer laser processes.
Of the various possibilities, groups in which two hydrogen atoms have been removed from cyclohexane, adamantane, norbornane or tetracyclododecane are readily available industrially, and are consequently preferred.
Of the monocyclic and polycyclic groups exemplified above, groups in which two hydrogen atoms have been removed from norbornane are particularly preferred.

The structural unit (a2') is preferably a structural unit derived from acrylic acid, and structures in which the above alicyclic group is bonded to the ester group [-C(O)O-] of the acrylate ester (namely, structures in which the hydrogen atom of the carboxyl group is substituted with the aforementioned alicyclic group) are preferred.

Specifically, as the structural unit (a2'), units represented by the aforementioned general formula (1) are particularly preferred.

Of the units represented by the general formula (1), structural units derived from monomers corresponding with unit m of the formula XIII shown below are preferred in terms of the effects achieved, the ease of synthesis, and the high level of etching resistance that is obtainable.

The structural unit (a2') may be either a single type of structural unit or a mixture of two or more different structural units.
The proportion of the structural unit (a2'), relative to the combined total of all the structural units within the component (A'), is typically within a range from 10 to 65 mol%, and is preferably from 20 to 60 mol%, and most preferably from 25 to 55 mol%.
Ensuring that this proportion is at least as large as the lower limit but no greater than the upper limit of the above range enables a favorable balance to be achieved with the other structural units.

In addition to the structural unit (a1') and the structural unit (a2'), the component (A') preferably also includes a structural unit (a2) derived from an acrylate ester that includes a lactone-containing monocyclic or polycyclic group.

### - Structural Unit (a2)

When the component (A') is used in forming a resist film, the lactone-containing monocyclic or polycyclic group of the structural unit (a2) is effective in improving the adhesion between the resist film and the substrate, and enhancing the hydrophilicity of the component (A') relative to the developing solution.
Here, the term "lactone-containing monocyclic or polycyclic group " refers to a cyclic group that includes a single ring containing a -O-C(O)- structure (the lactone ring). This lactone ring is counted as the first ring, meaning groups that contain only the lactone ring are referred to as monocyclic groups, whereas groups that also contain other ring structures are described as polycyclic groups regardless of the structure of the other rings.

As the structural unit (a2), any group can be used without any particular restrictions, provided it includes both the above type of lactone structure (-O-C(O)-) and a cyclic group.
Specifically, examples of lactone-containing monocyclic groups include groups in which one hydrogen atom has been removed from γ-butyrolactone. Examples of lactone-containing polycyclic groups include groups in which one hydrogen atom has been removed from a lactone ring-containing bicycloalkane, tricycloalkane, or tetracycloalkane. Groups obtained by removing one hydrogen atom from a lactone-containing tricycloalkane with a structural formula such as that shown below are particularly preferred in terms of industrial availability.

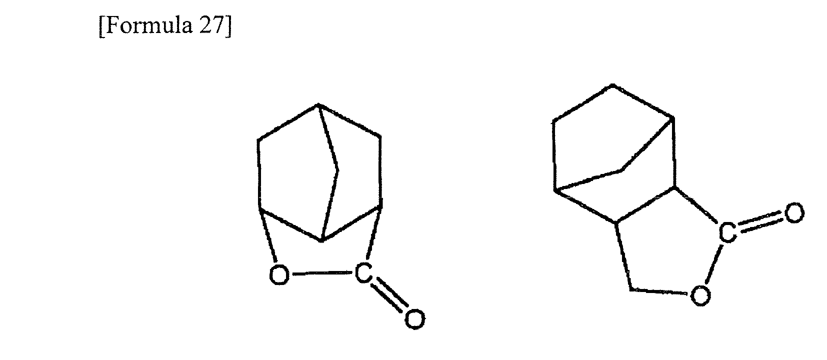

More specific examples of the structural unit (a2) include the structural units represented by general formulas (a2-1) to (a2-5) shown below.

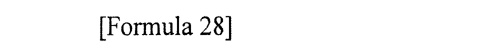

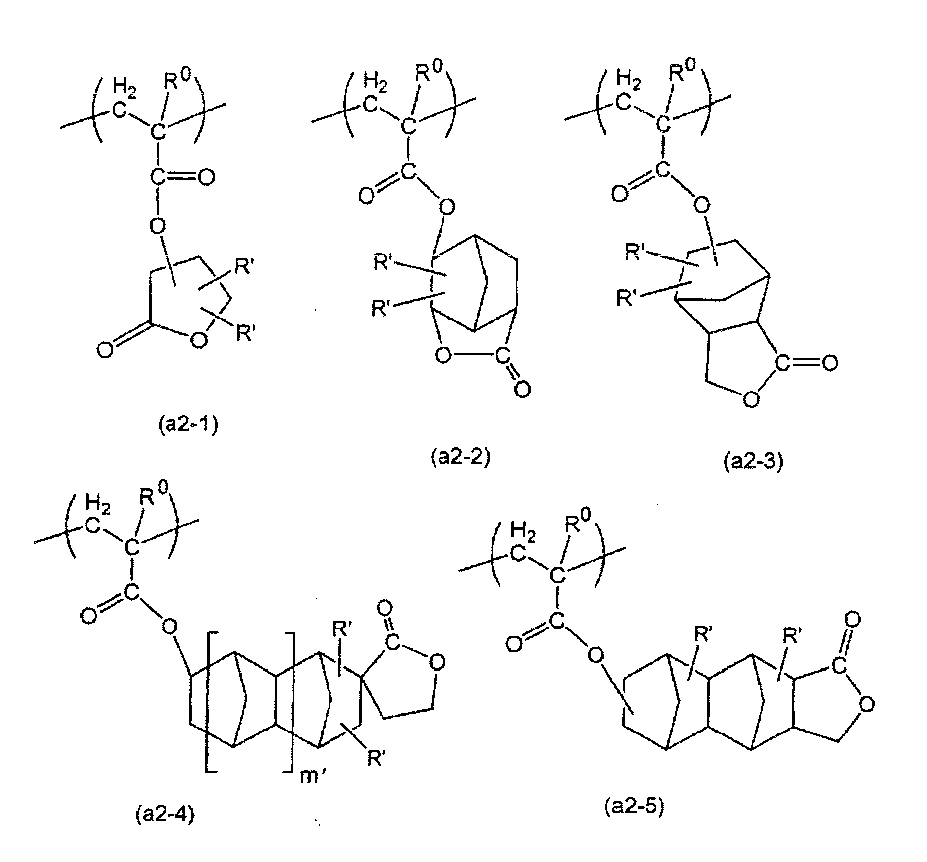

[wherein, R⁰ represents a hydrogen atom, a halogen atom, a halogenated lower alkyl group, or a lower alkyl group, R' represents a hydrogen atom, a lower alkyl group, or an alkoxy group of 1 to 5 carbon atoms, and m' represents an integer of either 0 or 1]

Examples of the lower alkyl groups of R⁰ and R' within the general formulas (a2-1) to (a2-5) include the same lower alkyl groups as those described in relation to the group R⁰ in the aforementioned structural unit (a1).
In the general formulas (a2-1) to (a2-5), considering factors such as industrial availability, R' is most preferably a hydrogen atom.

Of the above possibilities, at least one structural unit selected from the general formulas (a2-1) to (a2-5) is preferred, and at least one structural unit selected from the general formulas (a2-1) to (a2-3) is even more desirable.

The structural unit (a2) may be either a single type of structural unit or a mixture of two or more different structural units.
The proportion of the structural unit (a2) within the component (A'), relative to the combined total of all the structural units that constitute the component (A'), is typically within a range from 5 to 60 mol%, and is preferably from 10 to 50 mol%, and most preferably from 20 to 50 mol%. Ensuring that this proportion is at least as large as the lower limit of the above range enables the effects obtained by adding the structural unit (a2) to manifest satisfactorily, whereas ensuring the proportion is no greater than the upper limit enables a favorable balance to be achieved with the other structural units.

### - Structural Unit (a3)

The component (A') may also include a structural unit (a3) derived from an (α-lower alkyl) acrylate ester that contains a polar group-containing aliphatic hydrocarbon group. Including the structural unit (a3) increases the hydrophilicity of the component (A'), thereby improving the affinity with the developing solution, improving the alkali solubility within the exposed portions of the resist, and contributing to an improvement in the resolution.
Examples of the polar group include a hydroxyl group, cyano group, carboxyl group, or a hydroxyalkyl group in which a portion of the hydrogen atoms of the alkyl group have been substituted with fluorine atoms, although a hydroxyl group is particularly preferred.
Examples of the aliphatic hydrocarbon group include straight-chain or branched hydrocarbon groups (and preferably alkylene groups) of 1 to 10 carbon atoms, and polycyclic aliphatic hydrocarbon groups (polycyclic groups). These polycyclic groups can be selected appropriately from the multitude of groups that have been proposed for the resins of resist compositions designed for use with ArF excimer lasers.
Of the various possibilities, structural units that include an aliphatic polycyclic group that contains a hydroxyl group, cyano group, carboxyl group or a hydroxyalkyl group in which a portion of the hydrogen atoms of the alkyl group have been substituted with fluorine atoms, and are also derived from an (α-lower alkyl) acrylate ester are particularly preferred. Examples of suitable polycyclic groups include groups in which one or more hydrogen atoms have been removed from a bicycloalkane, tricycloalkane or tetracycloalkane or the like. Specific examples include groups in which one or more hydrogen atoms have been removed from a polycycloalkane such as adamantane, norbornane, isobornane, tricyclodecane or tetracyclododecane. These types of polycyclic groups can be selected appropriately from the multitude of groups proposed for the polymer (resin component) of resist compositions designed for use with ArF excimer lasers. Of these polycyclic groups, groups in which two or more hydrogen atoms have been removed from adamantane, groups in which two or more hydrogen atoms have been removed from norbornane, and groups in which two or more hydrogen atoms have been removed from tetracyclododecane are preferred industrially.

When the hydrocarbon group within the polar group-containing aliphatic hydrocarbon group is a straight-chain or branched hydrocarbon group of 1 to 10 carbon atoms, the structural unit (a3) is preferably a structural unit derived from the hydroxyethyl ester of the (α-lower alkyl) acrylic acid, whereas when the hydrocarbon group is a polycyclic group, examples of preferred structural units include the structural units represented by a formula (a3-1) and the structural units represented by a formula (a3-2), which are shown below.

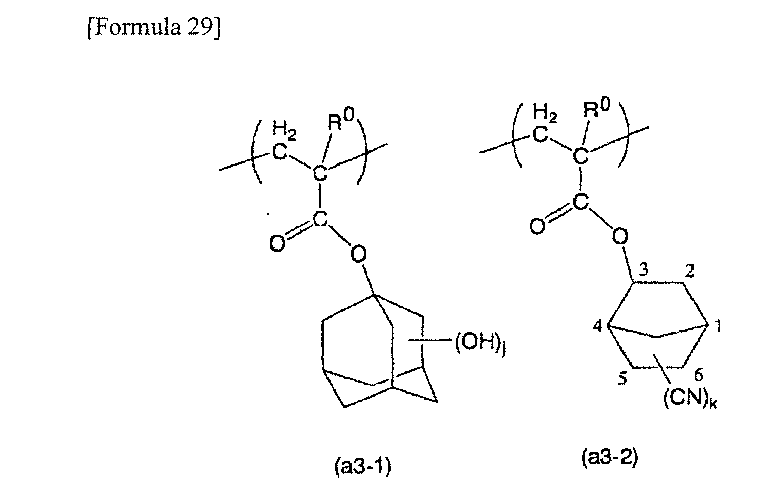

(wherein, R⁰ is as defined above, j represents an integer from 1 to 3, and k represents an integer from 1 to 3)

In the formula (a3-1), the value of j is preferably either 1 or 2, and is most preferably 1. In those cases where j is 2, the hydroxyl groups are preferably bonded to position 3 and position 5 of the adamantyl group. In those cases where j is 1, the hydroxyl group is preferably bonded to position 3 of the adamantyl group.
Cases in which j is 1 are preferred, and structural units in which the hydroxyl group is bonded to position 3 of the adamantyl group are particularly desirable.

In the formula (a3-2), the value of k is preferably 1. The cyano group is preferably bonded to either position 5 or position 6 of the norbornyl group.

As the structural unit (a3), either a single type of structural unit may be used alone, or a combination of two or more different structural units may be used.
In those cases where the component (A') includes a structural unit (a3), the proportion of the structural unit (a3) within the component (A'), relative to the combined total of all the structural units that constitute the component (A'), is preferably within a range from 5 to 50 mol%, even more preferably from 15 to 45 mol%, and is most preferably from 1 to 35 mol%.

### - Structural Unit (a4)

The component (A') may also include other structural units (a4) not included within the group consisting of the structural units (a1'), (a2'), (a2), and (a3) described above (hereafter also jointly referred to as the "structural units group"), provided the inclusion of these other units does not impair the effects of the present invention.
As the structural unit (a4), any other structural unit that cannot be classified within the above "structural units group" can be used without any particular restrictions, and any of the multitude of conventional structural units used within resist resins for ArF excimer lasers or KrF excimer lasers (and particularly for ArF excimer lasers) can be used.

As the structural unit (a4), a structural unit that contains a non-acid-dissociable aliphatic polycyclic group, and is also derived from an acrylate ester is preferred. Examples of this polycyclic group include the same groups as those described above in relation to the aforementioned structural unit (a1'), and any of the multitude of conventional polycyclic groups used within the resin component of resist compositions designed for ArF excimer lasers or KrF excimer lasers (and particularly for ArF excimer lasers) can be used.
In particular, at least one group selected from amongst a tricyclodecanyl group, adamantyl group, tetracyclododecanyl group, isobornyl group, and norbornyl group is preferred in terms of factors such as industrial availability. These polycyclic groups may also be substituted with straight-chain or branched alkyl groups of 1 to 5 carbon atoms.
Specific examples of the structural unit (a4) include units with structures represented by general formulas (a4-21) to (a4-25) shown below.

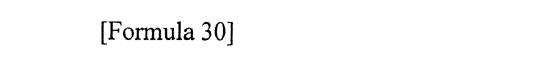

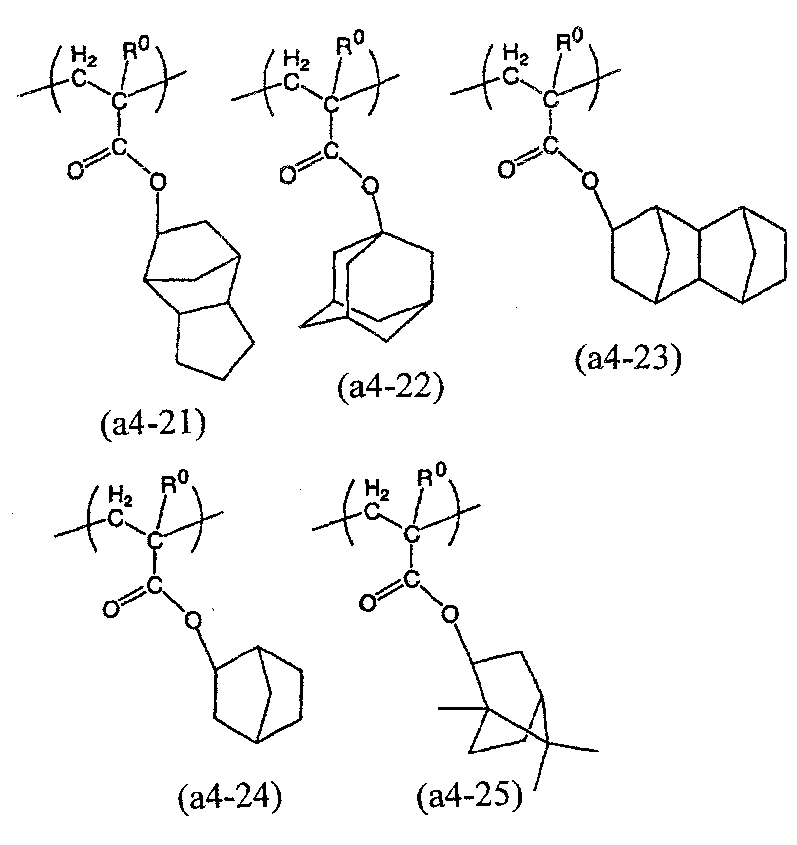

(wherein, R⁰ is as defined above)

The proportion of the structural unit (a4), namely the proportion of the structural units (a4-21) to (a4-25), relative to the combined total of all the structural units that constitute the component (A'), is typically within a range from 1 to 30 mol%, and is preferably from 10 to 20 mol%.

The component (A') can be obtained by a conventional radical polymerization or the like of the monomers that yield each of the structural units, using a radical polymerization initiator such as azobisisobutyronitrile (AIBN).
Furthermore, -C(CF₃)₂-OH groups may be introduced at the terminals of the component (A') by also using a chain transfer agent such as HS-CH₂-CH₂-CH₂-C(CF₃)₂-OH during the above polymerization. A copolymer wherein hydroxyalkyl groups, in which a portion of the hydrogen atoms of the alkyl group have been substituted with fluorine atoms, have been introduced in this manner is effective in reducing the levels of developing defects and LER (line edge roughness: non-uniform irregularities within the line side walls).

The component (A') can be obtained, for example, by a conventional radical polymerization of the monomers that yield each of the structural units.
The component (A') may use either a single resin, or a combination of two or more different resins.

### - Weight Average Molecular Weight

The weight average molecular weight (Mw) (the polystyrene equivalent value determined by gel permeation chromatography, this also applies below) of the component (A') is preferably no greater than 30,000, even more preferably no greater than 20,000, even more preferably no greater than 12,000, and is most preferably 10,000 or less.
Although there are no particular restrictions on the lower limit for the above range, in terms of suppressing pattern collapse and improving the level of resolution, the weight average molecular weight is preferably 4,000 or greater, and even more preferably 5,000 or greater.

The quantity of the component (A') is preferably adjusted in accordance with the film thickness of the resist that is to be formed.

### Acid Generator Component (B) that Generates Acid on Exposure

This component (B) is as described above for the second aspect, and duplicate descriptions are omitted.
Of the various possibilities, the component (B) is preferably an onium salt containing a fluorinated alkylsulfonate ion as the anion.
Moreover, in the positive resist composition described below, the use of an onium salt containing a fluorinated alkylsulfonate ion as the anion is preferred.
As the component (B), either a single acid generator may be used alone, or a combination of two or more different acid generators may be used.

The quantity used of the component (B) is typically within a range from 0.5 to 30 parts by weight, and even more preferably from 1 to 10 parts by weight, per 100 parts by weight of the component (A'). Ensuring the quantity satisfies this range enables satisfactory pattern formation to be conducted. Furthermore, a uniform solution is obtained, and the storage stability is also favorable, both of which are desirable.

### Nitrogen-containing Organic Compound (D)

In a positive resist composition, in order to improve the resist pattern shape and the post exposure stability of the latent image formed by the pattern-wise exposure of the resist layer, a nitrogen-containing organic compound (D) (hereafter referred to as the component (D)) may also be added as an optional component.
A multitude of these components (D) have already been proposed, and any of these known compounds can be used, although an aliphatic amine, and particularly a secondary aliphatic amine or tertiary aliphatic amine is preferred.

Examples of these aliphatic amines include amines in which at least one hydrogen atom of ammonia NH₃ has been substituted with an alkyl group or hydroxyalkyl group of no more than 12 carbon atoms (that is, alkylamines or alkyl alcohol amines). Specific examples of these aliphatic amines include monoalkylamines such as n-hexylamine, n-heptylamine, n-octylamine, n-nonylamine, and n-decylamine; dialkylamines such as diethylamine, di-n-propylamine, di-n-heptylamine, di-n-octylamine, and dicyclohexylamine; trialkylamines such as trimethylamine, triethylamine, tri-n-propylamine, tri-n-butylamine, tri-n-hexylamine, tri-n-pentylamine, tri-n-heptylamine, tri-n-octylamine, tri-n-nonylamine, tri-n-decanylamine, and tri-n-dodecylamine; and alkyl alcohol amines such as diethanolamine, triethanolamine, diisopropanolamine, triisopropanolamine, di-n-octanolamine, and tri-n-octanolamine.
These compounds may be used either alone, or in combinations of two or more different compounds.
The component (D) is typically used in a quantity within a range from 0.01 to 5.0 parts by weight per 100 parts by weight of the component (A'). Of the above amines, alkyl alcohol amines and trialkylamines are preferred, and alkyl alcohol amines are the most desirable. Amongst the various alkyl alcohol amines, triethanolamine and triisopropanolamine are the most preferred.

### Component (E)

In order to prevent any deterioration in sensitivity caused by the addition of the above component (D), and improve the resist pattern shape and the post exposure stability of the latent image formed by the pattern-wise exposure of the resist layer, an organic carboxylic acid, or a phosphorus oxo acid or derivative thereof (E) (hereafter referred to as the component (E)) may also be added as another optional component. The component (D) and the component (E) can be used in combination, or either one can also be used alone.
Examples of suitable organic carboxylic acids include malonic acid, citric acid, malic acid, succinic acid, benzoic acid, and salicylic acid.
Examples of suitable phosphorus oxo acids or derivatives thereof include phosphoric acid or derivatives thereof such as esters, including phosphoric acid, di-n-butyl phosphate and diphenyl phosphate; phosphonic acid or derivatives thereof such as esters, including phosphonic acid, dimethyl phosphonate, di-n-butyl phosphonate, phenylphosphonic acid, diphenyl phosphonate, and dibenzyl phosphonate; and phosphinic acid or derivatives thereof such as esters, including phosphinic acid and phenylphosphinic acid, and of these, phosphonic acid is particularly preferred.
The component (E) is typically used in a quantity within a range from 0.01 to 5.0 parts by weight per 100 parts by weight of the component (A').

### Other Optional Components

Other miscible additives can also be added to the positive resist composition according to need, and examples include additive resins for improving the performance of the resist film, surfactants for improving the ease of application, dissolution inhibitors, plasticizers, stabilizers, colorants, halation prevention agents, and dyes.

### [First Positive Resist Composition]

The first positive resist composition can use, for example, the same composition as the second positive resist composition. Of these possibilities, the first positive resist composition preferably includes a resin component (A'), which contains structural units derived from acrylate esters, and exhibits increased alkali solubility under the action of acid, and an acid generator component (B) that generates acid on exposure, and the component (A') most preferably includes a structural unit (a1') derived from an acrylate ester containing an acid-dissociable, dissolution-inhibiting group, and a structural unit (a2) derived from an acrylate ester that includes a lactone ring.
However, the restriction placed on the second positive resist composition, which requires the use of an organic solvent that does not dissolve the first resist layer 102, does not apply to the first positive resist composition.
As a result, organic solvents other than those described above in relation to the second positive resist composition can be used.
For example, the organic solvent may be any solvent capable of dissolving each of the components used to generate a uniform solution, and either one, or two or more solvents selected from known materials used as the solvents for conventional chemically amplified resists can be used.
Suitable examples include ketones such as γ-butyrolactone, acetone, methyl ethyl ketone, cyclohexanone, methyl isoamyl ketone and 2-heptanone; polyhydric alcohols and derivatives thereof such as ethylene glycol, ethylene glycol monoacetate, diethylene glycol, diethylene glycol monoacetate, propylene glycol, propylene glycol monoacetate, dipropylene glycol, or the monomethyl ether, monoethyl ether, monopropyl ether, monobutyl ether or monophenyl ether of dipropylene glycol monoacetate; cyclic ethers such as dioxane; and esters such as methyl lactate, ethyl lactate (EL), methyl acetate, ethyl acetate, butyl acetate, methyl pyruvate, ethyl pyruvate, methyl methoxypropionate, and ethyl ethoxypropionate.

These organic solvents may be used either alone, or as a mixed solvent of two or more different solvents.
Furthermore, a mixed solvent of propylene glycol monomethyl ether acetate (PGMEA) and a polar solvent is preferred. In such cases, the mixing ratio (weight ratio) can be determined on the basis of the co-solubility of the PGMEA and the polar solvent, but is preferably within a range from 1:9 to 9:1, and even more preferably from 2:8 to 8:2.
More specifically, in those cases where EL is added as the polar solvent, the weight ratio of PGMEA:EL is preferably within a range from 2:8 to 8:2, and even more preferably from 3:7 to 7:3.
Furthermore, as the organic solvent, a mixed solvent of at least one of PGMEA and EL, together with γ-butyrolactone is also preferred. In such cases, the mixing ratio is set so that the weight ratio between the former and latter components is preferably within a range from 70:30 to 95:5.

As the resin component of the first positive resist composition, a preferred component (A') includes a structural unit (a1') derived from an acrylate ester containing an acid-dissociable, dissolution-inhibiting group, and a structural unit (a2) derived from an acrylate ester that includes a lactone ring. A component (A') that also includes a structural unit (a3) derived from an acrylate ester that contains a polar group-containing polycyclic group in addition to the structural unit (a1') and the structural unit (a2) is the most desirable.
As the resin component of the second positive resist composition, a preferred component (A') includes a structural unit (a1') derived from an acrylate ester containing an acid-dissociable, dissolution-inhibiting group, and a structural unit (a2') containing an alicyclic group having a fluorinated hydroxyalkyl group.

Furthermore, the component (A') of the first positive resist composition preferably includes either a copolymer represented by a chemical formula (A'-21) shown below, or a copolymer represented by a chemical formula (A'-22) shown below, and is even more preferably a mixture of these copolymers. The mixing ratio (weight ratio) of the two copolymers is preferably within a range from 9: to 1:9, even more preferably from 8:2 to 2:8, and is most preferably from 6:4 to 4:6.

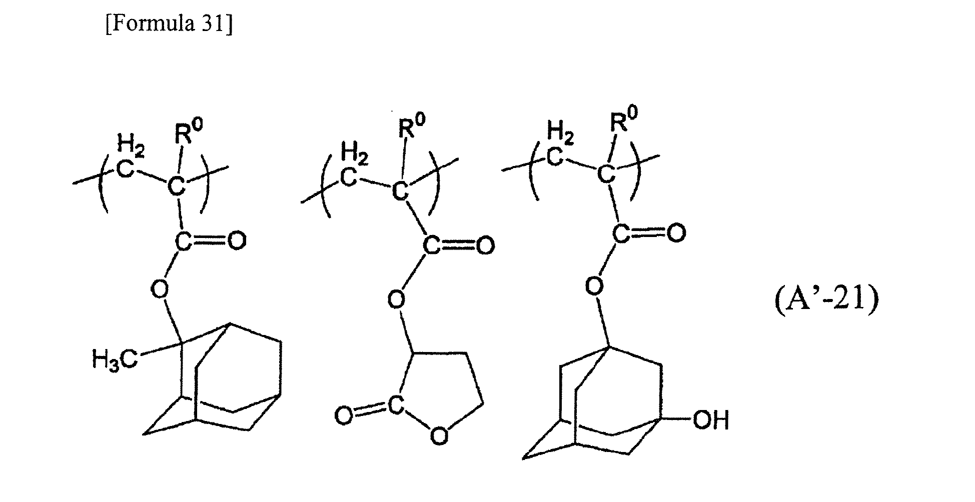

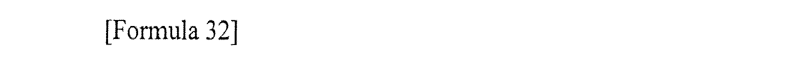

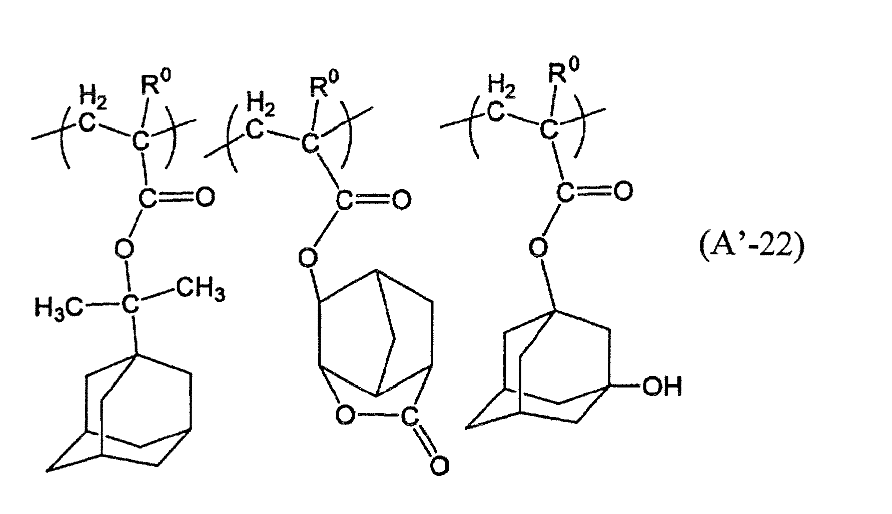

(wherein, R⁰ is as defined above)

Furthermore, the component (A') of the second positive resist composition preferably includes a copolymer represented by a chemical formula (A'-23) shown below. 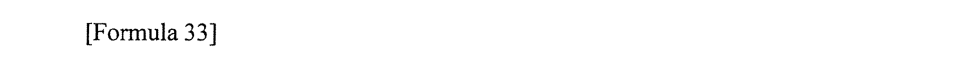 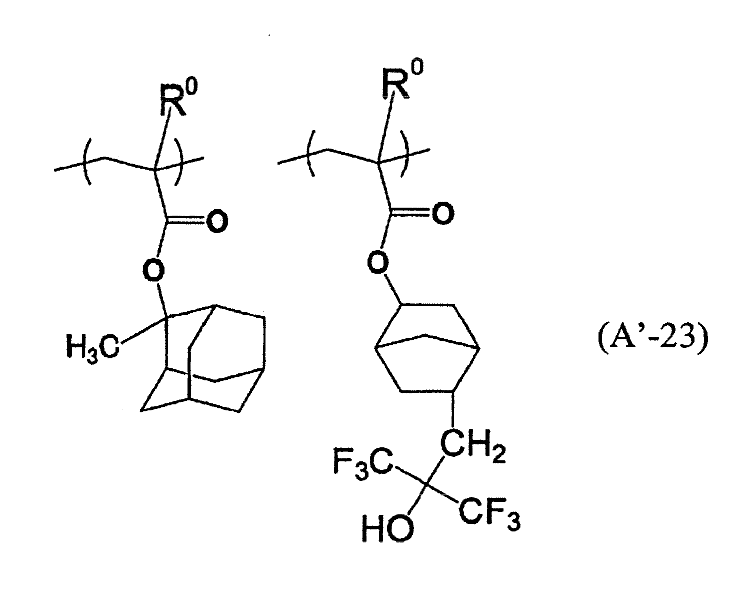 (wherein, R⁰ is as defined above)

In this method for forming a resist pattern according to the present invention, by using a specific positive resist composition described above as the second positive resist composition, a method for forming a resist pattern in which a dense pattern is formed in the lower layer and a pattern is formed in the upper layer can be provided, wherein mixing can be suppressed, and a resist pattern of favorable shape can be obtained.

### [Reference Example 2] (Preparation of Positive Resist Composition used in Second Resist Layer)

100 parts by weight (weight ratio 1: 1) of a resin 1 represented by the chemical formula shown below as a resin component, 5.0 parts by weight of triphenylsulfonium nonafluorobutanesulfonate as an acid generator, and 0.45 parts by weight of triethanolamine as a nitrogen-containing organic compound were dissolved in isobutanol as the organic solvent, yielding a positive resist composition with a solid fraction concentration of 6% by weight.

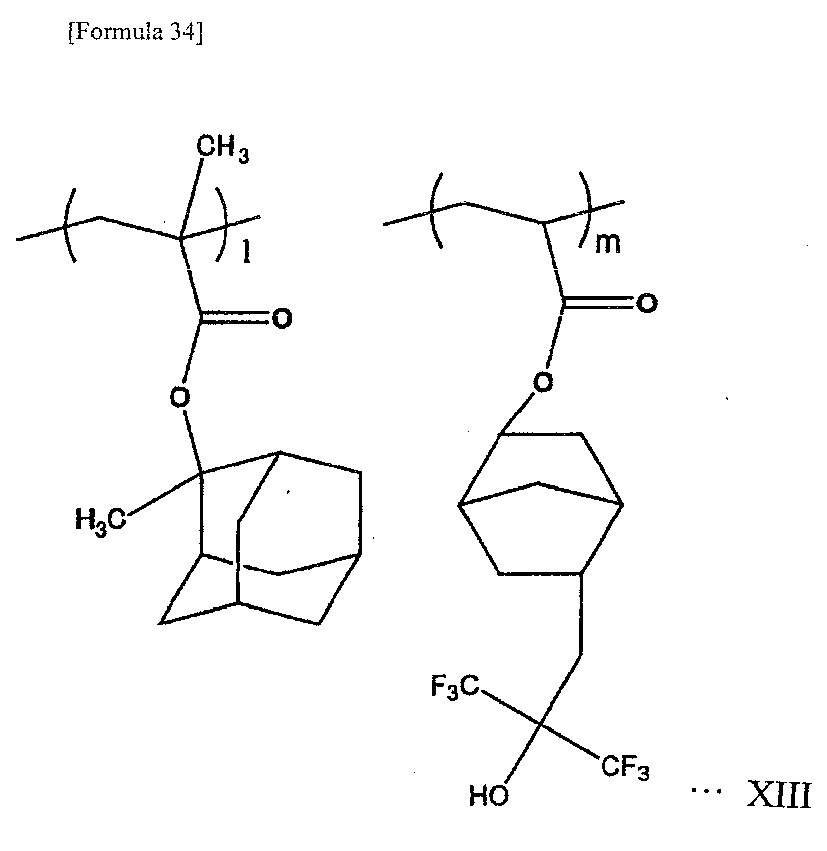

Resin 1 (weight average molecular weight: 9,800, dispersity (weight average molecular weight / number average molecular weight): 1.4, 11m = 48/52 (molar ratio))

### [Reference Example 3] (Preparation of Positive Resist Composition used in First Resist Layer)

100 parts by weight of a mixture (weight ratio 1:1) of a resin 1 and a resin 2 represented by the chemical formulas shown below as a resin component, 3.0 parts by weight of triphenylsulfonium nonafluorobutanesulfonate as an acid generator, 0.15 parts by weight of triethanolamine as a nitrogen-containing organic compound, and 0.1 parts by weight of a surfactant (product name: R-08, manufactured by Dainippon Ink and Chemicals, Incorporated) as another component were dissolved in a mixed solvent (weight ratio 6:4) of propylene glycol monomethyl ether acetate and ethyl lactate as organic solvent, yielding a positive resist composition with a solid fraction concentration of 10% by weight.

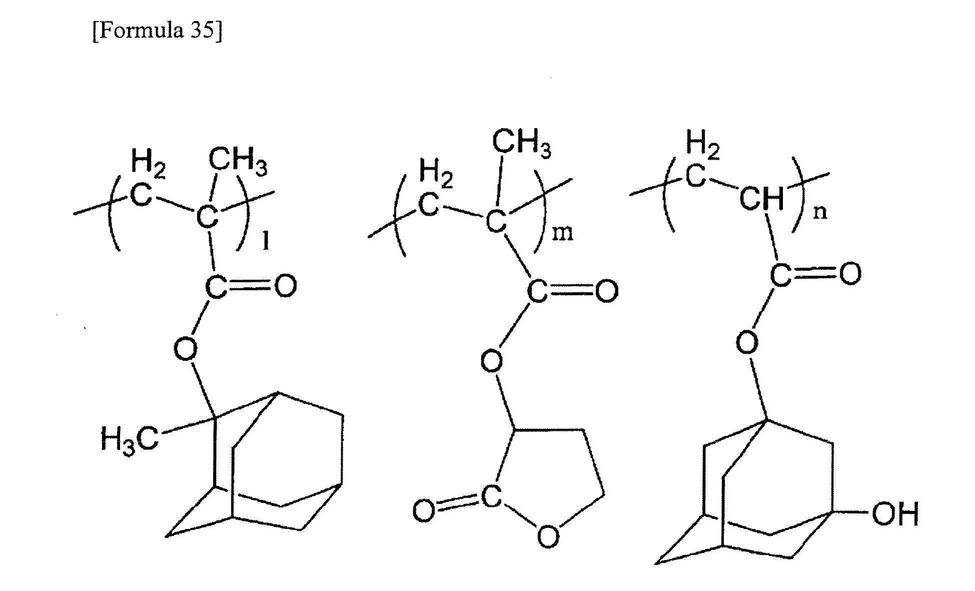

Resin 1 (weight average molecular weight: 10,000, dispersity: 2.0, l/m/n = 4/4/2 (molar ratio))

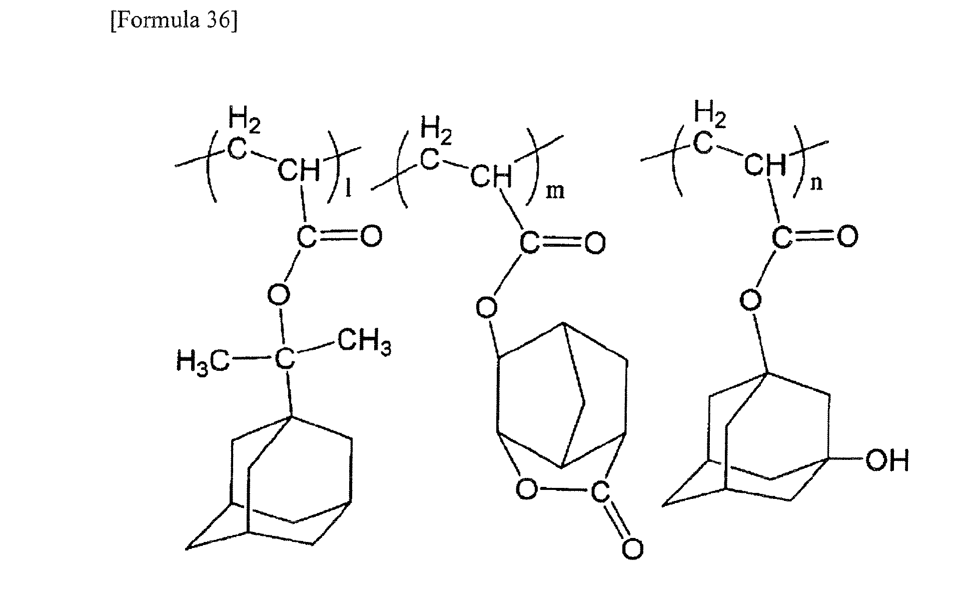

Resin 2 (weight average molecular weight: 10,000, dispersity: 2.0,1/m/n = 3/5/2 (molar ratio))

An organic anti-reflective film composition "ARC-29" (a product name, manufactured by Brewer Science Ltd.) was applied to the surface of an 8-inch silicon wafer using a spinner, and the composition was then baked and dried on a hotplate at 215°C for 60 seconds, thereby forming an organic anti-reflective film with a film thickness of 77 nm.
The first positive resist composition prepared in the aforementioned reference example 3 was then applied to the surface of this anti-reflective film using a spinner, and was then prebaked (PAB) and dried on a hotplate at 115°C for 60 seconds, thereby forming a resist layer with a film thickness of 300 nm.
Subsequently, this layer was selectively irradiated with an ArF excimer laser (193 nm) through a mask pattern, using an ArF exposure apparatus NSR-S302 (manufactured by Nikon Corporation; NA (numerical aperture) = 0.60, σ = 0.75).
The resist was then subjected to PEB treatment at 100°C for 60 seconds, subsequently subjected to puddle development for 60 seconds at 23°C in a 2.38% by weight aqueous solution of tetramethylammonium hydroxide, and was then washed for 20 seconds with water, and dried, thus forming a 140 nm 1:1 dense hole pattern.
Next, the second positive resist composition prepared in the reference example 2 was applied to the surface of the thus formed dense hole pattern using a spinner, and was then prebaked (PAB) and dried on a hotplate at 115°C for 60 seconds, thereby forming a resist layer with a film thickness of 200 nm. During this layer formation, no mixing occurred with the lower resist layer. Subsequently, this layer was selectively irradiated with an ArF excimer laser (193 nm) through a mask pattern, using an ArF exposure apparatus NSR-S302 (manufactured by Nikon Corporation; NA (numerical aperture) = 0.60, σ = 0.75).
The resist layer was then subjected to PEB treatment at 100°C for 60 seconds, subsequently subjected to puddle development for 60 seconds at 23°C in a 2.38% by weight aqueous solution of tetramethylammonium hydroxide, and was then washed for 20 seconds with water, and dried, thus forming an isolated-dense mixed pattern including both a 140 nm 1:1 dense contact hole pattern and an isolated pattern with a hole width of 140 nm.

In this manner, in an example according to the present invention, mixing was able to be prevented, and a practical resist pattern was able to be formed.

### INDUSTRIAL APPLICABILITY

The present invention can be applied to the formation of resist patterns during the production of semiconductor elements and liquid crystal display elements.

## Claims

1. A method for forming a resist pattern, comprising steps (i) and (ii) below:
(i) a step of forming a first resist layer on a substrate using a positive resist composition, and then conducting selective exposure, thereby forming a latent image of a dense pattern on said first resist layer, and
(ii) a step of forming a second resist layer on top of said first resist layer using a negative resist composition, conducting selective exposure, and then developing said first resist layer and said second resist layer simultaneously, thereby exposing a portion of said latent image of said dense pattern, wherein
as said negative resist composition, a negative resist composition dissolved in an organic solvent that does not dissolve said first resist layer is used.

2. A method for forming a resist pattern, comprising steps (i') and (ii') below:
(i') a step of forming a first resist layer on a substrate using a positive resist composition, conducting selective exposure, and then performing developing to form a dense pattern in said first resist layer, and
(ii') a step of forming a second resist layer on top of said dense pattern of said first resist layer using a negative resist composition, conducting selective exposure, and then performing developing, thereby filling in a portion of said dense pattern, wherein
as said negative resist composition, a negative resist composition dissolved in an organic solvent that does not dissolve said first resist layer is used.

3. The method for forming a resist pattern according to either claim 1 or claim 2, wherein said organic solvent comprises an alcohol-based solvent.

4. The method for forming a resist pattern according to claim 3, wherein said alcohol-based solvent is isobutanol and/or n-butanol.

5. The method for forming a resist pattern according to either claim 1 or claim 2, wherein
a negative resist composition comprising a resin component (A0) that contains at least a fluorinated hydroxyalkyl group and an alicyclic group, an acid generator component (B) that generates acid on exposure, and a cross-linking agent component (C) is used as said negative resist composition.

6. The method for forming a resist pattern according to claim 5, wherein
said component (A0) is a resin component (A), comprising a structural unit (a1) that comprises an alicyclic group having a fluorinated hydroxyalkyl group, and a structural unit (a2), which is a structural unit derived from an acrylate ester and comprises a hydroxyl group-containing alicyclic group.

7. The method for forming a resist pattern according to either claim 1 or claim 2, wherein
a positive resist composition comprising a resin component (A'), which comprises structural units derived from an (α-lower alkyl) acrylate ester, and exhibits increased alkali solubility under action of acid, and an acid generator component (B) that generates acid on exposure is used as said positive resist composition.

8. The method for forming a resist pattern, comprising steps (xi) and (xii) below:
(xi) a step of forming a first resist layer on a substrate using a first positive resist composition, and then conducting selective exposure, thereby forming a latent image of a dense pattern on said first resist layer, and
(xii) a step of forming a second resist layer on top of said first resist layer using a second positive resist composition, conducting selective exposure, and then developing said first resist layer and said second resist layer simultaneously, thereby exposing a portion of said latent image of said dense pattern, wherein
as said second positive resist composition, a positive resist composition dissolved in an organic solvent that does not dissolve said first resist layer is used.

9. A method for forming a resist pattern, comprising steps (xi') and (xii') below:
(xi') a step of forming a first resist layer on a substrate using a first positive resist composition, conducting selective exposure, and then performing developing to form a dense pattern in said first resist layer, and
(xii') a step of forming a second resist layer on top of said dense pattern of said first resist layer using a second positive resist composition, conducting selective exposure, and then performing developing, thereby filling in a portion of said dense pattern, wherein
as said second positive resist composition, a positive resist composition dissolved in an organic solvent that does not dissolve said first resist layer is used.

10. The method for forming a resist pattern according to either claim 8 or claim 9, wherein said organic solvent that does not dissolve said first resist layer comprises an alcohol-based solvent.

11. The method for forming a resist pattern according to either claim 8 or claim 9, wherein said alcohol-based solvent is isobutanol and/or n-butanol.

12. The method for forming a resist pattern according to either claim 8 or claim 9, wherein
either one of, or both, said first positive resist composition and said second positive resist composition are positive resist compositions comprising a resin component (A'), which comprises structural units derived from an acrylate ester, and exhibits increased alkali solubility under action of acid, and an acid generator component (B) that generates acid on exposure.

13. The method for forming a resist pattern according to claim 5, wherein
said component (A') of said first positive resist composition comprises a structural unit (a1') derived from an acrylate ester containing an acid-dissociable, dissolution-inhibiting group, and a structural unit (a2) derived from an acrylate ester that contains a lactone ring.

14. The method for forming a resist pattern according to claim 12, wherein
said component (A') of said second positive resist composition comprises a structural unit (a1') derived from an acrylate ester containing an acid-dissociable, dissolution-inhibiting group, and a structural unit (a2') that comprises an alicyclic group having a fluorinated hydroxyalkyl group.
